# EUROPEAN PATENT APPLICATION

(11) **EP 4 386 840 A2**
(43) Date of publication of application: **19.06.2024**
(21) Application number: 23216034.1
(22) Date of filing: 12.12.2023
(51) Int. Cl.: H01L 25/075, H01L 33/60, H01L 33/62, H01L 25/16, H01L 33/00, H01L 33/44, H01L 33/50

(54) **DISPLAY DEVICES AND METHODS FOR MANUFACTURING THE SAME**

(30) Priority: 12.12.2022 KR 20220172320
(71) Applicant: Samsung Display Co., Ltd., Yongin-si, Gyeonggi-do 17113 (KR)
(72) Inventor: SEO, Young Seok, 17113 Yongin-si (KR); KIM, Kyung Ho, 17113 Yongin-si (KR); JANG, Hye Won, 17113 Yongin-si (KR); CHOI, Jin Woo, 17113 Yongin-si (KR)
(74) Representative: Marks & Clerk LLP

(57) **Abstract**

A display device includes: a substrate; light emitting units (130) on the substrate, respectively corresponding to emission areas; and a partition wall (140) on the substrate, corresponding to a non-emission area which is a boundary between the emission areas. The partition wall includes a plate (141) corresponding to the non-emission area, and a pillar (142a) protruding from at least a portion of the plate to each of the emission areas and having a greater width than the plate. A further display device includes: a substrate; pixel electrodes on the substrate; dummy patterns on the substrate corresponding to a non-emission area; light emitting elements; a planarization layer between the light emitting elements and covering the pixel electrodes and the dummy patterns; and a common electrode on the light emitting elements and the planarization layer. The light emitting elements are spaced from each other by similar distances and two or more light emitting elements are on the pixel electrode of each emission area.

## Description

### BACKGROUND

### 1. Field

The present disclosure relates to a display device and a method of manufacturing the same.

### 2. Description of the Related Art

With the advancement of the information age, the demand for display devices for displaying an image has increased in many different forms. For example, display devices have been applied to various electronic devices such as smart phones, digital cameras, laptop computers, navigators, and smart televisions.

The display device may be a flat panel display device such as a liquid crystal display device, a field emission display device and a light emitting display device.

Examples of the light emitting display device may include an organic light emitting display device including organic light emitting elements, an inorganic light emitting display device including inorganic light emitting elements such as inorganic semiconductors, and a micro light emitting display device including micro light emitting elements.

### SUMMARY

A display device may include a plurality of light emitting units respectively corresponding to a plurality of emission areas emitting light for displaying an image and a partition wall surrounding the light emitting units. However, as a width of the partition wall increases, a width of the light emitting units decreases, thus reducing luminance. On the other hand, as the width of the partition wall decreases, it is easier to deform the partition wall, thus reducing display quality, life, and yield.

Accordingly, aspects and features of embodiments of the present disclosure provide a display device that can prevent easy deformation of the partition wall while reducing luminance degradation due to the partition wall.

The display device may include at least one light emitting element disposed on a pixel electrode corresponding to each of the emission areas. However, due to misalignment, the light emitting element may not be disposed on a central portion of the pixel electrode, but may be disposed on a portion of an edge of the pixel electrode. That is, not the whole of the misaligned light emitting element may be supported by the pixel electrode. In this case, because it is difficult for a common electrode to be disposed flat on the light emitting element, a defect such as breaking or local resistance increase may occur.

Accordingly, aspects and features of embodiments of the present disclosure also provide a display device that can prevent a defect in a common electrode due to misaligned light emitting elements and a method of manufacturing the display device.

However, aspects and features of embodiments of the present disclosure are not restricted to the one set forth herein. The above and other aspects and features of the present disclosure will become more apparent to one of ordinary skill in the art to which the present disclosure pertains by referencing the detailed description of the present disclosure given below.

According to one or more embodiments of the present disclosure, there is provided a display device that includes a substrate including a display area in which a plurality of emission areas configured to emit light for displaying an image is arranged; a plurality of light emitting units on the substrate and respectively corresponding to the plurality of emission areas; and a partition wall on the substrate, corresponding to a non-emission area which is a boundary between the plurality of emission areas, and having a variable width in at least one direction. The partition wall includes a plate corresponding to the non-emission area; and a pillar protruding from at least a portion of the plate to each of the plurality of emission areas and having a greater width than the plate.

Each of the plurality of light emitting units includes a light emitting element disposed on the substrate; and a light control layer disposed on the substrate to cover the light emitting element and configured to control characteristics of light emitted from the light emitting element. Each of the plurality of light emitting units has a light emitting surface corresponding to the light control layer and configured to emit light and a rear surface opposite the light emitting surface. The rear surface of each of the light emitting units has at least one corner or at least one side having a shape corresponding to that of the partition wall.

A minimum distance between pillars corresponding to both sides of any one of the light emitting units is greater than a width of the light emitting element.

A height of each pillar may be equal to a height of the plate in a thickness direction of the substrate, and the light emitting surface of each of the plurality of light emitting units may have at least one corner or at least one side having a shape corresponding to that of the pillar.

Each pillar may correspond to corners of four neighboring light emitting units. The light emitting surface and the rear surface of each of the plurality of light emitting units may have a quadrilateral shape having each corner shaped by the pillar.

Each pillar may correspond to corners of two light emitting units neighboring each other in one direction. The light emitting surface and the rear surface of each of the light emitting units may be formed in a quadrilateral shape in which corners corresponding to both ends of one side extending in the one direction are shaped by the pillars.

Each pillar may correspond to corners of two light emitting units neighboring each other in one direction and a portion of a side of one light emitting unit neighboring the corners of the two neighboring light emitting units in another direction. The light emitting surface and the rear surface of each of the light emitting units may have a quadrilateral shape in which corners corresponding to both ends of one side extending in the one direction and a portion of another side extending in the one direction are shaped by the pillars.

Each pillar may be between two neighboring light emitting units. The light emitting surface and the rear surface of each of the plurality of light emitting may include a combination of curved sides convex toward the center of the light emitting unit.

2n pillars may be located side by side between two neighboring light emitting units. The 2n pillars may include a first pillar having a cross-sectional shape convex toward one of the two neighboring light emitting units and a second pillar having a cross-sectional shape convex toward another one of the two neighboring light emitting units, wherein n is a natural number of 1 or more. The first pillar and the second pillar may be alternately arranged between the two neighboring light emitting units. The first and second pillars neighboring each other may be point-symmetrical to each other.

The plate may correspond to corners of four neighboring emission areas and a space between the first pillar and the second pillar. The light emitting surface and the rear surface of each of the plurality of light emitting units may have a quadrilateral shape that includes a side shaped by the first pillar and another side facing the side and shaped by the second pillar.

The height of each pillar may be less than the height of the plate. The rear surface of each of the light emitting units may be surrounded by the pillars. The light emitting surface of each of the light emitting units may be surrounded by the plate and may have a greater width than the rear surface.

The height of each pillar may be less than a light emission height of the light emitting element in a thickness direction of the substrate. The light emission height may correspond to an angle at which light is emitted from the light emitting element.

Each pillar may have a predetermined width.

Each pillar may include an inclined surface facing the light emitting element and a gradually decreasing width toward the plate.

Each pillar may include a curved surface facing the light emitting element and a gradually decreasing width toward the plate.

The partition wall may further include a buffer between each pillar and the plate. The buffer have have a width less than the width of each pillar and greater than the width of the plate.

The height of each pillar may be less than the height of the plate. The rear surface of each of the plurality of light emitting units may be surrounded by the plate and the pillars. The light emitting surface of each of the plurality of light emitting units may be surrounded by the plate and may have a greater width than the rear surface.

Each pillar may correspond to corners of four neighboring light emitting units. The rear surface of each of the plurality of light emitting units may have a quadrilateral shape having each corner shaped by the pillar.

The display device may further include a pixel electrode on the substrate and corresponding to each of the plurality of emission areas; a pixel connection electrode between the pixel electrode and the light emitting element; a common connection electrode on the substrate and corresponding to the non-emission area; a planarization layer between the common connection electrode and the partition wall; an insulating layer covering side surfaces of each of the pixel electrode, the pixel connection electrode, the light emitting element, the common connection electrode, the planarization layer, and the partition wall; a common electrode corresponding to the emission areas and covering the second insulating layer; and a reflective layer corresponding to the side surfaces of each of the pixel electrode, the pixel connection electrode, the light emitting element, the common connection electrode, the first insulating layer and the partition wall and on the common electrode.

A portion of the partition wall may include a same layer as the light emitting element.

According to another aspect of the present disclosure, there is provided a display device including a substrate including a display area in which a plurality of emission areas is arranged; a plurality of pixel electrodes on the substrate and respectively corresponding to the plurality of emission areas; a plurality of dummy patterns on the substrate and corresponding to a non-emission area between the plurality of emission areas; a plurality of light emitting elements corresponding to the plurality of emission areas; a planarization layer between the plurality of light emitting elements and covering the plurality of pixel electrodes and the plurality of dummy patterns; and a common electrode on the plurality of light emitting elements and the planarization layer and corresponding to the plurality of emission areas.

The plurality of light emitting elements is spaced from each other by a distance in the same range in at least one direction. Each of the plurality of emission areas corresponds to two or more of the plurality of light emitting elements. Two or more light emitting elements corresponding to emission area from among the plurality of emission areas are on the pixel electrode of the emission area.

From among the two or more light emitting elements corresponding to the emission area, some light emitting elements at an edge of the emission area may be supported by a dummy pattern from among the plurality of dummy patterns adjacent to the edge of the emission area.

One or more dummy patterns may be between two pixel electrodes neighboring each other in one direction. The dummy pattern between two pixel electrodes neighboring each other in the one direction may be located parallel to the two pixel electrodes and is spaced from the two pixel electrodes.

Each of the plurality of light emitting elements may have a first width in the one direction. The pixel electrodes may be spaced from each other by a first distance in the one direction. The first distance may be greater than the first width.

The pixel electrode of the emission area and the dummy pattern neighboring the emission area may be spaced from each other by a second distance in the one direction. The second distance may be smaller than half the first width.

Each of the plurality of dummy patterns may have a second width in the one direction. The sum of the second width and the second distance may be greater than half the first width.

When one dummy pattern from among the plurality of dummy patterns is between two pixel electrodes neighboring each other in the one direction, the sum of twice the second width and the second distance may be less than the first distance.

The dummy pattern from among the plurality of dummy patterns adjacent to the emission area may have a thickness in the same range as that of the pixel electrode of the emission area.

The plurality of dummy patterns may include a same material as the pixel electrodes.

The plurality of dummy patterns may include an insulating material.

The display device may further include a transistor array layer on the substrate and includes a plurality of thin-film transistors corresponding to the plurality of emission areas and a via layer covering the plurality of thin-film transistors. The pixel electrodes and the dummy patterns may be on the via layer of the transistor array layer.

The display device may further include a color conversion array layer on the common electrode; and a color filter layer on the color conversion array layer. The plurality of emission areas may include a first emission area corresponding to a first color, a second emission area corresponding to a second color in a wavelength band lower than that of the first color and a third emission area corresponding to a third color in a wavelength band lower than that of the second color. The color conversion array layer may include a first color conversion pattern corresponding to the first emission area and including first color conversion members configured to convert at least a portion of light of the plurality of light emitting elements into light of the first color, a second color conversion pattern corresponding to the second emission area and including second color conversion members configured to convert at least a portion of the light of the light emitting elements into light of the second color and a partition wall pattern corresponding to the non-emission area. The color filter layer may include a first color filter corresponding to the first emission area and configured to transmit the light of the first color, a second color filter corresponding to the second emission area and configured to transmit the light of the second color, a third color filter corresponding to the third emission area and configured to transmit the light of the third color and a light blocking pattern corresponding to the non-emission area.

The plurality of light emitting elements may be configured to emit the light of the third color. The color conversion array layer may further include a transmission pattern corresponding to the third emission area and configured to transmit the light of the plurality of light emitting elements.

The plurality of light emitting elements may be configured to emit light in a wavelength band lower than that of the third color. The color conversion array layer may further include a third color conversion pattern corresponding to the third emission area and including third color conversion members configured to convert at least a portion of the light of the plurality of light emitting elements into the light of the third color.

According to one or more embodiments of the present disclosure, there is provided a method of manufacturing a display device, the method includes preparing a substrate including a display area in which a plurality of emission areas are arranged and placing a transistor array layer including a plurality of thin-film transistors corresponding to the plurality of emission areas and a via layer covering the plurality of thin-film transistors, on the substrate; placing a plurality of pixel electrodes corresponding to the plurality of emission areas and a plurality of dummy patterns corresponding to a non-emission area between the plurality of emission areas on the via layer; preparing a light emitting element array layer located on an auxiliary substrate and including a plurality of light emitting elements corresponding to the plurality of emission areas; placing the light emitting element array layer on the plurality of pixel electrodes and removing the auxiliary substrate; placing a planarization layer to fill a space between the plurality of light emitting elements and to cover the plurality of pixel electrodes and the plurality of dummy patterns; placing a common electrode corresponding to the plurality of emission areas on the plurality of light emitting elements and the planarization layer; placing a color conversion array layer on the common electrode; and placing a color filter layer on the color conversion array layer.

In the placing of the plurality of pixel electrodes and the plurality of dummy patterns, the plurality of pixel electrodes may be spaced from each other by a first distance in one direction. A pixel electrode from among the plurality of pixel electrodes and a dummy pattern the plurality of dummy patterns neighboring each other in the one direction may be spaced from each other by a second distance. The preparing of the light emitting element array layer may include placing a semiconductor epitaxial layer including a first semiconductor layer of a first conductivity type, an active layer of a quantum well structure, a second semiconductor layer of a second conductivity type, and a third semiconductor layer of an undoped semiconductor sequentially stacked on a growth substrate; preparing a plurality of semiconductor structures, each of the plurality of semiconductor structures having a first width in the one direction, by patterning the semiconductor epitaxial layer; attaching the auxiliary substrate to the semiconductor structures; removing the growth substrate from the semiconductor structures; preparing the light emitting elements by placing a connection electrode on each of the semiconductor structures; increasing a distance between the light emitting elements by stretching the auxiliary substrate; and preparing the light emitting element array layer in which the light emitting elements are spaced from each other by a third distance in the one direction.

In the placing of the light emitting element array layer on the of the plurality of semiconductor structures pixel electrodes, two or more light emitting elements corresponding to an emission area among the plurality of emission areas may be placed on the pixel electrode of the emission area, and the first distance may be greater than the first width.

In the placing of the plurality of pixel electrodes and the plurality of dummy patterns, each of the plurality of dummy patterns may have a second width in the one direction, one or more dummy patterns may be between two pixel electrodes neighboring each other in the one direction from among the plurality of pixel electrodes, and a dummy pattern between two pixel electrodes neighboring each other in the one direction may be parallel to the wo pixel electrodes, spaced from each of the two pixel electrodes and spaced from one of the two pixel electrodes by the second distance in the one direction, and in the placing of the light emitting element array layer on the pixel electrodes, some light emitting elements on an edge of the one emission area from among the two or more light emitting elements corresponding to the one emission area may be supported by a dummy pattern adjacent to the edge of the one emission area.

The second distance may be less than half the first width, the sum of the second width and the second distance may be greater than half the first width, and when one dummy pattern is between two pixel electrodes neighboring each other in the one direction, the sum of twice the second width and the second distance may be less than the first distance.

In the placing of the plurality of pixel electrodes and the plurality of dummy patterns, a dummy pattern adjacent to the one emission area may have a thickness in the same range as that of the pixel electrode of the one emission area.

Optionally, in the placing of the color conversion array layer including a first color conversion pattern corresponding to a first emission area and including first color conversion members configured to convert at least a portion of light of the plurality of light emitting elements into light of a first color, a second color conversion pattern corresponding to a second emission area and including second color conversion members configured to convert at least a portion of the light of the light emitting elements into light of a second color and a partition wall pattern corresponding to the non-emission area, and in the placing of the color filter layer, the color filter layer includes a first color filter corresponding to the first emission area and configured to transmit the light of the first color, a second color filter corresponding to the second emission area and configured to transmit the light of the second color, a third color filter corresponding to a third emission area and configured to transmit light of a third color and a light blocking pattern corresponding to the non-emission area, wherein the color conversion array layer further includes one of a transmission pattern corresponding to the third emission area and configured to transmit the light of the light emitting elements and a third color conversion pattern corresponding to the third emission area and including third color conversion members configured to convert at least a portion of the light of the plurality of light emitting elements into the light of the third color.

A display device according to an embodiment may include a plurality of light emitting units respectively corresponding to a plurality of emission areas and a partition wall corresponding to a non-emission area which is a boundary between the emission areas and having a variable width in at least one direction.

Because the partition wall includes a portion having a relatively large width, it may not be easily deformed. Therefore, a decrease in the display quality, life, and yield of the display device due to deformation of the partition wall can be prevented.

In addition, because the partition wall includes a portion having a relatively small width, a decrease in the width of the light emitting units due to the partition wall can be reduced. Therefore, a decrease in the luminance of the display device due to the partition wall can be prevented.

A display device according to another embodiment includes a plurality of dummy patterns corresponding to a non-emission area between a plurality of emission areas, formed on the same layer as a plurality of pixel electrodes, and disposed parallel to the pixel electrodes.

Therefore, even if some of a plurality of light emitting elements protrude into the non-emission area due to an alignment error occurring in the process of simultaneously placing the light emitting elements on the pixel electrodes, they may be supported by the dummy patterns in the non-emission area. Accordingly, it is possible to prevent a tilting defect in which a light emitting element partially disposed in the non-emission area is tilted due to a step of a pixel electrode. Consequently, this can prevent a local increase in resistance of a common electrode, thus preventing degradation of display quality.

At least some of the above and other features of the invention are set out in the claims.

The effects of the present disclosure are not limited to the aforementioned effects, and various other effects are included in the present specification.

### BRIEF DESCRIPTION OF THE DRAWINGS

These and/or other aspects will become apparent and more readily appreciated from the following description of the embodiments, taken in conjunction with the accompanying drawings in which:
FIG. 1 is a plan view of a display device according to one or more embodiments;
FIG. 2 is a detailed view of a portion A of FIG. 1;
FIG. 3 is a cross-sectional view taken along the line A'-A" of FIG. 2;
FIG. 4 is an exploded perspective view of an example of a portion B of FIG. 2;
FIG. 5 is an example equivalent circuit diagram of an emission area of FIG. 2;
FIG. 6 is a perspective view of an example of a portion C of FIG. 2 according to a first embodiment;
FIG. 7 is a plan view illustrating rear surfaces of a partition wall portion and light emitting units in the portion B of FIG. 2 according to the first embodiment;
FIG. 8 is a plan view illustrating an example of pixel electrodes and a common connection electrode of FIG. 7;
FIGS. 9 and 10 are plan views illustrating examples of a process error related to the arrangement of light emitting elements in FIG. 7;
FIG. 11 is a cross-sectional view taken along the line D-D' of FIG. 7;
FIG. 12 is a view illustrating an example of a portion E of FIG. 11 in detail;
FIG. 13 is a view illustrating an example of a portion F of FIG. 11 in detail;
FIGS. 14 through 19 are process diagrams illustrating a process of placing a light emitting element of FIG. 12 and the partition wall portion of FIG. 13;
FIG. 20 is a plan view illustrating rear surfaces of a partition wall portion and light emitting units in the portion B of FIG. 2 according to a second embodiment;
FIG. 21 is a plan view illustrating rear surfaces of a partition wall portion and light emitting units in the portion B of FIG. 2 according to a third embodiment;
FIG. 22 is a plan view illustrating rear surfaces of a partition wall portion and light emitting units in the portion B of FIG. 2 according to a fourth embodiment;
FIG. 23 is a plan view illustrating rear surfaces of a partition wall portion and light emitting units in the portion B of FIG. 2 according to a fifth embodiment;
FIGS. 24 and 25 are views illustrating modified examples of the fifth embodiment;
FIG. 26 is a plan view illustrating rear surfaces of a partition wall portion and light emitting units in the portion B of FIG. 2 according to a sixth embodiment;
FIG. 27 is a plan view illustrating rear surfaces of a partition wall portion and light emitting units in the portion B of FIG. 2 according to a seventh embodiment;
FIG. 28 is a plan view illustrating rear surfaces of a partition wall portion and light emitting units in the portion B of FIG. 2 according to an eighth embodiment;
FIG. 29 is a cross-sectional view taken along the line G-G' of FIG. 28;
FIGS. 30, 31, and 32 are cross-sectional views taken along the line G-G' of FIG. 28, according to one or more embodiments;
FIG. 33 is a perspective view of an example of the portion C of FIG. 2 according to a ninth embodiment;
FIG. 34 is a plan view illustrating rear surfaces of a partition wall portion and light emitting units in the portion B of FIG. 2 according to the ninth embodiment;
FIG. 35 is a cross-sectional view taken along the line I-I' of FIG. 34;
FIG. 36 is a cross-sectional view taken along the line J-J' of FIG. 34;
FIG. 37 is a plan view illustrating rear surfaces of a partition wall portion and light emitting units in the portion B of FIG. 2 according to a tenth embodiment;
FIGS. 38, 39, 40, and 41 are plan views illustrating rear surfaces of partition wall portions and light emitting units according to an eleventh embodiment and modified examples of the eleventh embodiment;
FIG. 42 is a plan view of a display device according to one or more embodiments;
FIG. 43 is a layout view of an example of a transistor array layer in the display device of FIG. 42;
FIGS. 44, 45, and 46 are equivalent circuit diagrams of examples of an emission area in the transistor array layer of FIG. 43;
FIG. 47 is a layout view illustrating an example of a plurality of emission areas corresponding to a portion A of FIG. 42;
FIG. 48 is a plan view illustrating an example of pixel electrodes and dummy patterns corresponding to a portion B of FIG. 47;
FIG. 49 is a cross-sectional view of an example of a surface cut along the line C-C' of FIG. 48;
FIG. 50 is a cross-sectional view of an example of the transistor array layer of FIG. 49;
FIG. 51 is a detailed cross-sectional view of a portion D of FIG. 49;
FIG. 52 is a cross-sectional view of an example of the surface cut along the line C-C' of FIG. 48;
FIGS. 53 and 54 are plan views illustrating examples of an alignment error of light emitting elements illustrated in FIG. 48;
FIG. 55 is a cross-sectional view of an example of a surface cut along the line D-D' of FIG. 53;
FIG. 56 is a cross-sectional view of a comparative example of FIG. 55;
FIGS. 57 through 63 are plan views illustrating examples of pixel electrodes and dummy patterns corresponding to the portion B of FIG. 47;
FIG. 64 is a plan view illustrating an example of a plurality of emission areas corresponding to the portion A of FIG. 42;
FIGS. 65 and 66 are plan views illustrating examples of pixel electrodes and dummy patterns corresponding to a portion F of FIG. 64;
FIG. 67 is a flowchart illustrating a method of manufacturing a display device according to one or more embodiments;
FIG. 68 is a flowchart illustrating an operation of preparing a light emitting element array layer in FIG. 67; and
FIGS. 69 through 84 are process diagrams illustrating each operation of FIGS. 67 and 68.

### DETAILED DESCRIPTION

One or more embodiments will now be described more fully hereinafter with reference to the accompanying drawings. The embodiments may, however, be provided in different forms and should not be construed as limiting. The same reference numbers indicate the same components throughout the present disclosure. In the accompanying figures, the thickness of layers and regions may be exaggerated for clarity.

Some of the parts that are not associated with the description may not be provided in order to describe embodiments of the present disclosure.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above, and the phrase "in a schematic cross-sectional view" means when a schematic crosssection taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teaching and scope of the present disclosure.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the features of the measurement system). For example, "about" may mean within one or more standard deviations, or within ± 30%, 20%, 10%, 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" or "at least one of A or B" may be understood to mean "A, B, or A and B."

Unless otherwise defined or implied, all terms used herein (including technical and scientific terms) have the same meaning as commonly understood by those skilled in the art to which the present disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Hereinafter, embodiments will be described with reference to the accompanying drawings.

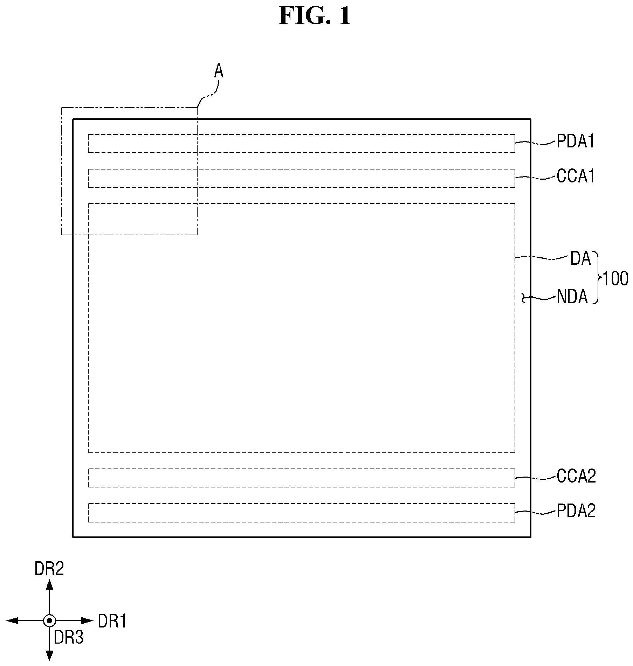

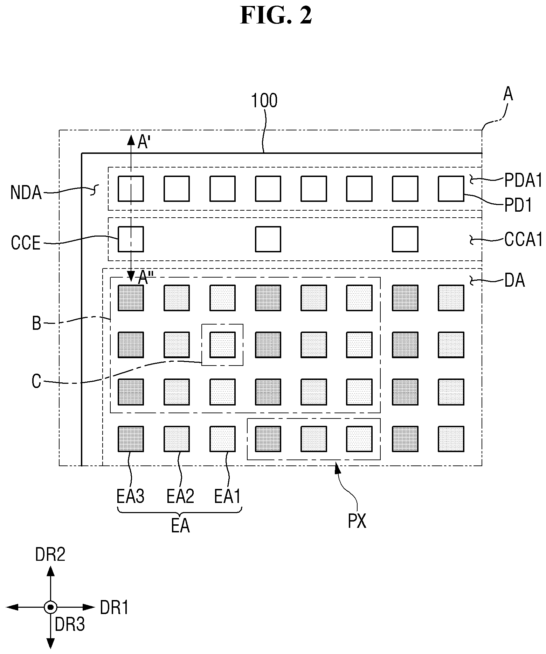

FIG. 1 is a plan view of a display device 100 according to one or more embodiments. FIG. 2 is a detailed view of a portion A of FIG. 1.

In the present specification, the display device 100 according to one or more embodiments is mainly described as an ultra-small light emitting diode display device (e.g., a micro or nano-light emitting diode display device) including an ultra-small light emitting diode (a micro or nano-light emitting diode), but one or more embodiments of the present disclosure are not limited thereto.

In addition, in the present disclosure, the display device 100 according to one or more embodiments is described, focusing on a case where light emitting elements of a plurality of light emitting units are disposed on a circuit array layer 120 disposed on a substrate 110. However, it should be noted that one or more embodiments of the present disclosure are not limited thereto. For example, the display device 100 according to one or more embodiments may also be a light emitting diode on silicon (LEDoS) display device in which light emitting diodes are disposed as light emitting elements on a semiconductor circuit board formed by a semiconductor process using a silicon wafer.

In addition, in the present disclosure, a first direction DR1 refers to a horizontal direction of the display device 100, a second direction DR2 refers to a vertical direction of the display device 100, and a third direction DR3 refers to a thickness direction of the display device 100 or a thickness direction of the semiconductor circuit board. In this case, "left," "right," "upper," and "lower" refer to directions when the display device 100 is seen in a plan view. For example, a "right side" refers to one side in the first direction DR1, a "left side" refers to the other side in the first direction DR1, an "upper side" refers to one side in the second direction DR2, and a "lower side" refers to the other side in the second direction DR2. In addition, "top" refers to one side in the third direction DR3, and "bottom" refers to the other side in the third direction DR3.

Referring to FIG. 1, the display device 100 according to one or more embodiments may be shaped like a flat plate.

For example, the display device 100 may have a quadrilateral planar shape having long sides in the first direction DR1 and short sides in the second direction DR2. However, the planar shape of the display device 100 is not limited thereto, and the display device 100 may also have a polygonal, circular, oval, or irregular planar shape other than the quadrilateral shape.

The display device 100 is a device for displaying moving images or still images. The display device 100 may be used as a display screen in portable electronic devices such as mobile phones, smartphones, tablet personal computers (PCs), smart watches, watch phones, mobile communication terminals, electronic notebooks, electronic books, portable multimedia players (PMPs), navigation devices and ultra-mobile PCs (UMPCs), as well as in various products such as televisions, notebook computers, monitors, billboards, and/or Internet of things (IoT) devices.

The display device 100 includes a display area DA configured to emit light for displaying an image and a non-display area NDA disposed around the display area DA along an edge or periphery of the display area DA and not displaying an image.

The display area DA may follow the planar shape of the display device 100. For example, the display area DA may have a quadrilateral shape as illustrated in FIG. 1.

The display area DA may be disposed in the center (e.g., a central portion) of the display device 100.

The non-display area NDA may be around (e.g., may surround) the display area DA along an edge or periphery of the display area DA.

The non-display area NDA may include a first pad portion PDA1 and a second pad portion PDA2 disposed on both sides of the display area DA in the second direction DR2, a first common connection area CCA1 between the display area DA and the first pad portion PDA1, and a second common connection area CCA2 disposed between the display area DA and the second pad portion PDA2.

Referring to FIG. 2, the display device 100 may include a plurality of emission areas EA arranged in the display area DA and configured to emit light for displaying an image.

The emission areas EA may include first emission areas EA1, second emission areas EA2, and third emission areas EA3 configured to emit light of different colors. In addition, a combination of the first through third emission areas EA1 through EA3 adjacent to each other may form a pixel PX, which is a minimum light emitting unit that can display white light.

That is, the display device 100 includes a plurality of pixels PX arranged in a matrix in the display area DA and configured to emit their respective luminances and colors, and each of the pixels PX is composed of the first through third emission areas EA1 through EA3 adjacent to each other.

In one or more embodiments of the present disclosure, a case where each of the pixels PX includes three emission areas EA1 through EA3 corresponding to different colors is described as an example. However, embodiments of the present disclosure are not limited thereto. For example, each of the pixels PX may also include four emission areas.

The first emission areas EA1 are areas that emit light of a first color (hereinafter, referred to as "first light"). The first light may be light in a blue wavelength band. The blue wavelength band may be about 370 to 460 nm, but one or more embodiments of the present disclosure are not limited thereto.

The second emission areas EA2 are areas that emit light of a second color (hereinafter, referred to as "second light") in a wavelength band higher than that of the first color. The second light may be light in a green wavelength band. The green wavelength band may be about 480 to 560 nm, but one or more embodiments of the present one or more are not limited thereto.

The third emission areas EA3 are areas that emit light of a third color (hereinafter, referred to as "third light") in a wavelength band higher than that of the second color. The third light may be light in a red wavelength band. The red wavelength band may be about 600 to 750 nm, but one or more embodiments of the present disclosure are not limited thereto.

The first emission areas EA1, the second emission areas EA2, and the third emission areas EA3 may be alternately arranged along the first direction DR1. For example, the first emission areas EA1, the second emission areas EA2, and the third emission areas EA3 may be arranged along the first direction DR1 in the order of the first emission area EA1, the second emission area EA2, and the third emission area EA3.

The first emission areas EA1 may be arranged side by side in the second direction DR2. The second emission areas EA2 may be arranged side by side in the second direction DR2. The third emission areas EA3 may be arranged side by side in the second direction DR2.

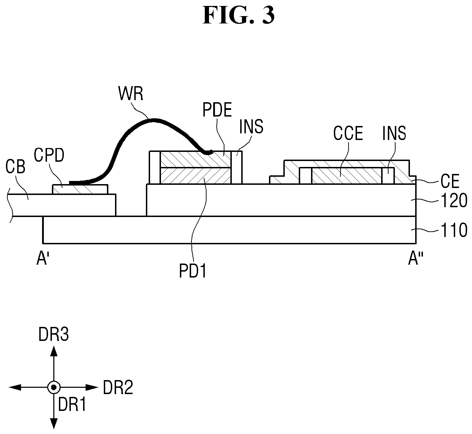

The first pad portion PDA1 may be disposed on an upper side of a display device 100. The first pad portion PDA1 may include first pads PD1 connected to an external circuit board CB (see FIG. 3).

The second pad portion PDA2 may be disposed on a lower side of the display device 100. The second pad unit PDA2 may include second pads for connection to the external circuit board CB (see FIG. 3). The second pad portion PDA2 may also be omitted.

Each of the first common connection area CCA1 and the second common connection area CCA2 may include a plurality of common connection electrodes CCE.

FIG. 3 is a cross-sectional view taken along the line A'-A" of FIG. 2.

Referring to FIG. 3, the display device 100 according to one or more embodiments may include a substrate 110, a circuit array layer 120 disposed on the substrate 110, a common connection electrode CCE disposed on the circuit array layer 120 in the first common connection area CCA1, a common electrode CE disposed on the circuit array layer 120 and covering the common connection electrode CCE, a first pad PD1 disposed on the circuit array layer 120 in the first pad portion PDA1, and a pad connection electrode PDE disposed on the first pad PD1.

The first pad PD1 may be connected to the common connection electrode CCE through a wiring of the circuit array layer 120.

The pad connection electrode PDE may be electrically connected to a pad CPD of the circuit board CB fixed on one side of the substrate 110 through a wire WR.

The circuit board CB may be a flexible printed circuit board (FPCB), a printed circuit board (PCB), a flexible printed circuit (FPC), or a flexible film such as a chip on film (COF).

The common connection electrode CCE and the pad connection electrode PDE may be made of the same layer and the same material.

The display device 100 may further include an insulating layer INS covering sides (e.g., side surfaces) of each of the first pad PD1, the common connection electrode CCE, and the pad connection electrode PDE.

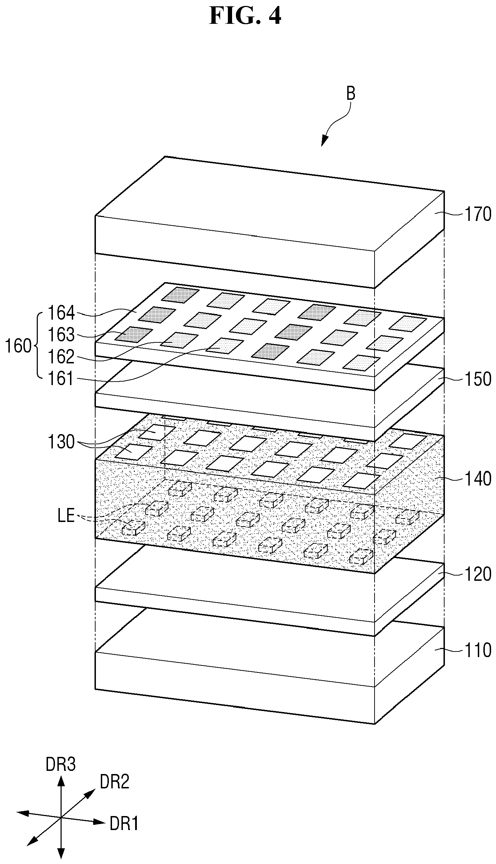

FIG. 4 is an exploded perspective view of an example of a portion B of FIG. 2.

Referring to FIG. 4, the display device 100 according to one or more embodiments includes the substrate 110 including the display area DA in which a plurality of emission areas EA are arranged, a plurality of light emitting units 130 disposed on the substrate 110 and respectively corresponding to the emission areas EA, and a partition wall portion (i.e., a partition wall) 140 disposed on the substrate 110 and corresponding to a non-emission area, which is a boundary between the emission areas EA.

The substrate 110 may be provided in the form of a rigid flat plate. Alternatively, the substrate 110 may be provided in the form of a flexible flat plate that is easily deformable, for example, bendable, foldable, or rollable.

The substrate 110 may be made of an insulating material such as glass, quartz, and/or polymer resin. Here, the polymer material may be, for example, polyethersulphone (PES), polyacrylate (PA), polyarylate (PAR), polyetherimide (PEI), polyethylene naphthalate (PEN), polyethylene terepthalate (PET), polyphenylene sulfide (PPS), polyallylate, polyimide (PI), polycarbonate (PC), cellulose triacetate (CAT), cellulose acetate propionate (CAP), and/or a combination thereof.

Alternatively, the substrate 110 may be made of a metal material or a silicon wafer.

The substrate 110 supports the circuit array layer 120, the light emitting units 130, and the partition wall portion 140.

Each of the light emitting units 130 includes a light emitting element LE disposed on the substrate 110.

The light emitting element LE may have an upper surface of a polygonal (such as quadrilateral), circular, oval, or irregular shape.

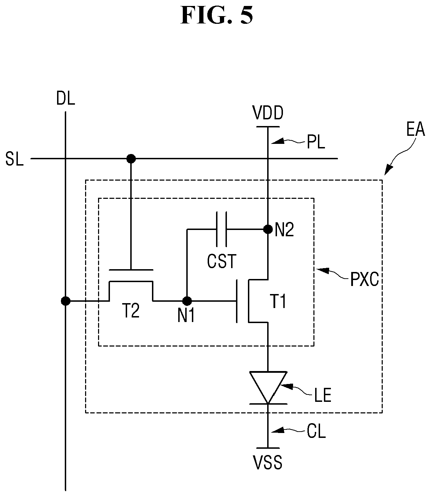

The display device 100 according to the described embodiment may further include the circuit array layer 120 disposed on the substrate 110. The circuit array layer 120 may include a plurality of pixel circuit units respectively corresponding to the emission areas EA. The pixel circuit units will be described later with reference to FIG. 5.

The light emitting units 130 and the partition wall portion 140 may be disposed on the circuit array layer 120.

The display device 100 according to the described embodiment may further include a color filter layer 160 disposed on the light emitting units 130 and the partition wall portion 140. The color filter layer 160 may include first color filters 161 corresponding to the first emission areas EA1, second color filters 162 corresponding to the second emission areas EA2, and third color filters 163 corresponding to the third emission areas EA3. The color filter layer 160 may further include a light blocking portion 164 corresponding to the non-emission area.

The first color filters 161 cover the light emitting units 130 of the first emission areas EA1 and transmit the first light.

The second color filters 162 cover the light emitting units 130 of the second emission areas EA2 and transmit the second light.

The third color filters 163 cover the light emitting units 130 of the third emission areas EA3 and transmit the third light.

The display device 100 according to the described embodiment may further include a protective layer 150 covering the light emitting units 130 and the partition wall portion 140. In this case, the color filter layer 160 may be disposed on the protective layer 150.

Each of the light emitting units 130 may be sealed with the protective layer 150.

For example, the protective layer 150 may be made of an inorganic layer selected from among a silicon oxide (SiO₂) layer, an aluminum oxide (Al₂O₃) layer, and/or a hafnium oxide (HfOₓ) layer, but embodiments of the present disclosure are not limited thereto.

The display device 100 according to the described embodiment may further include a protective substrate 170 disposed on the color filter layer 160. However, this is merely an example, and embodiments of the present disclosure are not limited thereto.

The protective substrate 170 may be attached onto the color filter layer 160 through a suitable adhesive layer (e.g., a predetermined adhesive layer).

The protective substrate 170 may be made of a glass material including SiO₂ as its main component. Alternatively, the protective substrate 170 may be made of a plastic material. The plastic material may be one or more selected from among polyethersulphone (PES), polyacrylate (PAR), polyetherimide (PEI), polyethylene naphthalate (PEN), polyethyelene terephthalate (PET), polyphenylene sulfide (PPS), polyallylate, polyimide, polycarbonate (PC), cellulose triacetate (TAC), and/or cellulose acetate propionate (CAP).

FIG. 5 is an example equivalent circuit diagram of an emission area EA of FIG. 2.

Referring to FIG. 5, the display device 100 includes a plurality of pixel circuit units PXC respectively corresponding to the emission areas EA and respectively connected to the light emitting elements LE of the emission areas EA. The pixel circuit units PXC may be implemented as the circuit array layer 120.

Each of the pixel circuit units PXC may include one or more thin-film transistors T1 and T2.

For example, as illustrated in FIG. 5, a pixel circuit unit PXC may include a first thin-film transistor T1 connected to a light emitting element LE, and a second thin-film transistor T2 and a storage capacitor CST connected to the first thin-film transistor T1.

The first thin-film transistor T1 may be connected in series to the light emitting element LE between a power line PL supplying first driving power VDD and a common line CL supplying second driving power VSS having a lower voltage level than the first driving power VDD.

That is, a first electrode of the first thin-film transistor T1 may be connected to the power line PL, and a second electrode of the first thin-film transistor T1 may be connected to an anode of the light emitting element LE.

In addition, a cathode of the light emitting element LE may be connected to the common line CL.

The second thin-film transistor T2 may be connected between a gate electrode of the first thin-film transistor T1 and a data line DL supplying a data signal corresponding to each emission area EA. In addition, a gate electrode of the second thin-film transistor T2 may be connected to a scan line SL that supplies a scan signal for selecting whether to write a data signal.

The storage capacitor CST may be connected between a first node N1 and a second node N2. The first node N1 is a contact point between the gate electrode of the first thin-film transistor T1 and the second thin-film transistor T2, and the second node N2 is a contact point between the first thin-film transistor T1 and the power line PL. That is, the storage capacitor CST is connected between the gate electrode and the first electrode of the first thin-film transistor T1.

When the second thin-film transistor T2 is turned on based on the scan signal of the scan line SL, the data signal of the data line DL is supplied to the gate electrode of the first thin-film transistor T1 and the storage capacitor CST through the turned-on second thin-film transistor T2. Accordingly, the first thin-film transistor T1 is turned on based on the data signal, and a driving current corresponding to the data signal is supplied to the light emitting element LE through the turned-on first thin-film transistor T1. In addition, the first thin-film transistor T1 may be kept turned on based on a voltage charged in the storage capacitor CST.

Next, the display device 100 according to one or more embodiments will be described.

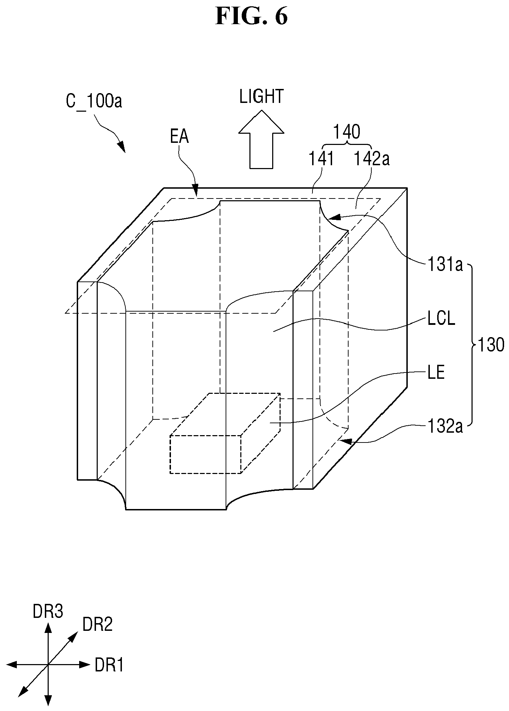

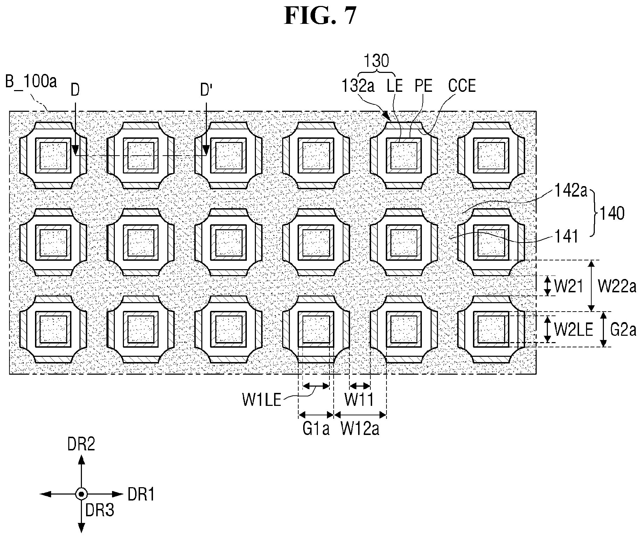

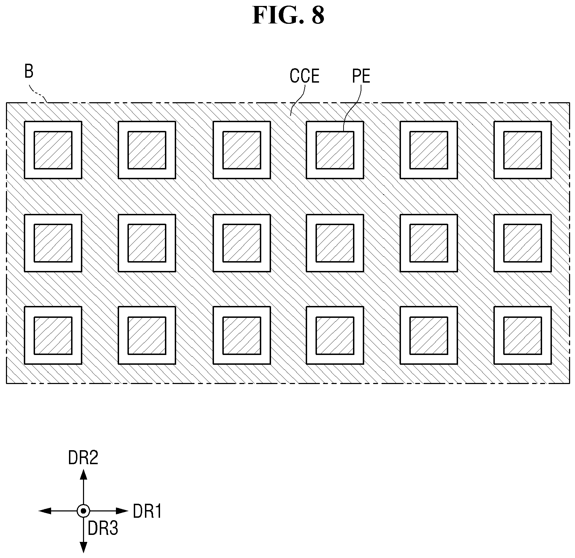

FIG. 6 is a perspective view of an example of a portion C of FIG. 2 according to a first embodiment. FIG. 7 is a plan view illustrating rear surfaces of a partition wall portion 140 and light emitting units 130 in the portion B of FIG. 2 according to the first embodiment. FIG. 8 is a plan view illustrating an example of pixel electrodes PE and a common connection electrode CCE of FIG. 7.

Referring to FIG. 6, a display device 100a according to the first embodiment includes the partition wall portion 140 disposed on a substrate 110, corresponding to a non-emission area, which is a boundary between a plurality of emission areas EA, and having a variable width in at least one direction.

The partition wall portion 140 includes a plate portion (i.e., a plate) 141 corresponding to the non-emission area and a pillar portion (i.e., a pillar) 142a protruding from at least a portion of the plate portion 141 into each of the emission areas EA and having a greater width than the plate portion 141.

Each of the light emitting units 130 may include a light emitting element LE disposed on the substrate 110 and a light control layer LCL disposed on the substrate 110 to cover the light emitting element LE and configured to control the characteristics of light emitted from the light emitting element LE.

The light control layer LCL may include scattering particles that diffuse the light of the light emitting element LE.

Alternatively, the light control layer LCL may include not only the scattering particles but also wavelength conversion particles that convert the light of the light emitting element LE into light of a higher wavelength band. For example, the wavelength conversion particles may be quantum dots.

For example, when the light emitting elements LE of the light emitting units 130 emit first light in a lowest wavelength band from among first light, the second light and the third light, the light control layers LCL of the light emitting units 130 corresponding to the first emission areas EA1 may include only scattering particles and may scatter and transmit the first light emitted from the light emitting elements LE.

On the other hand, the light control layers LCL of the light emitting units 130 corresponding to the second emission areas EA2 configured to emit the second light of a wavelength band higher than that of the first light may include first wavelength conversion particles that convert the first light of the light emitting elements LE into the wavelength band of the second light. Accordingly, the light emitting units 130 corresponding to the second emission areas EA2 may emit the second light into which the first light of the light emitting elements LE have been converted by the first wavelength conversion particles of the light control layers LCL.

In addition, the light control layers LCL of the light emitting units 130 corresponding to the third emission areas EA3 configured to emit the third light of a wavelength band higher than that of the second light may include second wavelength conversion particle that convert the first light of the light emitting elements LE into the wavelength band of the third light. Accordingly, the light emitting units 130 corresponding to the third emission areas EA3 may emit the third light into which the first light of the light emitting elements LE have been converted by the second wavelength conversion particles of the light control layers LCL.

However, this is merely an example, and the wavelength band of light of the light emitting elements LE and the light control layer LCL of each of the light emitting units 130 are not limited thereto.

Each of the light emitting units 130 has a light emitting surface 131a corresponding to the light control layer LCL and configured to emit light and a rear surface 132a opposite the light emitting surface 131a.

According to the first embodiment, the partition wall portion 140 has a variable width in at least one direction. To this end, the partition wall portion 140 may include a portion protruding into each emission area EA and thus having a greater width than the non-emission area. Accordingly, the rear surface 132a of each of the light emitting units 130 may have at least one corner or at least one side formed in a shape corresponding to that of the partition wall portion 140.

According to the first embodiment, the partition wall portion 140 includes the plate portion 141 corresponding to the non-emission area and the pillar portion 142a protruding from at least a portion of the plate portion 141 into each emission area EA and having a greater width than the plate portion 141.

The pillar portion 142a of the partition wall portion 140 may correspond to each corner of each emission area EA.

In addition, a height of the pillar portion 142a may be equal to a height of the plate portion 141 in the third direction DR3.

Accordingly, the light emitting surface 131a and the rear surface 132a of each of the light emitting units 130 may be formed in a quadrilateral shape having each corner deformed by the pillar portion 142a of the partition wall portion 140.

Referring to FIG. 7, the pillar portion 142a of the partition wall portion 140 according to the first embodiment may correspond to corners of four neighboring light emitting units 130. That is, the pillar portion 142a of the first embodiment may be provided in a cylindrical shape partially disposed on corners of the light emitting surfaces 131a and the rear surfaces 132a of four neighboring light emitting units 130.

As described above, according to the first embodiment, the partition wall portion 140 includes the pillar portion 142a protruding from the plate portion 141 to a corner of each of a plurality of emission areas EA and having a greater width than the plate portion 141.

That is, a width W12a of the pillar portion 142a in the first direction DR1 is greater than a width W11 of the plate portion 141 in the first direction DR1.

In addition, a width W22a of the pillar portion 142a in the second direction DR2 is greater than a width W21 of the plate portion 141 in the second direction DR2.

Because the pillar portion 142a having a greater width than the plate portion 141 is inserted between parts of the plate portion 141 having a width corresponding to that of the non-emission area, the strength of the partition wall portion 140 may be increased. Therefore, the partition wall portion 140 can be prevented from being easily deformed by physical impact or the like. Accordingly, it is possible to prevent a decrease in the display quality, life, and yield of the display device 100 due to easy deformation of the partition wall portion 140.

In addition, because not the entire partition wall portion 140 is formed to have the width of the pillar portion 142a, a significant decrease in the width of the emission areas EA due to the strengthened partition wall portion 140 can be prevented. Accordingly, it is possible to prevent the luminance of the emission areas EA from being greatly reduced due to the partition wall portion 140.

Referring to FIGS. 7 and 8, the display device 100a according to the first embodiment may include a plurality of pixel electrodes PE respectively corresponding to the emission areas EA.

In addition, the display device 100a according to the first embodiment may further include the common connection electrode CCE corresponding to the non-emission area, which is a boundary between the emission areas EA, and spaced from each of the pixel electrodes PE. When the common connection electrode CCE is disposed in a display area DA, the resistance of a common electrode CE may be lowered.

However, this is merely an example, and the common connection electrode CCE may also not be disposed in the display area DA, but may be disposed only in a first common connection area CCA1 and a second common connection area CCA2 of a non-display area NDA.

As illustrated in FIG. 7, the light emitting element LE of each of the light emitting units 130 may be disposed on a pixel electrode PE.

In addition, a minimum distance G1a or G2a between the pillar portions 142a corresponding to both sides of a light emitting unit 130 is greater than a width of the light emitting element LE of the light emitting unit 130.

That is, the minimum distance G1a between the pillar portions 142a corresponding to both sides of a light emitting unit 130 in the first direction DR1 is greater than a width W1LE of the light emitting element LE of the light emitting unit 130 in the first direction DR1.

In addition, the minimum distance G2a between the pillar portions 142a corresponding to both sides of a light emitting unit 130 in the second direction DR2 is greater than a width W2LE of the light emitting element LE of the light emitting unit 130 in the second direction DR2.

In this case, a distance margin between each light emitting element LE and the partition wall portion 140 can be maintained regardless of the pillar portions 142a protruding into the emission areas EA.

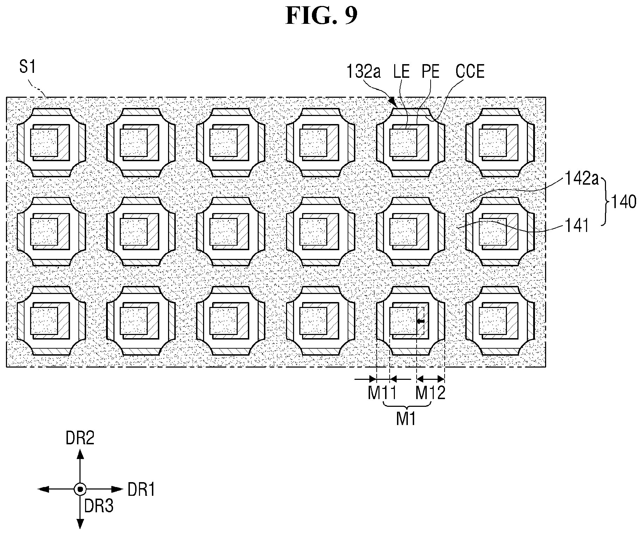

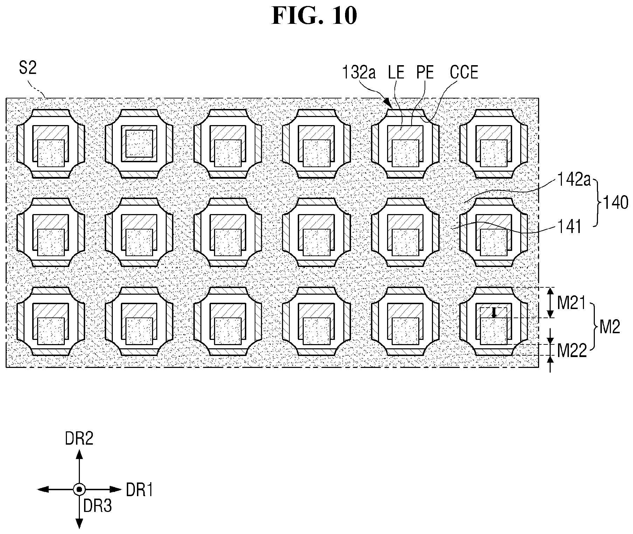

FIGS. 9 and 10 are plan views illustrating examples of a process error related to the arrangement of the light emitting elements LE in FIG. 7.

Referring to FIG. 9, when a process error S1 in which the light emitting elements LE are shifted to any one side in the first direction DR1 compared with the partition wall portion 140 occurs in a process of placing the light emitting elements LE, a distance margin M1 between each light emitting element LE and the partition wall portion 140 in the first direction DR1 may not be affected by the pillar portions 142a of the partition wall portion 140.

Here, the distance margin M1 between each light emitting element LE and the partition wall portion 140 in the first direction DR1 may include a first margin M11 corresponding to the partition wall portion 140 neighboring the light emitting element LE on one side in the first direction DR1 and a second margin M12 corresponding to the partition wall portion 140 neighboring the light emitting element LE on the other side in the first direction DR1.

In addition, referring to FIG. 10, when a process error S2 in which the light emitting elements LE are shifted to any one side in the second direction DR2 compared with the partition wall portion 140 occurs in the process of placing the light emitting elements LE, a distance margin M2 between each light emitting element LE and the partition wall portion 140 in the second direction DR2 may not be affected by the pillar portions 142a of the partition wall portion 140.

Here, the distance margin M2 between each light emitting element LE and the partition wall portion 140 in the second direction DR2 may include a third margin M21 corresponding to the partition wall portion 140 neighboring the light emitting element LE on one side in the second direction DR2 and a fourth margin M22 corresponding to the partition wall portion 140 neighboring the light emitting element LE on the other side in the second direction DR2.

As described above, according to the first embodiment, the minimum distance G1a or G2a between the pillar portions 142a corresponding to both sides of a light emitting unit 130 is greater than the width of the light emitting element LE of the light emitting unit 130. Therefore, it is possible to prevent the distance margin M1 or M2 between the light emitting element LE and the partition wall portion 140 from being reduced by the pillar portions 142a.

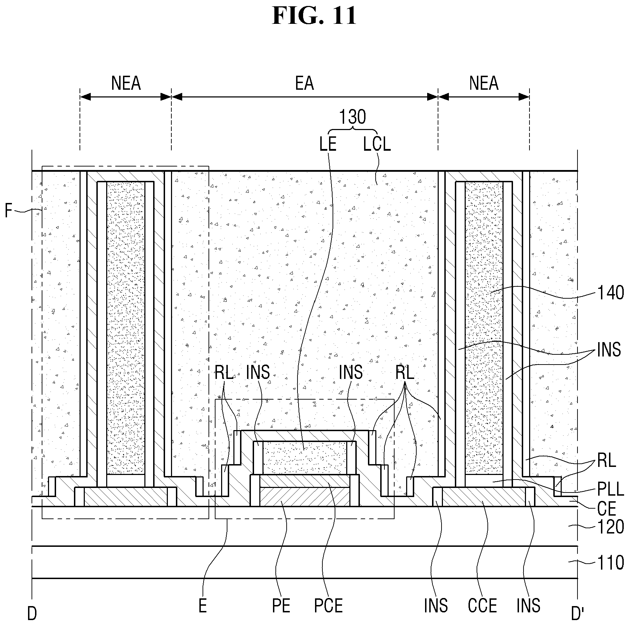

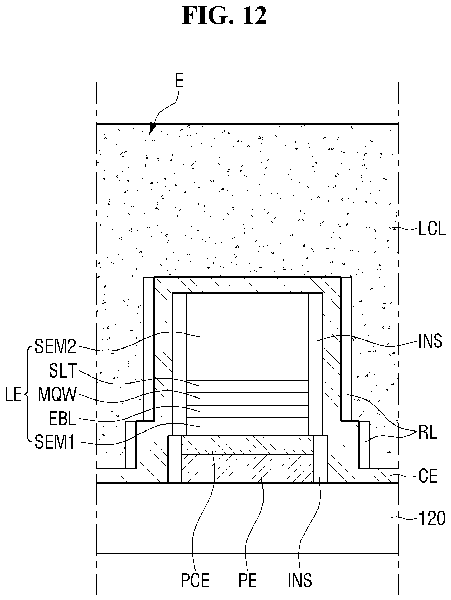

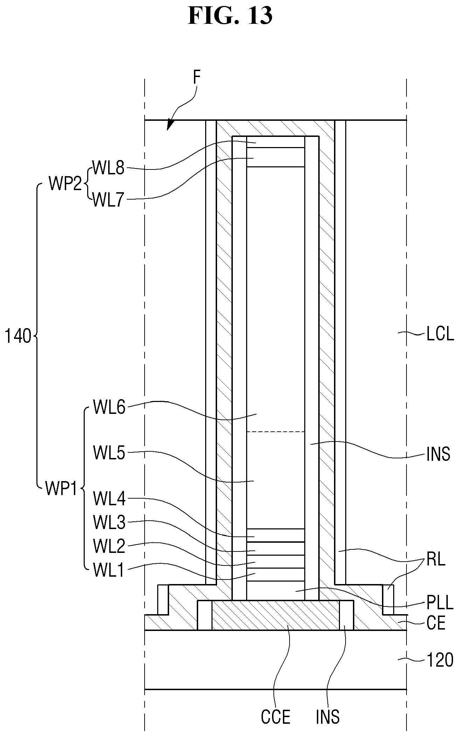

FIG. 11 is a cross-sectional view taken along the line D-D' of FIG. 7. FIG. 12 is a view illustrating an example of a portion E of FIG. 11 in detail. FIG. 13 is a view illustrating an example of a portion F of FIG. 11 in detail.

Referring to FIG. 11, the display device 100a according to the first embodiment may further include a pixel electrode PE disposed on the substrate 110 and corresponding to each of the emission areas EA, a pixel connection electrode PCE disposed between the pixel electrode PE and a light emitting element LE, a common connection electrode CCE disposed on the substrate 110 and corresponding to a non-emission area NEA, which is a boundary between the emission areas EA, a planarization layer PLL disposed between the common connection electrode CCE and the partition wall portion 140, an insulating layer INS covering side surfaces of each of the pixel electrode PE, the pixel connection electrode PCE, the light emitting element LE, the common connection electrode CCE, the planarization layer PLL and the partition wall portion 140, the common electrode CE corresponding to the emission areas EA and covering the insulating layer INS, the partition wall 140, and the light emitting element LE, and a reflective layer RL corresponding to the side surfaces of each of the pixel electrode PE, the pixel connection electrode PCE, the light emitting element LE, the common connection electrode CCE, the planarization layer PLL and the partition wall portion 140, and disposed on the common electrode CE.

The light control layer LCL of each of the light emitting units 130 may be disposed between portions of the reflective layer RL that correspond to sides of the partition wall portion 140 to cover the light emitting element LE and the common electrode CE.

The pixel electrode PE may include one or more selected from among gold (Au), copper (Cu), aluminum (Al), and/or tin (Sn).

The pixel connection electrode PCE and the common connection electrode CCE may be made of the same layer. The pixel connection electrode PCE and the common connection electrode CCE may include one or more selected from among gold (Au), copper (Cu), aluminum (Al), and/or tin (Sn). Alternatively, the common connection electrode CCE may include a first layer including one or more selected from among gold (Au), copper (Cu), aluminum (Al) and/or tin (Sn) and a second layer disposed on the first layer and including one or more selected from among gold (Au), copper (Cu), aluminum (Al) and/or tin (Sn).

The light emitting element LE may be disposed on the pixel connection electrode PCE. The light emitting element LE may be a vertical light emitting diode element including an anode and a cathode that are opposite each other in the third direction DR3. For example, a length of the light emitting element LE in the third direction DR3 may be about 1 to 5 *µ*m.

The light emitting element LE may be a micro-light emitting diode or a nano-light emitting diode.

The planarization layer PLL may be designed to offset a step difference due to the pixel electrode PE.

The planarization layer PLL may be made of an inorganic layer including one or more selected from among silicon oxide (SiO₂) layer, an aluminum oxide (Al₂O₃) layer, and/or a hafnium oxide (HfOₓ) layer, but embodiments of the present specification are not limited thereto.

The insulating layer INS is designed to insulate the pixel electrode PE and the common electrode CE from each other.

The insulating layer INS may be made of an inorganic layer including one or more selected from among a silicon oxide (SiO₂) layer, an aluminum oxide (Al₂O₃) layer, and/or a hafnium oxide (HfOₓ) layer, but embodiments of the present disclosure are not limited thereto.

The common electrode CE may include a transparent conductive material. For example, the common electrode CE may include a transparent conductive oxide (TCO) such as indium tin oxide (ITO) and/or indium zinc oxide (IZO).

The reflective layer RL reflects light traveling in a direction other than the third direction DR3 from among light emitted from each light emitting unit 130. The reflective layer RL may include a metal material having high reflectivity such as aluminum (Al). A thickness of the reflective layer RL may be about 0.1 *µ*m. The light efficiency of each light emitting unit 130 may be improved by the reflective layer RL.

The light control layer LCL may be made of a base resin in which at least scattering particles among scattering particles and wavelength conversion particles are dispersed. The base resin may include a light-transmitting organic material. For example, the base resin may include one or more selected from among epoxy resin, acrylic resin, cardo resin, and/or imide resin.

The wavelength conversion particles may be quantum dots, quantum rods, a fluorescent material, and/or a phosphorescent material. The quantum dots may include Group IV nanocrystals, Group II-VI compound nanocrystals, Group III-V compound nanocrystals, Group IV-VI nanocrystals, or a combination thereof.

Each quantum dot may include a core and a shell over-coating the core. The core may be, but is not limited to, for example, one or more selected from among CdS, CdSe, CdTe, ZnS, ZnSe, ZnTe, GaN, GaP, GaAs, GaSb, AIN, AIP, AlAs, AlSb, InP, InAs, InSb, SiC, Ca, Se, In, P, Fe, Pt, Ni, Co, Al, Ag, Au, Cu, FePt, Fe₂O₃, Fe₃O₄, Si, and/or Ge. The shell may include, but not limited to, for example, one or more selected from among ZnS, ZnSe, ZnTe, CdS, CdSe, CdTe, HgS, HgSe, HgTe, AIN, AIP, AlAs, AlSb, GaN, GaP, GaAs, GaSb, GaSe, InN, InP, InAs, InSb, TIN, TIP, TIAs, TISb, PbS, PbSe, and/or PbTe.

The scattering particles may include metal oxide particles or organic particles. For example, the metal oxide may be one or more selected from among titanium oxide (TiO₂), zirconium oxide (ZrO₂), silicon dioxide (SiO₂), aluminum oxide (Al₂O₃), indium oxide (In₂O₃), zinc oxide (ZnO), and/or tin oxide (SnO₂). In addition, the organic particles may include acrylic resin and/or urethane resin. The scattering particles may have a diameter of several to several tens of nanometers.

Referring to FIG. 12, the light emitting element LE may include a first semiconductor layer SEM1, an electron blocking layer EBL, an active layer MQW, a superlattice layer SLT, and a second semiconductor layer SEM2 stacked in the third direction DR3.

The first semiconductor layer SEM1 may be disposed on the pixel connection electrode PCE. The first semiconductor layer SEM1 may be doped with a dopant of a first conductive type such as Mg, Zn, Ca, Se, and/or Ba. For example, the first semiconductor layer SEM1 may be p-GaN doped with p-type Mg. A thickness of the first semiconductor layer SEM1 may be about 30 to 200 nm.

The electron blocking layer EBL may be disposed on the first semiconductor layer SEM1. The electron blocking layer EBL may be a layer for suppressing or preventing too many electrons from flowing into the active layer MQW. For example, the electron blocking layer EBL may be p-AlGaN doped with p-type Mg. A thickness of the electron blocking layer EBL may be about 10 to 50 nm. The electron blocking layer EBL may also be omitted.

The active layer MQW may be disposed on the electron blocking layer EBL. The active layer MQW may emit light through combination of electron-hole pairs according to electrical signals received though the first semiconductor layer SEM1 and the second semiconductor layer SEM2. The active layer MQW may emit first light whose central wavelength band is in the range of 450 to 495 nm, that is, light in a blue wavelength band.

The active layer MQW may include a material having a single or multiple quantum well structure. When the active layer MQW includes a material having a multiple quantum well structure, it may have a structure in which a plurality of well layers and a plurality of barrier layers are alternately stacked. Here, the well layers may be made of InGaN, and the barrier layers may be made of GaN or AlGaN, but embodiments of the present disclosure are not limited thereto. The well layers may have a thickness of about 1 to 4 nm, and the barrier layers may have a thickness of 3 to 10 nm.

Alternatively, the active layer MQW may have a structure in which a semiconductor material having a large band gap energy and a semiconductor material having a small band gap energy are alternately stacked or may include different Group III to V semiconductor materials depending on the wavelength band of light that it emits. Light emitted from the active layer MQW is not limited to the first light (e.g., light in the blue wavelength band). In some cases, the second light (e.g., the light in a green wavelength band) or the third light (e.g., the light in a red wavelength band) may be emitted.

The superlattice layer SLT may be disposed on the active layer MQW. The superlattice layer SLT may be a layer for relieving stress between the second semiconductor layer SEM2 and the active layer MQW. For example, the superlattice layer SLT may be made of InGaN or GaN. A thickness of the superlattice layer SLT may be about 50 to 200 nm. The superlattice layer SLT may also be omitted.

The second semiconductor layer SEM2 may be disposed on the superlattice layer SLT. The second semiconductor layer SEM2 may be doped with a dopant of a second conductivity type such as Si, Ge, or Sn. For example, the second semiconductor layer SEM2 may be n-GaN doped with n-type Si. A thickness of the second semiconductor layer SEM2 may be about 500 nm to about 1 *µ*m.

Referring to FIG. 13, a portion of the partition wall portion 140 may be made of the same layer as the light emitting element LE.

That is, the partition wall portion 140 may include a first wall portion WP1 made of the same layer as the light emitting element LE and a second wall portion WP2 disposed on the first wall portion WP1 and made of a mask for patterning a semiconductor laminate.

The first wall portion WP1 may include a first wall layer WL1 made of the same layer as the first semiconductor layer SEM1 (see FIG. 12), a second wall layer WL2 made of the same layer as the electron blocking layer EBL (see FIG. 12), a third wall layer WL3 made of the same layer as the active layer MQW (see FIG. 12), a fourth wall layer WL4 made of the same layer as the superlattice layer SLT (see FIG. 12), and a fifth wall layer WL5 made of the same layer as the second semiconductor layer SEM2.

In addition, the partition wall portion 140 has a thickness sufficient to surround the light control layer LCL and is disposed higher than the light emitting element LE. Accordingly, the first wall portion WP1 of the partition wall portion 140 may further include a sixth wall layer WL6 disposed on the fifth wall layer WL5. The sixth wall layer WL6 may be made of the same material as the second semiconductor layer SEM2. Alternatively, the sixth wall layer WL6 may be made of an undoped semiconductor material.

The second wall portion WP2 may include a seventh wall layer WL7 made of the same layer as a first mask layer corresponding to the light emitting element LE and an eighth wall layer WL8 made of the same layer as a second mask layer corresponding to the partition wall portion 140.

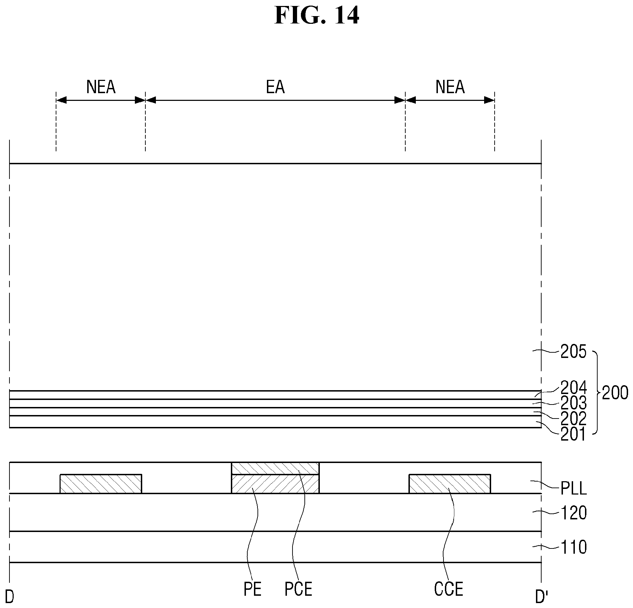

FIGS. 14 through 19 are process diagrams illustrating a process of placing the light emitting element LE of FIG. 12 and the partition wall portion 140 of FIG. 13.

Referring to FIG. 14, a circuit array layer 120 is placed on a substrate 110, and a pixel electrode PE of each emission area EA is placed on the circuit array layer 120. Then, a pixel connection electrode PCE is placed on the pixel electrode PE, a common connection electrode CCE of a non-emission area NEA is placed, and a planarization layer PLL is placed to cover the pixel connection electrode PCE and the common connection electrode CCE. Next, the planarization layer PLL is mirror-finished until an upper surface of the pixel connection electrode PCE is exposed.

A semiconductor laminate 200 is bonded onto the planarization layer PLL processed to expose the upper surface of the pixel connection electrode PCE.

The semiconductor laminate 200 may include a first layer 201 corresponding to the first semiconductor layer SEM1, a second layer 202 corresponding to the electron blocking layer EBL, a third layer 203 corresponding to the active layer MQW, a fourth layer 204 corresponding to the superlattice layer SLT, and a fifth layer 205 corresponding to the second semiconductor layer SEM2.

In addition, the semiconductor laminate 200 may further include a sixth layer disposed on the fifth layer 205 and corresponding to the sixth wall layer WL6 of the partition wall portion 140.

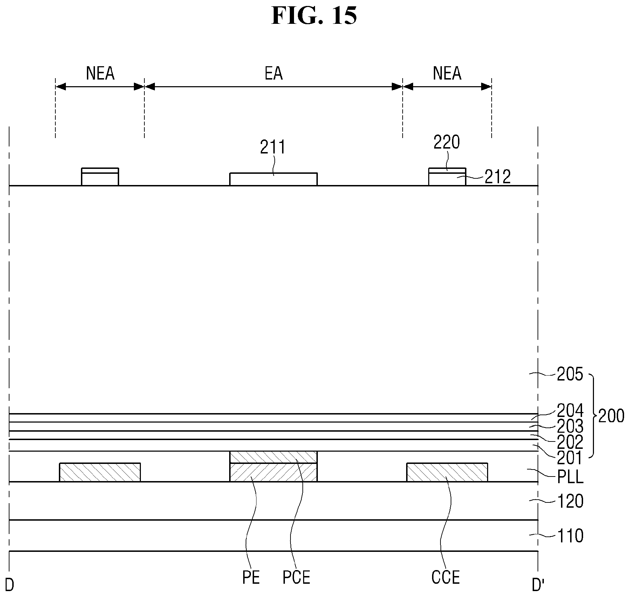

Referring to FIG. 15, a first mask layer 211 and 212 and a second mask layer 220 are placed on the semiconductor laminate 200.

The first mask layer 211 may include an element mask pattern 211 corresponding to the light emitting element LE which is to be disposed in a part of the center of each emission area EA and a partition wall mask pattern 212 corresponding to the partition wall portion 140 which is to be disposed in the non-emission area NEA.

The first mask layer 211 and 212 may be made of an inorganic layer including one or more selected from among a silicon oxide (SiO₂) layer, an aluminum oxide (Al₂O₃) layer, and/or a hafnium oxide (HfOₓ) layer. A thickness of the first mask layer 211 may be about 1 to 2 *µ*m.

The second mask layer 220 is placed on the partition wall mask pattern 212. The second mask layer 220 may include a metal material such as nickel (Ni). A thickness of the second mask layer 220 may be about 0.01 to 1 *µ*m.

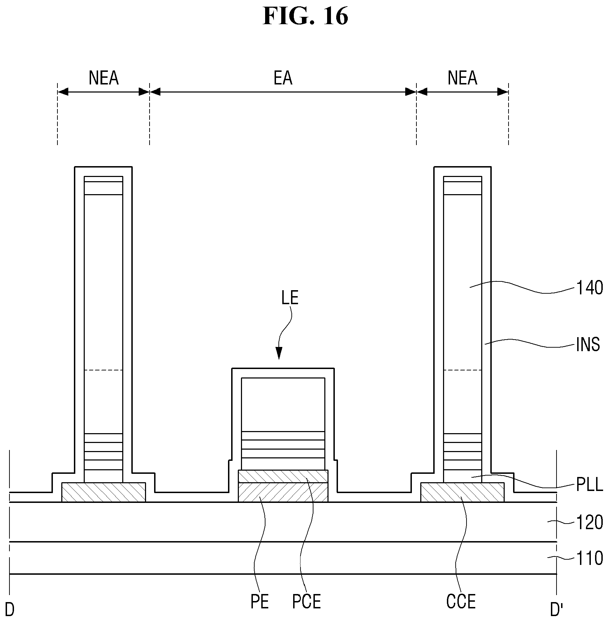

Referring to FIG. 16, the light emitting element LE and the partition wall portion 140 may be separated by patterning the semiconductor laminate 200 in areas where the first mask layer 211 and 212 and the second mask layer 220 are not disposed.

When the semiconductor laminate 200 is patterned for the placement of the partition wall portion 140, the planarization layer PLL is also patterned. Therefore, the planarization layer PLL may have the same width as the partition wall portion 140. Accordingly, the partition wall portion 140 may be disposed on the planarization layer PLL covering a portion of the common connection electrode CCE.

Next, the light emitting element LE may be provided by patterning the semiconductor laminate 200 to a portion of the fifth layer 205 in an area where the second mask layer 220 is not disposed, that is, in an area corresponding to the element mask pattern 211.

The light emitting element LE may be disposed on most of the upper surface of the pixel connection electrode PCE. Alternatively, the light emitting element LE may be aligned with the pixel connection electrode PCE in the third direction DR3.

Next, an insulating layer INS is placed to cover the light emitting element LE and the partition wall portion 140.

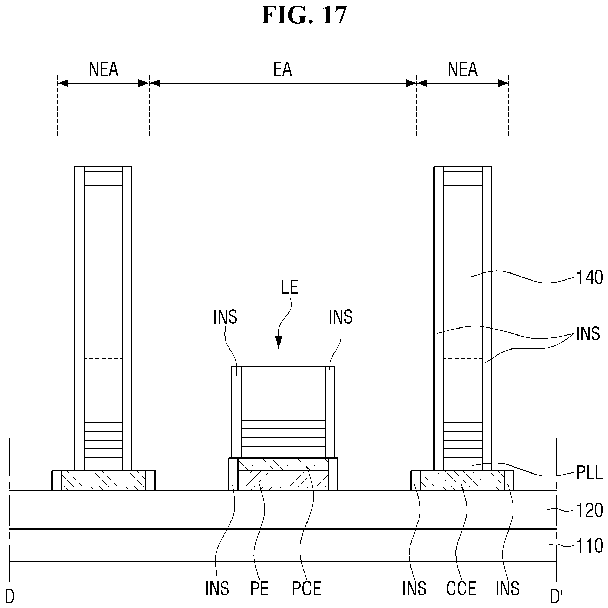

Referring to FIG. 17, horizontal portions of the insulating layer INS are removed through mirror machining to produce the insulating layer INS covering side surfaces of each of the pixel electrode PE, the pixel connection electrode PCE, the light emitting element LE, the common connection electrode CCE, the planarization layer PLL, and the partition wall portion 140.

The insulating layer INS may remain on edges of the pixel connection electrode PCE.

The insulating layer INS may insulate the pixel electrode PE and the pixel connection electrode PCE as well as the first semiconductor layer SEM1, etc. of the light emitting element LE connected to the pixel electrode PE and the pixel connection electrode PCE from a common electrode CE.

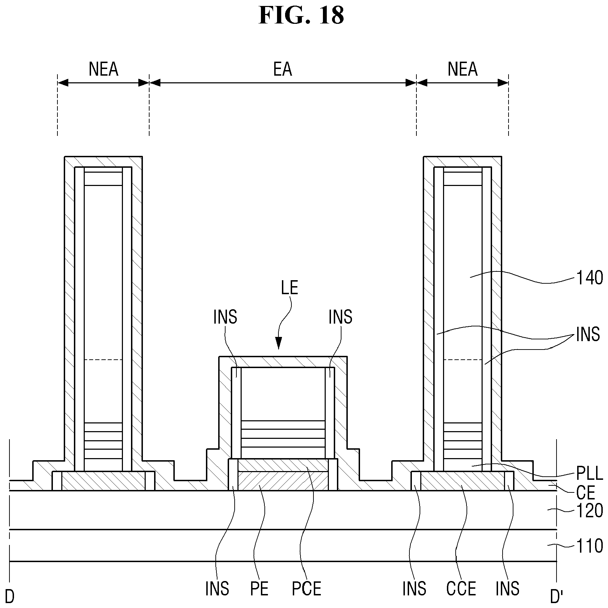

Referring to FIG. 18, the common electrode CE is placed to cover the insulating layer INS by stacking a conductive layer on the entire surface of the substrate 110.

Because the insulating layer INS covers the sides of the common connection electrode CCE, the common electrode CE may contact an upper surface of the common connection electrode CCE. Accordingly, the common electrode CE may be electrically connected to the common connection electrode CCE.

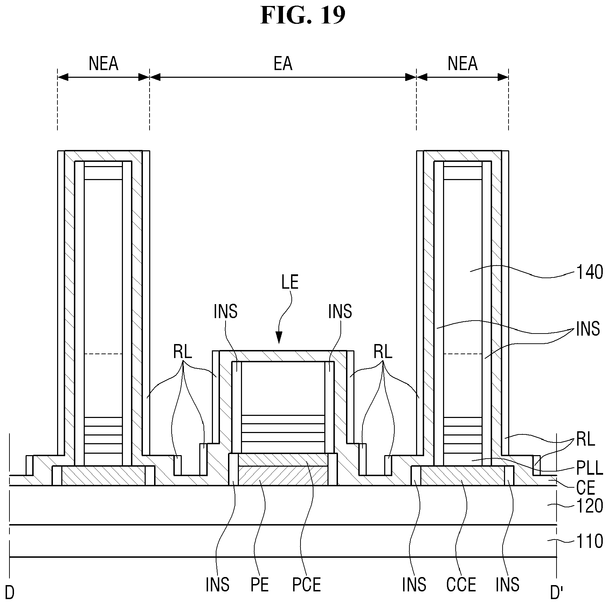

Referring to FIG. 19, a reflective layer RL is stacked on the common electrode CE, and then horizontal portions of the reflective layer RL are removed through mirror machining to produce the reflective layer RL disposed on the common electrode CE and corresponding to the side surfaces of each of the pixel electrode PE, the pixel connection electrode PCE, the light emitting element LE, the common connection electrode CCE, the planarization layer PLL, and the partition wall portion 140.

According to the first embodiment, the partition wall portion 140 includes the pillar portion 142a corresponding to corners of four neighboring light emitting units 130 and having a cylindrical shape. However, embodiments of the present disclosure are not limited to the first embodiment, and the partition wall portion 140 can be variously modified as long as it includes the plate portion 141 and the pillar portion 142a having a greater width than the plate portion 141.

Hereinafter, display devices according to other embodiments will be described.

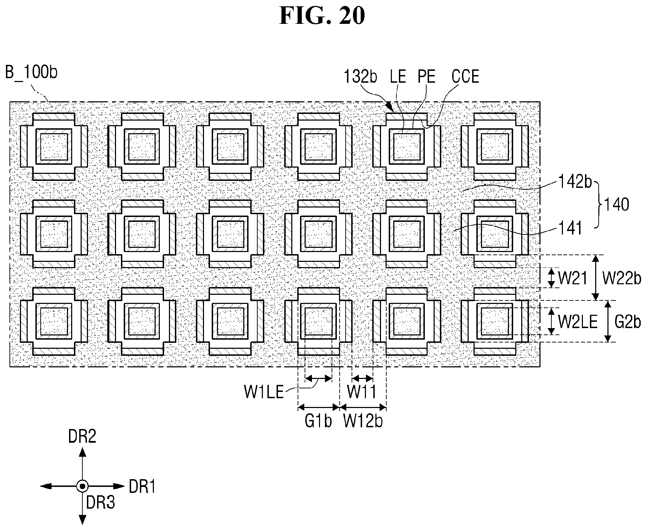

FIG. 20 is a plan view illustrating rear surfaces of a partition wall portion 140 and light emitting units 130 in the portion B of FIG. 2 according to a second embodiment.

Referring to FIG. 20, a display device 100b according to the second embodiment is the same as the display device 100a of the first embodiment except that the partition wall portion 140 includes a pillar portion 142b corresponding to the corners of four neighboring light emitting units 130 and having a prism shape with a quadrilateral cross section. Therefore, any redundant description will be omitted below.

According to the second embodiment, a width W12b of the pillar portion 142b in the first direction DR1 is greater than a width W11 of a plate portion 141 in the first direction DR1, and a width W22b of the pillar portion 142b in the second direction DR2 is greater than a width W21 of the plate portion 141 in the second direction DR2. Accordingly, the strength of the partition wall portion 140 may be increased by the pillar portion 142b.

In addition, a minimum distance G1b between the pillar portions 142b corresponding to both sides of a light emitting unit 130 in the first direction DR1 is greater than a width W1LE of a light emitting element LE in the first direction DR1. In addition, a minimum distance G2b between the pillar portions 142b corresponding to both sides of a light emitting unit 130 in the second direction DR2 is greater than a width W2LE of the light emitting element LE in the second direction DR2. Accordingly, a distance margin between the light emitting element LE and the partition wall portion 140 may be maintained regardless of the pillar portions 142b.

According to the second embodiment, because the pillar portions 142b of the partition wall portion 140 have a prism shape, a decrease in the width of a rear surface 132b of each light emitting unit 130 by the partition wall portion 140 can be reduced.

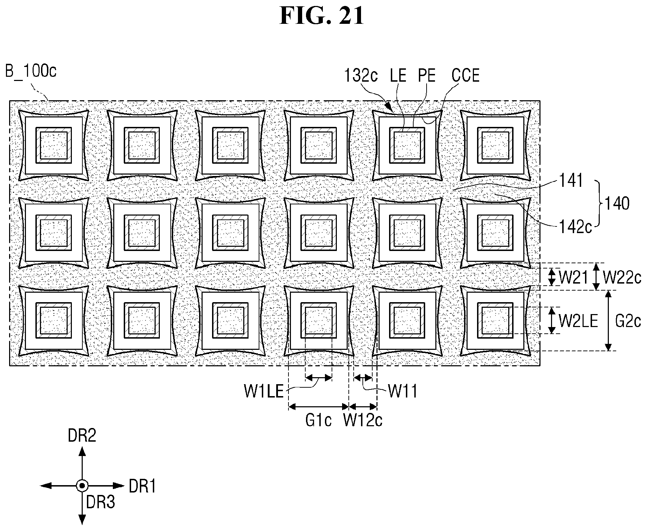

FIG. 21 is a plan view illustrating rear surfaces of a partition wall portion 140 and light emitting units 130 in the portion B of FIG. 2 according to a third embodiment.

Referring to FIG. 21, a display device 100c according to the third embodiment is the same as the display device 100a of the first embodiment except that the partition wall portion 140 includes a pillar portion 142c disposed between two neighboring light emitting units 130. Therefore, any redundant description will be omitted below.

According to the third embodiment, the pillar portion 142c is disposed in an area where sides of two light emitting units 130 corresponding to two neighboring emission areas EA face each other. The pillar portion 142c may have a cross section convexly protruding into the two emission areas EA.

Here, because a plate portion 141 is partially disposed on corners of four neighboring light emitting units 130, both ends of the pillar portion 142c may contact the plate portion 141.

According to the third embodiment, a width W12c of the pillar portion 142c in the first direction DR1 is greater than a width W11 of the plate portion 141 in the first direction DR1, and a width W22c of the pillar portion 142c in the second direction DR2 is greater than a width W21 of the plate portion 141 in the second direction DR2. Accordingly, the strength of the partition wall portion 140 may be increased by the pillar portion 142c.

In addition, a minimum distance G1c between the pillar portions 142c corresponding to both sides of a light emitting unit 130 in the first direction DR1 is greater than a width W1LE of a light emitting element LE in the first direction DR1. In addition, a minimum distance G2c between the pillar portions 142c corresponding to both sides of a light emitting unit 130 in the second direction DR2 is greater than a width W2LE of the light emitting element LE in the second direction DR2. Accordingly, a distance margin between the light emitting element LE and the partition wall portion 140 may be maintained regardless of the pillar portions 142c.

Because the pillar portions 142c of the third embodiment correspond to the sides of the light emitting units 130, the strength of the partition wall portion 140 can be increased more efficiently.

In addition, due to the pillar portions 142c, a light emitting surface and a rear surface 132c of each of the light emitting units 130 may be composed of a combination of curved sides convex toward the center. That is, side surfaces of each light emitting unit 130 are formed in a curved shape corresponding to the shape of the pillar portions 142c. Accordingly, because the total reflection by a reflective layer RL is reduced, the light efficiency of the light emitting units 130 can be improved.

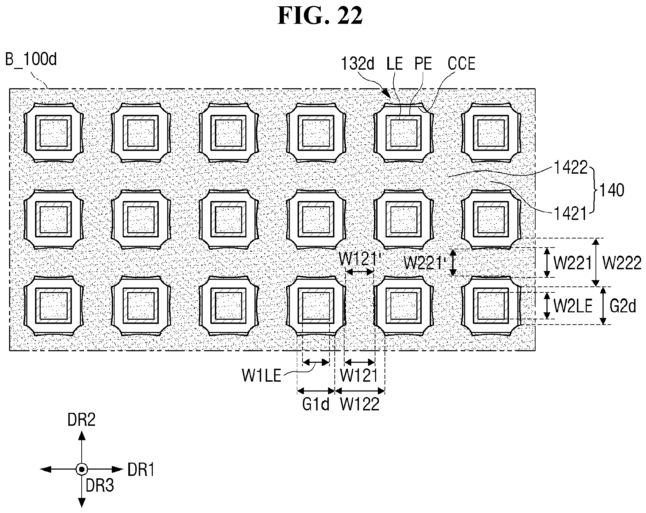

FIG. 22 is a plan view illustrating rear surfaces of a partition wall portion 140 and light emitting units 130 in the portion B of FIG. 2 according to a fourth embodiment.

Referring to FIG. 22, a display device 100d according to the fourth embodiment is the same as the display device 100a of the first embodiment and the display device 100c of the third embodiment except that the partition wall portion 140 includes a side pillar portion 1421 disposed between two neighboring light emitting units 130 and a corner pillar portion 1422 corresponding to corners of four neighboring light emitting units 130. Therefore, any redundant description will be omitted below.

According to the fourth embodiment, a width W121 or W221 of a portion of the side pillar portion 1421 which is parallel to the center of each light emitting unit 130 may be similar to a width of a non-emission area NEA. In addition, the side pillar portion 1421 may have a smaller width toward the corner pillar portion 1422. That is, a width W121' or W221' of another portion of the side pillar portion 1421, which is adjacent to the corner pillar portion 1422, is smaller than the width W121 or W221 of the portion of the side pillar portion 1421, which is parallel to the center of each light emitting unit 130. In this case, while the strength of the partition wall portion 140 is somewhat increased by the side pillar portion 1421, a decrease in the width of a rear surface 132d of each light emitting unit 130 by the side pillar portion 1421 can be reduced.

A width W122 of the corner pillar portion 1422 in the first direction DR1 is greater than the width W121 of the side pillar portion 1421 in the first direction DR1, and a width W222 of the corner pillar portion 1422 in the second direction DR2 is greater than the width W221 of the side pillar portion 1421 in the second direction DR2. Accordingly, the strength of the partition wall portion 140 can be increased by the corner pillar portion 1422.

In addition, a minimum distance G1d between the corner pillar portions 1422 corresponding to both sides of a light emitting unit 130 in the first direction DR1 is greater than a width W1LE of a light emitting element LE in the first direction DR1. In addition, a minimum distance G2d between the corner pillar portions 1422 corresponding to both sides of a light emitting unit 130 in the second direction DR2 is greater than a width W2LE of the light emitting element LE in the second direction DR2. Accordingly, a distance margin between the light emitting element LE and the partition wall portion 140 may be maintained regardless of the corner pillar portions 142d.

As described above, because the partition wall portion 140 according to the fourth embodiment further includes the corner pillar portions 1422, its strength can be further increased.

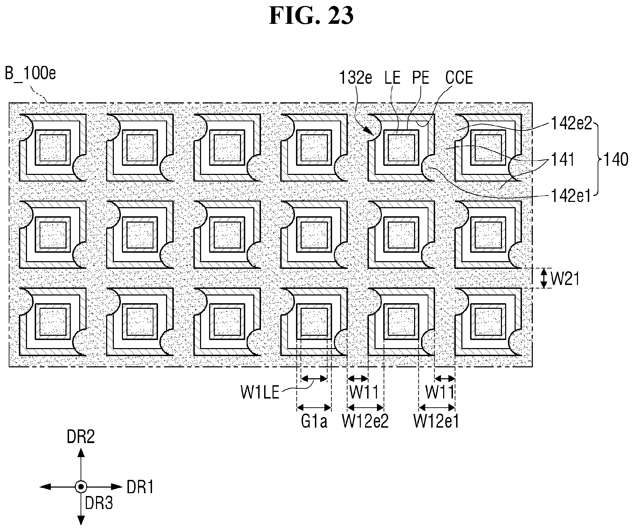

FIG. 23 is a plan view illustrating rear surfaces of a partition wall portion 140 and light emitting units 130 in the portion B of FIG. 2 according to a fifth embodiment.

Referring to FIG. 23, a display device 100e according to the fifth embodiment is the same as the display device 100a of the first embodiment except that the partition wall portion 140 includes 2n pillar portions 142e1 and 142e2 (where *n* is a natural number of 1 or more) disposed side by side between two light emitting units 130 neighboring each other in any one direction (DR1 in FIG. 23). Therefore, any redundant description will be omitted below.

The 2n pillar portions 142e1 and 142e2 include a first pillar portion 142e1 having a cross-sectional shape convex toward any one of the two neighboring light emitting units 130 and a second pillar portion 142e2 having a cross-sectional shape convex toward the other one of the two neighboring light emitting units 130.

A plate portion 141 may be disposed between two light emitting units 130 neighboring each other in another direction (DR2 in FIG. 23).

According to the fifth embodiment, the first pillar portion 142e1 and the second pillar portion 142e2 are alternately disposed between two neighboring light emitting units 130.

In addition, the first pillar portion 142e1 and the second pillar portion 142e2 alternately disposed and neighboring each other in another direction (DR2 in FIG. 23) may be point-symmetrical to each other. Alternatively, the first pillar portion 142e1 and the second pillar portion 142e2 disposed on both sides of a light emitting unit 130 may be point-symmetrical to each other.

Accordingly, a light emitting surface and a rear surface 132e of each light emitting unit 130 may have a quadrilateral shape including one side deformed by the first pillar portion 142e1 and another side facing the above side and deformed by the second pillar portion 142e2.

According to the fifth embodiment, a width W12e1 of the first pillar portion 142e1 in the first direction DR1 and a width W12e2 of the second pillar portion 142e2 in the first direction DR1 are greater than a width W11 of the plate portion 141 in the first direction DR1. Accordingly, the strength of the partition wall portion 140 may be increased by the first pillar portion 142e1 and the second pillar portion 142e2.

In addition, a minimum distance G1a between the first pillar portion 142e1 and the second pillar portion 142e2 corresponding to both sides of a light emitting unit 130 in the first direction DR1 is greater than a width W1LE of a light emitting element LE in the first direction DR1. Accordingly, a distance margin between the light emitting element LE and the partition wall portion 140 may be maintained regardless of the first pillar portion 142e1 and the second pillar portion 142e2.

According to the fifth embodiment, while the strength of the partition wall portion 140 is increased by the pillar portions 142e1 and 142e2, a decrease in the width of each light emitting unit 130 due to the protrusion of the pillar portions 142e1 and 142e2 may be reduced.

Although the first pillar portion 142e1 and the second pillar portion 142e2 neighboring each other in another direction (DR2 in FIG. 23) are point-symmetrical to each other in FIG. 23, this is merely an example.

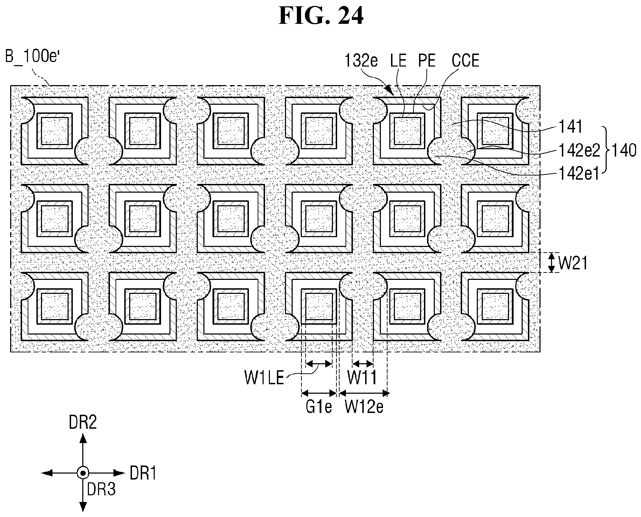

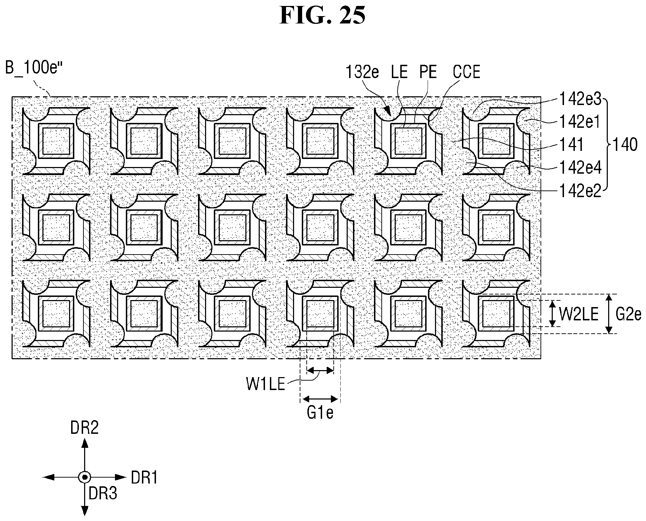

FIGS. 24 and 25 are views illustrating modified examples of the fifth embodiment.

Referring to FIG. 24, a first pillar portion 142e1 and a second pillar portion 142e2 according to a first modified example 100e' of the fifth embodiment are disposed side by side with each other in one direction (DR1 in FIG. 23) between two neighboring light emitting units 130. That is, the first pillar portion 142e1 and the second pillar portion 142e2 may be axially symmetrical to each other between the two light emitting units 130.

According to the first modified example, a total width W12e of the first pillar portion 142e1 and the second pillar portion 142e2 disposed side by side with each other in the first direction DR1 is greater than a width W11 of a plate portion 141 in the first direction DR1. Accordingly, the strength of a partition wall portion 140 may be increased by the first pillar portion 142e1 and the second pillar portion 142e2.

In addition, according to the first modified example, a minimum distance G1e between the first pillar portion 142e1 and the second pillar portion 142e2 corresponding to both sides of a light emitting unit 130 in the first direction DR1 is greater than a width W1LE of a light emitting element LE in the first direction DR1. Accordingly, a distance margin between the light emitting element LE and the partition wall portion 140 may be maintained regardless of the first pillar portion 142e1 and the second pillar portion 142e2.

Alternatively, referring to FIG. 25, a partition wall portion 140 according to a second modified example 100e" of the fifth embodiment may include a first pillar portion 142e1, a second pillar portion 142e2, a third pillar portion 142e3, and a fourth pillar portion 142e4, each protruding from a portion of a side of each light emitting unit 130 into the light emitting unit 130.

The first pillar portion 142e1 and the second pillar portion 142e2 may be respectively disposed on both sides of a light emitting unit 130 in the first direction DR1.

The third pillar portion 142e3 and the fourth pillar portion 142e4 may be respectively disposed on both sides of a light emitting unit 130 in the second direction DR2.

According to the second modified example, a minimum distance G1e between the first pillar portion 142e1 and the second pillar portion 142e2 corresponding to both sides of a light emitting unit 130 in the first direction DR1 is greater than a width W1LE of a light emitting element LE in the first direction DR1. In addition, a minimum distance G2e between the third pillar portion 142e3 and the fourth pillar portion 142e4 corresponding to both sides of a light emitting unit 130 in the second direction DR2 is greater than a width W2LE of the light emitting element LE in the second direction DR2. Accordingly, a distance margin between the light emitting element LE and the partition wall portion 140 may be maintained regardless of the first pillar portion 142e1, the second pillar portion 142e2, the third pillar portion 142e3, and the fourth pillar portion 142e4.

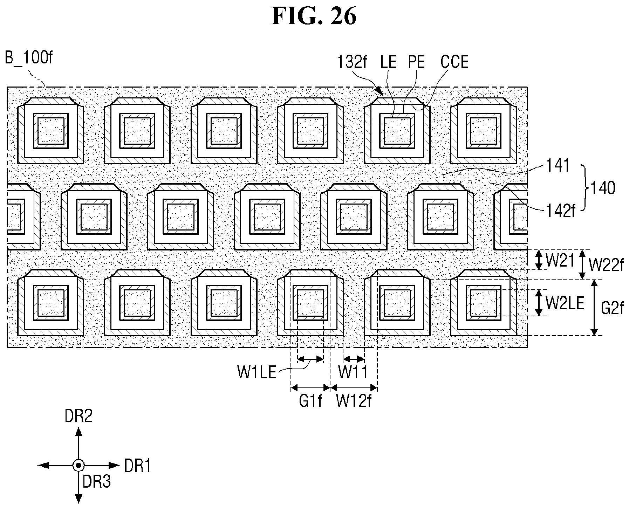

FIG. 26 is a plan view illustrating rear surfaces of a partition wall portion 140 and light emitting units 130 in the portion B of FIG. 2 according to a sixth embodiment.

Referring to FIG. 26, a display device 100f according to the sixth embodiment is the same as the display device 100a of the first embodiment except that a plurality of emission areas EA are arranged side by side in the first direction DR1 but not in the second direction DR2 and that the partition wall portion 140 includes a pillar portion 142f corresponding to corners of two light emitting units 130 neighboring each other in one direction (DR1 in FIG. 26). Therefore, any redundant description will be omitted below.

A plate portion 141 may be disposed between the pillar portions 142f neighboring each other in one direction (e.g., DR1). The plate portion 141 may be disposed nearby the light emitting units 130 in another direction (e.g., DR2).

According to the sixth embodiment, the pillar portions 142f protrude to both corners of one side of each light emitting unit 130. Accordingly, a light emitting surface and a rear surface 132f of each light emitting unit 130 may have a quadrilateral shape whose corners corresponding to both ends of one side extending in one direction (e.g., DR1) are deformed by the pillar portions 142f.

According to the sixth embodiment, a width W12f of each pillar portion 142f in the first direction DR1 is greater than a width W11 of the plate portion 141 in the first direction DR1, and a maximum width W22f of the partition wall portion 140 in the second direction DR2 is greater than a width W21 of the plate portion 141 in the second direction DR2. Accordingly, the strength of the partition wall portion 140 may be increased by the pillar portions 142f.

In addition, a minimum distance G1f between the pillar portions 142f corresponding to both sides of a light emitting unit 130 in the first direction DR1 is greater than a width W1LE of a light emitting element LE in the first direction DR1. In addition, a minimum distance G2f of the partition wall portion 140 corresponding to both sides of a light emitting unit 130 in the second direction DR2 is greater than a width W2LE of the light emitting element LE in the second direction DR2. Accordingly, a distance margin between the light emitting element LE and the partition wall portion 140 may be maintained regardless of the pillar portions 142f.

According to the sixth embodiment, because only two corners of each light emitting unit 130 are deformed by the pillar portions 142f, a decrease in the width of the light emitting unit 130 by the pillar portions 142f can be reduced.

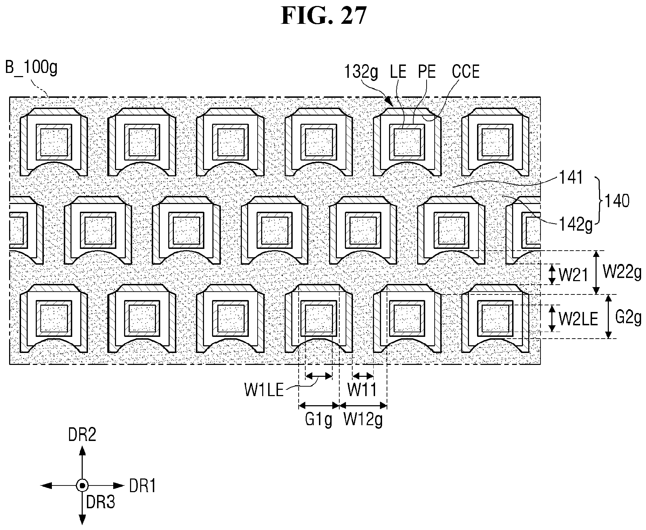

FIG. 27 is a plan view illustrating rear surfaces of a partition wall portion 140 and light emitting units 130 in the portion B of FIG. 2 according to a seventh embodiment.

Referring to FIG. 27, a display device 100g according to the seventh embodiment is the same as the display device 100f of the sixth embodiment except that the partition wall portion 140 includes a pillar portion 142g corresponding to corners of two light emitting units 130 neighboring each other in one direction (e.g., DR1 in FIG. 27) and a portion of a side of one light emitting unit 130 neighboring the two light emitting units 130 in another direction (e.g., DR2 in FIG. 27). Therefore, any redundant description will be omitted below.

According to the seventh embodiment, a light emitting surface and a rear surface 132g of each of the light emitting units 130 may have a quadrilateral shape in which corners corresponding to both ends of one side extending in one direction DR1 and a portion of another side extending in the direction DR1 are deformed by the pillar portions 142g.

According to the seventh embodiment, a maximum width W12g of each pillar portion 142g in the first direction DR1 is greater than a width W11 of a plate portion 141 in the first direction DR1, and a maximum width W22g of each pillar portion 142g in the second direction DR2 is greater than a width W21 of the plate portion 141 in the second direction DR2. Accordingly, the strength of the partition wall portion 140 may be increased by the pillar portions 142g.

In addition, a minimum distance G1g between the pillar portions 142g corresponding to both sides of a light emitting unit 130 in the first direction DR1 is greater than a width W1LE of a light emitting element LE in the first direction DR1. In addition, a minimum distance G2g between the pillar portions 142g corresponding to both sides of a light emitting unit 130 in the second direction DR2 is greater than a width W2LE of the light emitting element LE in the second direction DR2. Accordingly, a distance margin between the light emitting element LE and the partition wall portion 140 may be maintained regardless of the pillar portions 142g.

According to the seventh embodiment, because each pillar portion 142g corresponds to corners of two light emitting units 130 and a portion of one side of one light emitting unit 130 neighboring the two light emitting units 130 in another direction (DR2 in FIG. 26), the strength of the partition wall portion 140 can be further increased compared with the sixth embodiment.

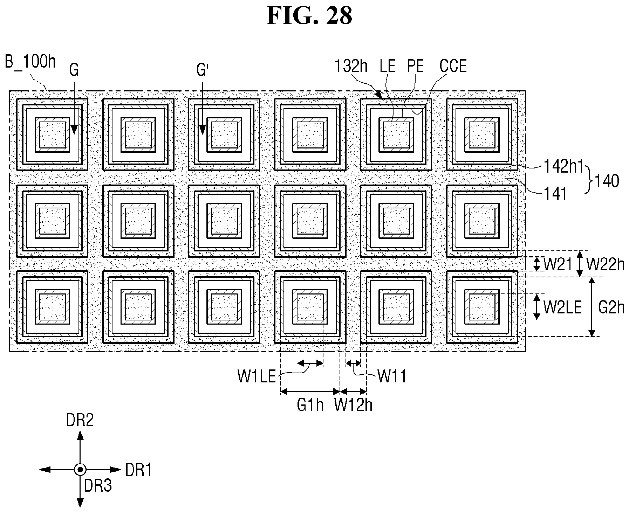

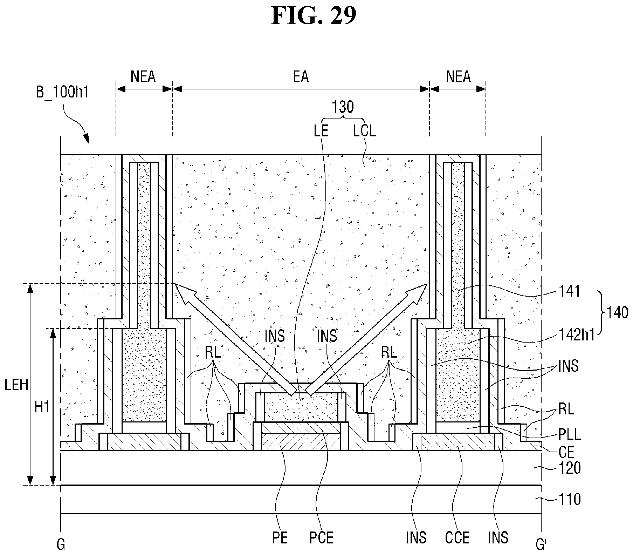

FIG. 28 is a plan view illustrating rear surfaces of a partition wall portion 140 and light emitting units 130 in the portion B of FIG. 2 according to an eighth embodiment. FIG. 29 is a cross-sectional view taken along the line G-G' of FIG. 28.

Referring to FIGS. 28 (100h) and 29 (100h1), a display device 100h according to the eighth embodiment is the same as the display device 100a of the first embodiment except that the partition wall portion 140 includes a pillar portion 142h1 disposed on sides of each light emitting unit 130 and having a lower height than a plate portion 141. Therefore, any redundant description will be omitted below.

According to the eighth embodiment, a width W12h of the pillar portion 142h1 in the first direction DR1 is greater than a width W11 of the plate portion 141 in the first direction DR1, and a width W22h of the pillar portion 142h1 in the second direction DR2 is greater than a width W21 of the plate portion 141 in the second direction DR2. Accordingly, the strength of the partition wall portion 140 may be increased by the pillar portion 142h1.

In addition, a minimum distance G1h between the pillar portion 142h1 corresponding to both sides of a light emitting unit 130 in the first direction DR1 is greater than a width W1LE of a light emitting element LE in the first direction DR1. In addition, a minimum distance G2h between the pillar portion 142h1 corresponding to both sides of a light emitting unit 130 in the second direction DR2 is greater than a width W2LE of the light emitting element LE in the second direction DR2. Accordingly, a distance margin between the light emitting element LE and the partition wall portion 140 may be maintained regardless of the pillar portion 142h1.

According to the eighth embodiment, because the height of the pillar portion 142h1 is smaller than the height of the plate portion 141, a light emitting surface of each light emitting unit 130 is not affected by the pillar portion 142h1.

That is, the light emitting surface of each light emitting unit 130 is surrounded by the plate portion 141. In addition, a rear surface 132h of each light emitting unit 130 is surrounded by the pillar portion 142h1.

Therefore, it is possible to prevent a width of the light emitting surface of each light emitting unit 130 from being reduced by the pillar portion 142h1.

In addition, a height H1 of the pillar portion 142h1 from a substrate 110 may be smaller than a light emission height LEH of the light emitting element LE from the substrate 110.

The light emission height LEH of the light emitting element LE may correspond to at least one of the width of the light emitting element LE, the width of the light emitting surface, the height of the light emitting element LE from the substrate 110, and an angle at which light is emitted from the light emitting element LE.

Because the height H1 of the pillar portion 142h1 is limited as described above, the pillar portion 142h1 is not disposed in an area to which the light emitting element LE emits light. Therefore, the effect of the pillar portion 142h1 in light emission characteristics of the light emitting element LE can be eliminated.

According to the eighth embodiment, while the strength of the partition wall portion 140 is improved by the pillar portion 142h1, a decrease in the width of the light emitting surface of each light emitting unit 130 can be prevented.

In FIG. 29, the pillar portion 142h1 according to the eighth embodiment has a desired width (e.g., a predetermined width) which is greater than that of the plate portion 141. However, this is merely an example, and the pillar portion 142h1 may also have a variable width.

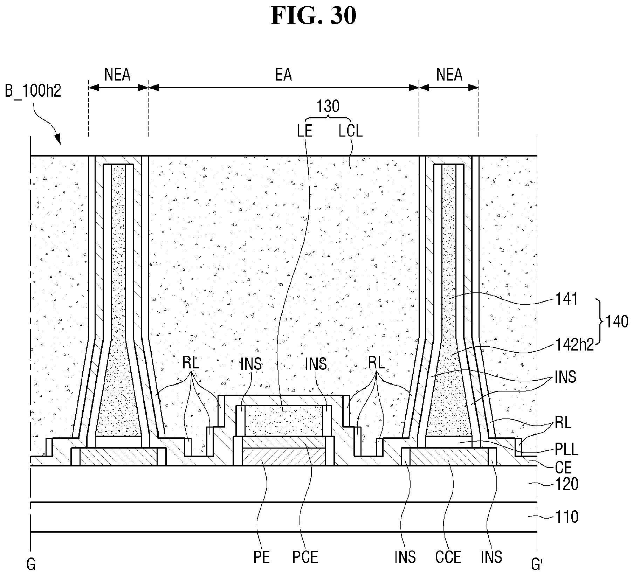

FIGS. 30, 31, and 32 are cross-sectional views taken along the line G-G' of FIG. 28, according to one or more other embodiments.

Referring to FIG. 30 (100h2), a pillar portion 142h2 according to a first example of the eighth embodiment may include inclined surfaces facing a light emitting element LE and may have a gradually decreasing width toward a plate portion 141.

In this case, because a reflective layer RL has inclined surfaces due to the pillar portion 142h2, a traveling direction of light around the light emitting element LE is highly likely to be changed to the third direction DR3 by the reflective layer RL. Therefore, the light efficiency of a light emitting unit 130 can be improved.

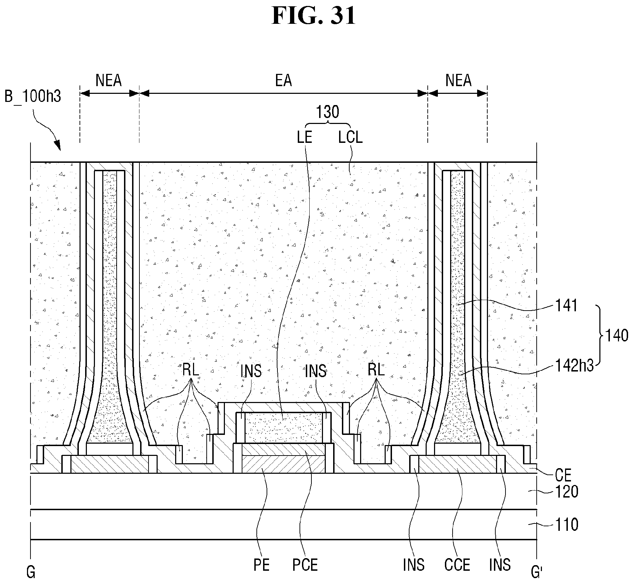

Referring to FIG. 31 (100h3), a pillar portion 142h3 according to a second example of the eighth embodiment may include curved surfaces facing a light emitting element LE and may have a gradually decreasing width toward a plate portion 141.

In this case, because a reflective layer RL has curved surfaces in the form of an exponential function graph due to the pillar portion 142h3, a traveling direction of light around the light emitting element LE is highly likely to be changed to the third direction DR3 by the reflective layer RL, and total reflection may be reduced. Therefore, the light efficiency of a light emitting unit 130 can be further improved.

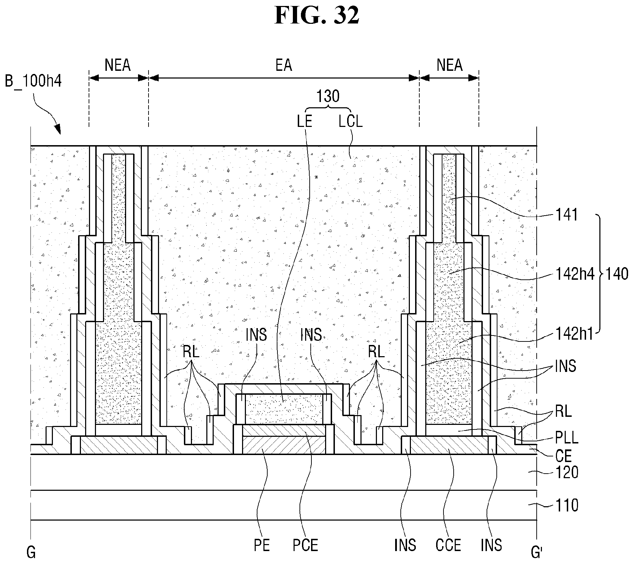

Referring to FIG. 32 (100h4), a partition wall portion 140 according to a third example of the eighth embodiment may further include a buffer portion 142h4 disposed between a pillar portion 142h1 and a plate portion 141.

The buffer portion 142h4 may have a width smaller than the width of the pillar portion 142h1 and greater than the width of the plate portion 141.

In this case, because the deformation of the plate portion 141 can be reduced by the buffer portion (i.e., a buffer) 142h4, the strength of the partition wall portion 140 can be further increased.

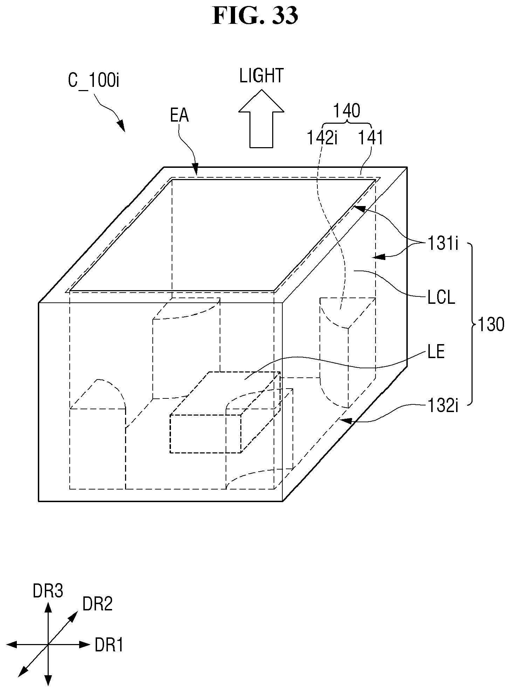

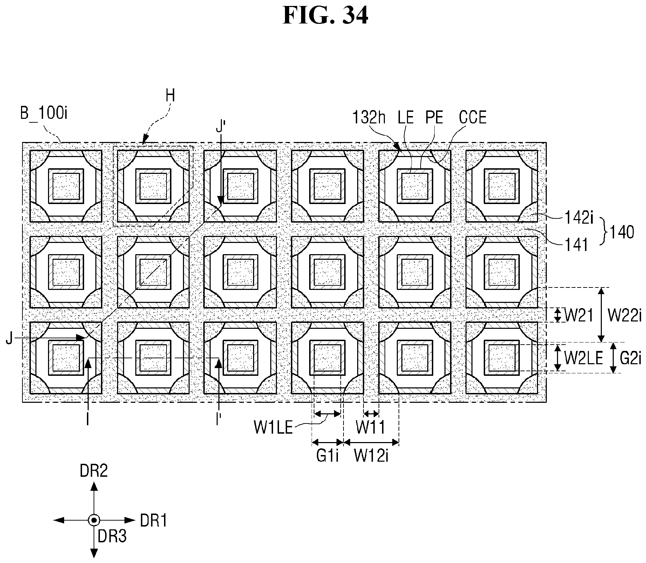

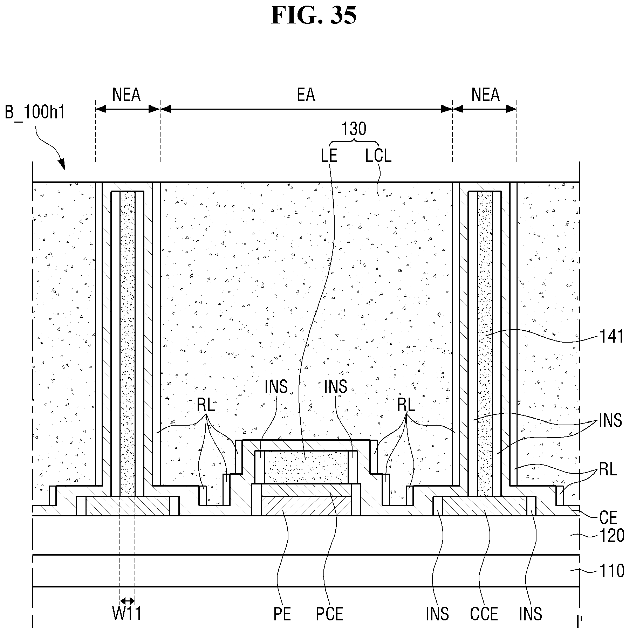

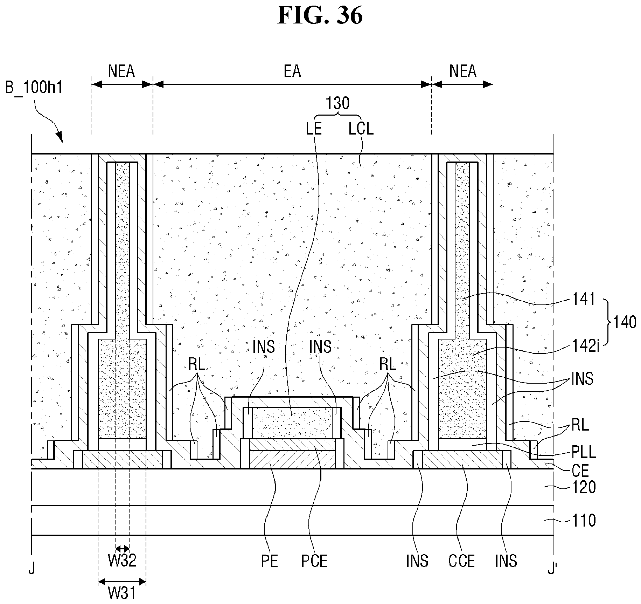

FIG. 33 is a perspective view of an example of the portion C of FIG. 2 according to a ninth embodiment. FIG. 34 is a plan view illustrating rear surfaces of a partition wall portion 140 and light emitting units 130 in the portion B of FIG. 2 according to the ninth embodiment. FIG. 35 is a cross-sectional view taken along the line I-I' of FIG. 34. FIG. 36 is a cross-sectional view taken along the line J-J' of FIG. 34.

Referring to FIGS. 33, 34, 35 and 36, a display device 100i according to the ninth embodiment is the same as the display device 100a of the first embodiment and the display device 100h of the eighth embodiment except that the partition wall portion 140 includes a pillar portion 142i protruding from a portion of a plate portion 141 to a side or corner of each light emitting unit 130 and having a lower height than the pillar portion 141. Therefore, any redundant description will be omitted below.

As illustrated in FIG. 34, according to the ninth embodiment, a width W12i of the pillar portion 142i in the first direction DR1 is greater than a width W11 of the plate portion 141 in the first direction DR1, and a width W22i of the pillar portion 142i in the second direction DR2 is greater than a width W21 of the plate portion 141 in the second direction DR2. Accordingly, the strength of the partition wall portion 140 may be increased by the pillar portion 142i.

In addition, a minimum distance G1i between the pillar portions 142i corresponding to both sides of a light emitting unit 130 in the first direction DR1 is greater than a width W1LE of a light emitting element LE in the first direction DR1. In addition, a minimum distance G2i between the pillar portions 142i corresponding to both sides of a light emitting unit 130 in the second direction DR2 is greater than a width W2LE of the light emitting element LE in the second direction DR2. Accordingly, a distance margin between the light emitting element LE and the partition wall portion 140 may be maintained regardless of the pillar portions 142i.

As illustrated in FIG. 33, according to the ninth embodiment, the height of each pillar portion 142i is smaller than that of the plate portion 141 in the third direction DR3. Therefore, only a rear surface 132i of each light emitting unit 130 may be deformed by the pillar portions 142i, and a light emitting surface 131i of each light emitting unit 130 may not be deformed by the pillar portions 142i.

That is, as illustrated in FIGS. 33, 35 (100h1) and 36 (100h1), the light emitting surface 131i of each light emitting unit 130 is surrounded by the plate portion 141. Accordingly, the light emitting surface 131i of each light emitting unit 130 may be formed in a shape corresponding to that of an emission area EA.

Therefore, it is possible to prevent the width of the light emitting surface 131i of each light emitting unit 130 from being reduced by the pillar portions 142i.

In addition, as illustrated in FIGS. 33 and 36, because the pillar portions 142i protrude to portions of each light emitting unit 130, the rear surface 132i of each light emitting unit 130 is surrounded by the plate portion 141 and the pillar portions 142i.

Accordingly, a decrease in the width of the rear surface 132i of each light emitting unit 130 by the pillar portions 142i can be reduced.

According to the ninth embodiment, each pillar portion 142i may correspond to corners of four neighboring light emitting units 130. That is, each pillar portion 142i may be partially disposed on corners of four neighboring light emitting units 130 and may have a pillar shape with a circular or elliptical cross section.

In other words, the rear surface 132i of each light emitting unit 130 may have a quadrilateral shape in which each corner is deformed by the pillar portion 142i.

As described above, according to the ninth embodiment, while the partition wall portion 140 includes the pillar portions 142i, it is possible to prevent a decrease in the width of the light emitting surface 131i of each light emitting unit 130 and possible to reduce a decrease in the width of the rear surface 132i of each light emitting unit 130. As shown in FIG. 36, a cross-sectional width W31 of the pillar portion 142i is greater than a cross-sectional width W32 of the plate portion 141.

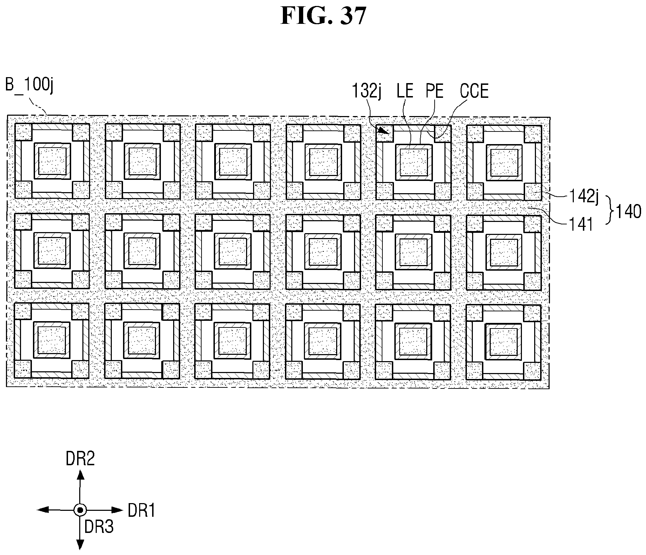

FIG. 37 is a plan view illustrating rear surfaces of a partition wall portion 140 and light emitting units 130 in the portion B of FIG. 2 according to a tenth embodiment.

Referring to FIG. 37, a display device 100j according to the tenth embodiment is the same as the display device 100i of the ninth embodiment except that a pillar portion 142j of the partition wall portion 140 has a prism shape with a quadrilateral cross section. Therefore, any redundant description will be omitted below.

According to the tenth embodiment, because the pillar portion 142j of the partition wall portion 140 has a prism shape, a decrease in the width of a rear surface 132j of each light emitting unit 130 by the partition wall portion 140 can be reduced.

Unlike the above description, each emission area EA may also be formed in a circular or elliptical shape rather than a quadrilateral shape.

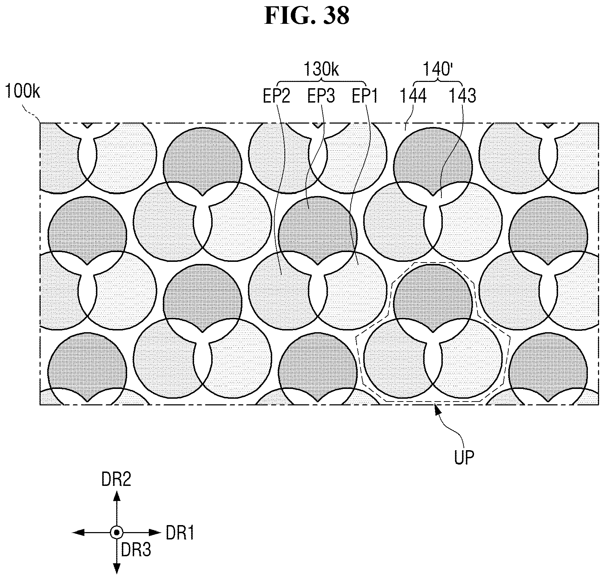

FIGS. 38, 39, 40, and 41 are plan views illustrating rear surfaces of partition wall portions and light emitting units according to an eleventh embodiment and modified examples of the eleventh embodiment.

Referring to FIG. 38, a display device 100k according to the eleventh embodiment is the same as the display device 100a of the first embodiment except that a rear surface of each of a plurality of light emitting units 130k corresponding to a plurality of emission areas EA is deformed in a circular or elliptical shape by a partition wall portion 140'. Therefore, any redundant description will be omitted below.

According to the eleventh embodiment, the light emitting units 130k may include a first light emitting unit EP1 corresponding to each first emission area configured to emit first light, a second light emitting unit EP2 corresponding to each second emission area configured to emit second light, and a third light emitting unit EP3 corresponding to each third emission area configured to emit third light. In addition, each pixel PX may be implemented as a combination of the first light emitting unit EP1, the second light emitting unit EP2, and the third light emitting unit EP3 at least partially overlapping each other.

The partition wall portion 140' according to the eleventh embodiment may include an inner partition wall portion 143 disposed at a boundary between the first light emitting unit EP1, the second light emitting unit EP2 and the third light emitting unit EP3 constituting each pixel PX and an outer partition wall portion 144 corresponding to an area around the pixels PX (see UP of FIG. 38).

Each of the inner partition wall portion 143 and the outer partition wall portion 144 may have a variable width in a plane corresponding to the first direction DR1 and the second direction DR2.

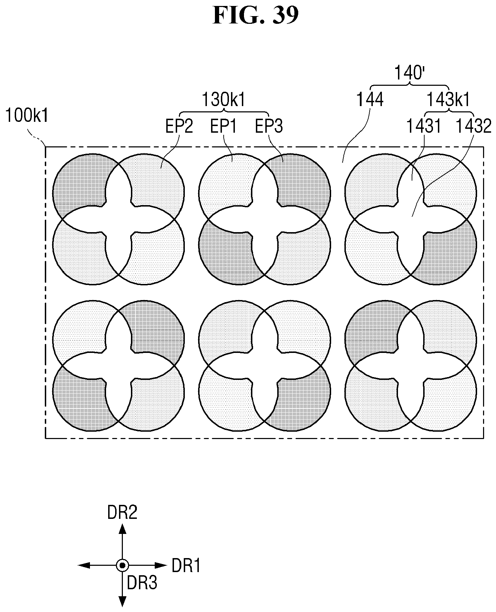

Referring to FIG. 39, a display device 100k1 according to a first example of the eleventh embodiment is the same as the display device 100k of the eleventh embodiment 100k of FIG. 38 except that four light emitting units 130k1 form one group. Therefore, any redundant description will be omitted below.

Here, any two of the four light emitting units 130k1 included in one light emitting unit group may emit light of the same color, another may emit light of another color, and the other may emit light of another color.

The light emitting units 130k1 emitting light of the same color may be arranged side by side in a diagonal direction.

An inner partition wall portion 143k1 according to the first example of the eleventh embodiment may include a first inner partition wall portion 1431 corresponding to an area between two light emitting units 130k1 neighboring each other in one direction in each light emitting unit group and a second inner partition wall portion 1432 corresponding to an area between four light emitting units 130k1 included in each light emitting unit group.

In addition, the outer partition wall portion 144 according to the first example of the eleventh embodiment may be disposed around the light emitting unit groups.

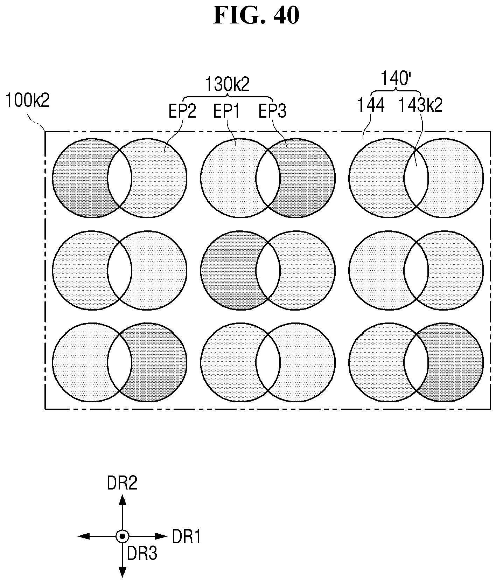

Referring to FIG. 40, a display device 100k2 according to a second example of the eleventh embodiment is the same as the display device 100k of the eleventh embodiment of FIG. 38 except that two light emitting units 130k2 disposed side by side in the first direction DR1 form one group. Therefore, any redundant description will be omitted below.

Here, a first light emitting unit EP1, a third light emitting unit EP3, and a second light emitting unit EP2, may be alternately disposed along the first direction DR1 and the second direction DR2.

An inner partition wall portion 143k2 according to the second example of the eleventh embodiment may be disposed between two light emitting units 130k2 included in each light emitting unit group.

An outer partition wall portion 144 according to the second example of the eleventh embodiment may be disposed around the light emitting unit groups.

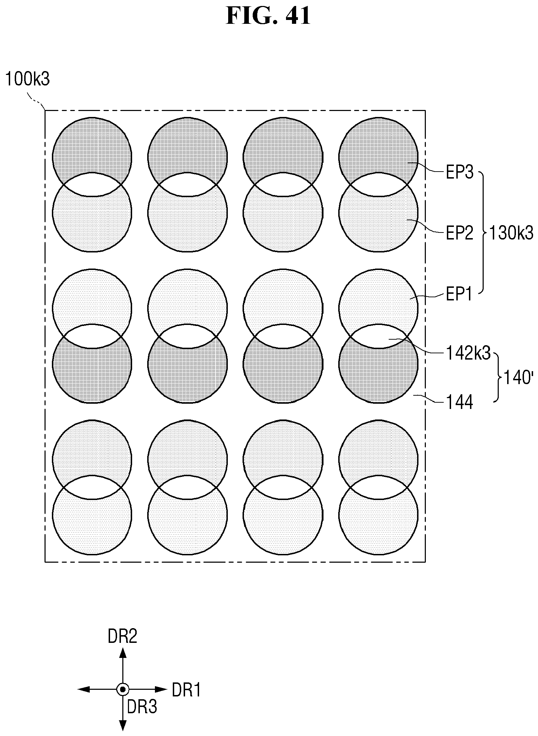

Referring to FIG. 41, a display device 100k3 according to a third example of the eleventh embodiment is the same as the display device 100k of the eleventh embodiment of FIG. 38 except that two light emitting units 130k3 disposed side by side in the second direction DR2 form one group. Therefore, any redundant description will be omitted below.

Here, first light emitting units EP1 may be arranged side by side in the first direction DR1, second light emitting units EP2 may be arranged side by side in the first direction DR1, and third light emitting units EP3 may be arranged side by side in the first direction DR1.

In addition, the first light emitting units EP1, the third light emitting units EP3, and the second light emitting units EP2 may be alternately disposed along the second direction DR2.

An inner partition wall portion 143k3 according to the third example of the eleventh embodiment may be disposed between two light emitting units 130k3 included in each light emitting unit group.

An outer partition wall portion 144 according to the third example of the eleventh embodiment may be disposed around the light emitting unit groups.

Next, a display device according to another embodiment will be described.

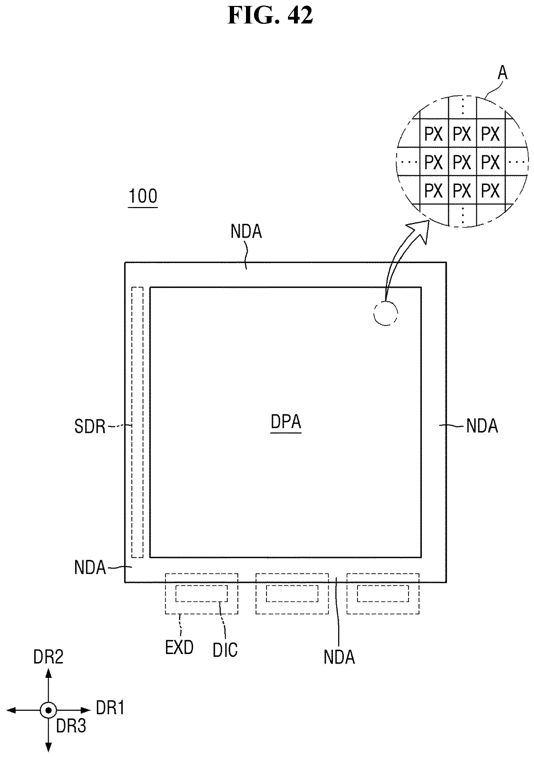

FIG. 42 is a plan view of a display device 100 according to one or more embodiments.

Referring to FIG. 42, the display device 100 according to the described embodiment may be applied to smartphones, mobile phones, tablet PCs, personal digital assistants (PDAs), PMPs, televisions, game consoles, wristwatch-type electronic devices, head mounted displays, monitors of PCs, notebook computers, car navigation systems, car dashboards, digital cameras, camcorders, outdoor billboards, electronic display boards, medical devices, examination devices, various home appliances such as refrigerators and washing machines, and/or Internet of things (IoT) devices. In the present disclosure, a television will be described as an example of a display device, and the television may have high resolution or ultra-high resolution such as HD, UHD, 4K, and/or 8K.

The display device 100 according to the described embodiment may be variously classified according to a display method. For example, the display device 100 may be classified as an organic light emitting display device, an inorganic electroluminescent (EL) display device, a quantum dot light emitting display device (QED), a micro-light emitting diode display device, a nano-light emitting diode display device, a plasma display panel (PDP), a field emission display (FED) device, a cathode ray tube (CRT) display device, a liquid crystal display (LCD) device, and/or an electrophoretic display (EPD) device. A micro-light emitting diode display device will be described below as an example of the display device 100. Unless a special distinction is required, the micro-light emitting diode display device applied to embodiments will be simply abbreviated as a display device. However, one or more embodiments are not limited to the micro-light emitting diode display device, and other display devices listed above or known in the art can also be applied within the scope of the present disclosure.

In the drawings, a first direction DR1 indicates a horizontal direction of the display device 100, a second direction DR2 indicates a vertical direction of the display device 100, and a third direction DR3 indicates a thickness direction of the display device 100. In this case, "left," "right," "upper," and "lower" refer to directions when the display device 100 is seen in a plan view. For example, a "right side" refers to one side in the first direction DR1, a "left side" refers to the other side in the first direction DR1, an "upper side" refers to one side in the second direction DR2, and a "lower side" refers to the other side in the second direction DR2. In addition, "top" refers to one side in the third direction DR3, and "bottom" refers to the other side in the third direction DR3.

The display device 100 according to the described embodiment may have a quadrate shape in a plan view, for example, a square shape. In addition, when the display device 100 is a television, it may have a rectangular shape with long sides located in the horizontal direction. However, embodiments of the present disclosure are not limited thereto, and the long sides may also be located in the vertical direction, or the display device 100 may be rotatably installed so that the long sides can be variably located in the horizontal or vertical direction. The display device 100 may also have a circular or elliptical shape.

The display device 100 may include a display area DPA and a non-display area NDA along an edge or periphery of the display area DPA. The display area DPA may be an active area in which an image is displayed. The display area DPA may have a square shape similar to the overall shape of the display device 100 in a plan view, but embodiments of the present disclosure are not limited thereto. That is, the display area DPA may have any one of a polygonal shape, a circular shape and an elliptical shape or may have a combination of straight lines and curves.

The display area DPA may include a plurality of pixels PX. The pixels PX may be arranged in a matrix direction. For example, the pixels PX may be arranged along rows and columns of a matrix. Each of the pixels PX may be rectangular or square in a plan view. However, embodiments of the present disclosure are not limited thereto, and each of the pixels PX may also have a rhombic planar shape having each side inclined with respect to a side of the display device 100.

The pixels PX may be basic units that display various colors including white and various brightness levels.

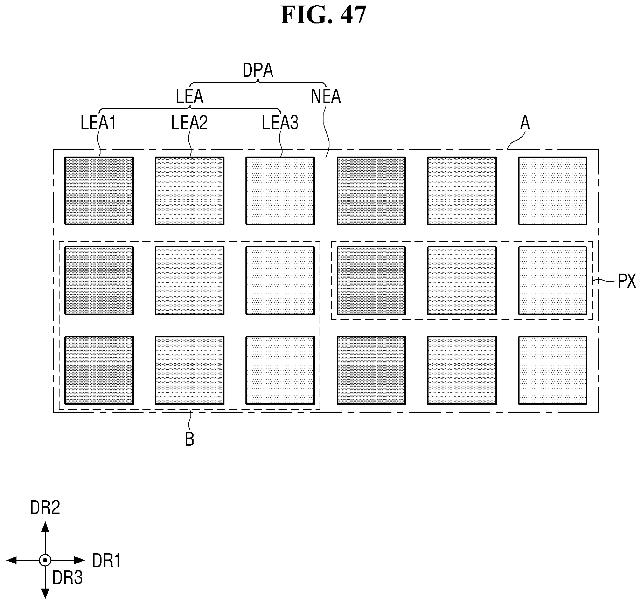

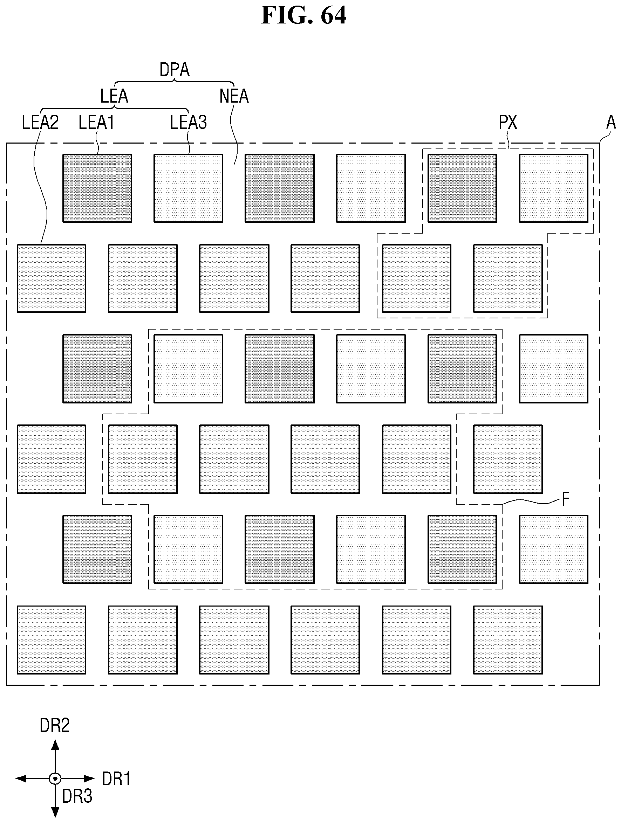

As will be described later with reference to FIGS. 47 and 64, for color display, each of the pixels PX may be composed of two or more emission areas LEA (see FIGS. 47 and 64) adjacent to each other and corresponding to different colors.

For example, two or more emission areas corresponding to each of the pixels PX may include at least one first emission area LEA1 (see FIGS. 47 and 64) corresponding to a first color, at least one second emission area LEA2 (see FIGS. 47 and 64) corresponding to a second color different from the first color, and at least one third emission area LEA3 (see FIGS. 47 and 64) corresponding to a third color different from the first color and the second color. Here, the first color, second color, and third color may be red, green, and blue, respectively.

Accordingly, each of the pixels PX may display a color and brightness corresponding to a mixture of light of the first color emitted from the first emission area LEA1, light of the second color emitted from the second emission area LEA2, and light of the third color emitted from the third emission area LEA3.

In addition, the emission areas LEA constituting the pixels PX may be arranged in the display area DPA along the first direction DR1 or the second direction DR2. Here, emission areas corresponding to the same color may be arranged side by side with each other in any one of the first direction DR1 and the second direction DR2. In addition, emission areas corresponding to different colors may be alternately arranged in a stripe type or a PENTILE^{®} type in the other one of the first direction DR1 and the second direction DR2, but the present disclosure is not limited thereto. The PENTILE^{®} arrangement structure may be referred to as an RGBG matrix structure (e.g., a PENTILE^{®} matrix structure or an RGBG structure (e.g., a PENTILEO structure)). PENTILE^{®} is a registered trademark of Samsung Display Co., Ltd., Republic of Korea. However, this is merely an example, and the arrangement form of the emission areas LEA according to one or more embodiment is not limited to those illustrated in FIGS. 47 and 64 and can be changed as desired.

The non-display area NDA may be disposed around the display area DPA along an edge or periphery of the display area DPA. The non-display area NDA may entirely or partially surround the display area DPA. For example, when the display area DPA has a quadrilateral shape, the non-display area NDA may be disposed adjacent to four sides of the display area DPA. The non-display area NDA may correspond to a bezel of the display device 100.

A driving circuit or a driving element for driving the display area DPA may be disposed in the non-display area NDA. In the described embodiment, a pad portion may be provided in the non-display area NDA adjacent to a first side (e.g., a lower side in FIG. 42) of the display device 10, and external devices EXD may be mounted on pad electrodes of the pad portion. Examples of the external devices EXD may include connection films, printed circuit boards, driving chips DIC, connectors, and/or wiring connection films. A scan driver SDR may be disposed in the non-display area NDA adjacent to a second side (e.g., a left side in FIG. 42) of the display device 100.

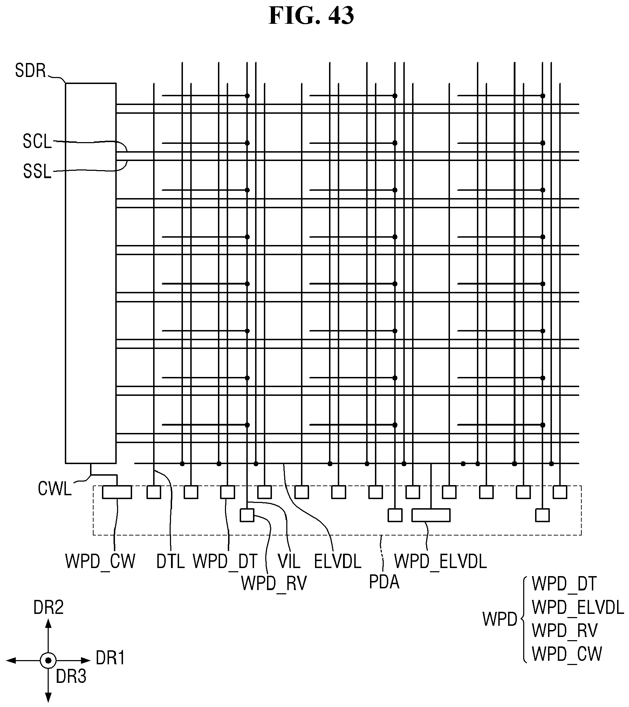

FIG. 43 is a layout view of an example of a transistor array layer TFTL in the display device 100 of FIG. 42.

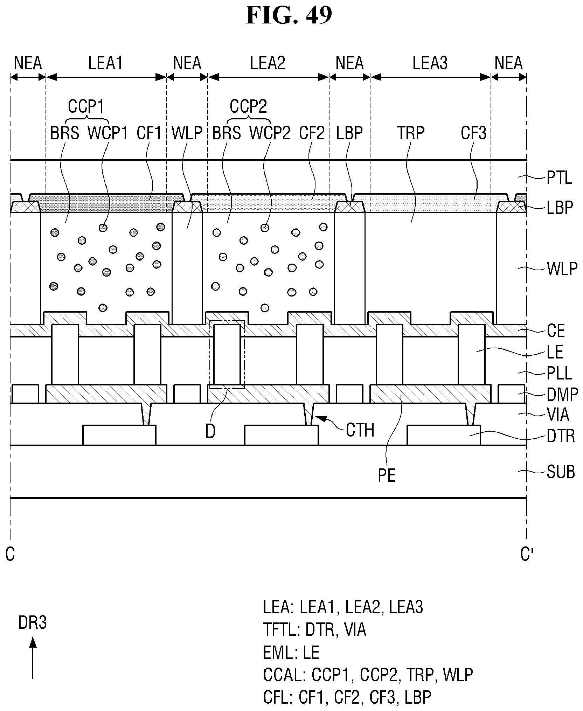

The display device 100 may include the transistor array layer TFTL (see FIG. 49) including a plurality of thin-film transistors corresponding to a plurality of emission areas LEA. The transistor array layer TFTL is designed to individually drive the emission areas LEA (see FIG. 49).

Referring to FIG. 43, the transistor array layer TFTL may include a plurality of wirings disposed in the display area DPA. Here, the wirings may include scan lines SCL, sensing signal lines SSL, data lines DTL, initialization voltage lines VIL, and a first power line ELVDL.

The scan lines SCL and the sensing signal lines SSL may extend in the first direction DR1. The scan lines SCL and the sensing signal lines SSL may be connected to the scan driver SDR.

The scan driver SDR may be disposed in a portion of the non-display area NDA adjacent to one side of the display area DPA in the first direction DR1. Alternatively, the scan driver SDR may be disposed in a portion of the non-display area NDA adjacent to both sides of the display area DPA in the first direction DR1.

The scan driver SDR may include a driving circuit corresponding to each scan line SCL and each sensing signal line SSL.

The scan driver SDR may be connected to an end of a signal connection line CWL.

The other end of the signal connection line CWL may be connected to an external device EXD (see FIG. 42) through a pad WPD_CW disposed at an edge of the non-display area NDA.

The data lines DTL and the initialization voltage lines VIL may extend in the second direction DR2 intersecting the first direction DR1.

The first power line ELVDL may include portions extending in the second direction DR2. Alternatively, the first power line ELVDL may have a mesh structure further including portions extending in the first direction DR1. The first power line ELVDL according to the described embodiment is not limited to that illustrated in FIG. 43.

Ends of the data lines DTL, the initialization voltage lines VIL, and the first power line ELVDL may be respectively connected to wiring pads WPD disposed in the non-display area NDA.

Wiring pads WPD_DT (hereinafter, referred to as `data pads') of the data lines DTL, wiring pads WPD_RV (hereinafter, referred to as `initialization voltage pads') of the initialization voltage lines VIL, and a wiring pad WPD_ELVDL of the first power line ELVDL may be disposed in a pad portion PDA that is an edge of the non-display area NDA.

The external devices EXD (see FIG. 42) may be mounted on the wiring pads WPD.

The external devices EXD may be mounted on the wiring pads WPD through anisotropic conductive films, ultrasonic bonding, or the like.

The transistor array layer TFTL may further include a plurality of pixel driving circuits respectively corresponding to a plurality of emission areas arranged in the display area DPA. The pixel driving circuits of the emission areas may be connected to the above-described wirings and may supply driving currents to light emitting elements of the emission areas, respectively.

Each of the pixel driving circuits of the emission areas may include at least one thin-film transistor and at least one capacitor. The number of transistors and capacitors included in each pixel driving circuit and their connection forms can be variously changed.

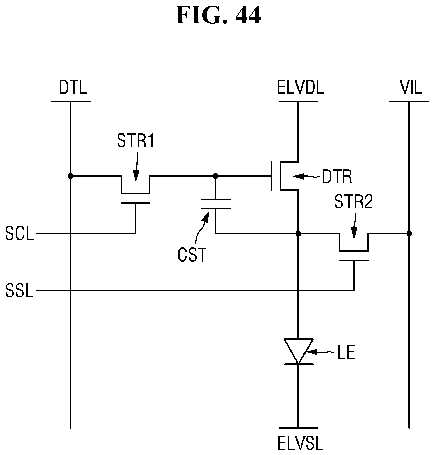

Examples of a pixel driving circuit will now be described. However, this is merely an example, and the pixel driving circuit according to the described embodiment is not limited to those illustrated in FIGS. 44, 45, and 46 and may also have other various modified structures such as a 2T1C structure, a 7T1C structure, and a 6T1C structure.

FIGS. 44, 45, and 46 are equivalent circuit diagrams of examples of an emission area in the transistor array layer TFTL of FIG. 43.

Referring to FIG. 44, a pixel driving circuit of an emission area may include a driving transistor DTR, a first transistor STR1, a second transistor STR2, and one storage capacitor CST.

The driving transistor DTR is connected in series to a light emitting element LE between a first power line ELVDL to which a first power supply voltage is supplied and a second power line ELVSL to which a second power supply voltage is supplied. The driving transistor DTR is turned on when a voltage difference between a gate electrode and a source electrode is equal to or greater than a threshold voltage and supplies a driving current corresponding to the voltage difference between the gate electrode and the source electrode to the light emitting element LE.

The driving transistor DTR may have the gate electrode connected to the first transistor STR1, the source electrode connected to the light emitting element LE, and a drain electrode connected to the first power line ELVDL. Alternatively, depending on the structure of the driving transistor DTR, the drain electrode of the driving transistor DTR may be connected to the light emitting element LE, and the source electrode may be connected to the first power line ELVDL.

The first transistor STR1 is connected between a data line DTL and the driving transistor DTR. A gate electrode of the first transistor STR1 is connected to a scan line SCL. The first transistor STR1 is turned on based on a scan signal of the scan line SCL and supplies a data signal of the data line DTL to the gate electrode of the driving transistor DTR.

An end of the storage capacitor CST may be connected to a node between the driving transistor DTR and the first transistor STR1 (at the gate electrode of the driving transistor DTR), and the other end may be connected to a node between the driving transistor DTR and the light emitting element LE (at the source electrode of the driving transistor DTR). The storage capacitor CST may be charged with the data signal supplied through the turned-on first transistor STR1. That is, the storage capacitor CST may retain a difference voltage between the gate electrode and the source electrode of the driving transistor DTR.

The second transistor STR2 is connected between the driving transistor DTR (e.g., the source electrode of the driving transistor DTR) and an initialization voltage line VIL. A gate electrode of the second transistor STR2 is connected to a sensing signal line SSL. The second transistor STR2 may be turned on based on a sensing signal of the sensing signal line SSL and may initialize the potential of the node between the driving transistor DTR and the light emitting element LE to an initialization voltage of the initialization voltage line VIL.

The driving transistor DTR, the first transistor STR1, and the second transistor STR2 may be provided as thin-film transistors. Although the driving transistor DTR, the first transistor STR1 and the second transistor STR2 are all N-type metal oxide semiconductor field effect transistors (MOSFETs) in FIG. 44, one or more embodiments are not limited to the illustration of FIG. 44. That is, at least some of the driving transistor DTR, the first transistor STR1, and the second transistor STR2 may also be P-type MOSFETs.

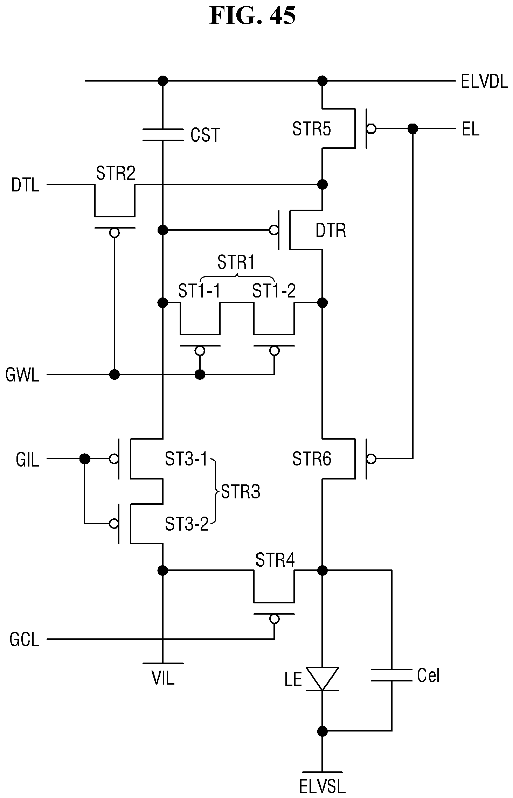

Referring to FIG. 45, a pixel driving circuit of an emission area according to an example may include a driving transistor DTR, first through sixth transistors STR1 through STR6, and a storage capacitor CST.

The driving transistor DTR is connected in series to a light emitting element LE between a first power line ELVDL and a second power line ELVSL.

That is, a first electrode (e.g., a source electrode) of the driving transistor DTR may correspond to the first power line ELVDL, and a second electrode (e.g., a drain electrode) of the driving transistor DTR may correspond to a first electrode (e.g., an anode) of the light emitting element LE.

A second electrode (e.g., a cathode) of the light emitting element LE may be connected to the second power line ELVSL.

A parasitic capacitance Cel may be formed at both ends of the light emitting element LE.

The storage capacitor CST may be connected between a gate electrode of the driving transistor DTR and the first power line ELVDL.

The first transistor STR1 (including transistors ST1-1 and ST1-2 connected in series) may be connected between the gate electrode of the driving transistor DTR and the second electrode (e.g., the drain electrode) of the driving transistor DTR. When the first transistor STR1 is turned on based on a gate signal of a write scan line GWL, the gate electrode of the driving transistor DTR and the second electrode of the driving transistor DTR may be changed to the same potential (e.g., the driving transistor DTR may be diodeconnected).

The second transistor STR2 may be connected between a data line DTL and the first electrode (e.g., the source electrode) of the driving transistor DTR. When the second transistor STR2 is turned on based on the gate signal of the write scan line GWL, a data signal of the data line DTL may be transmitted to the first electrode of the driving transistor DTR.

Here, when a voltage difference between the gate electrode of the driving transistor DTR and the first electrode of the driving transistor DTR is equal to or greater than a threshold voltage, the driving transistor DTR is turned on, and a driving current corresponding to the voltage difference between the gate electrode and the source electrode is generated.

The third transistor STR3 (including transistors ST3-1 and ST3-2 connected in series) may be connected between the gate electrode of the driving transistor DTR and an initialization voltage line VIL. When the third transistor STR3 is turned on by a gate signal of an initialization scan line GIL, the potential of the gate electrode of the driving transistor DTR may be initialized to the voltage of the initialization voltage line VIL.

The fourth transistor STR4 may be connected between the first electrode (e.g., the anode) of the light emitting element LE and the initialization voltage line VIL. When the fourth transistor STR4 is turned on by a gate signal of a control scan line GCL, the potential of the first electrode (e.g., the anode) of the light emitting element LE may be initialized to the voltage of the initialization voltage line VIL.

The fifth transistor STR5 may be connected between the first power line ELVDL and the driving transistor DTR.

The sixth transistor STR6 may be connected between the driving transistor DTR and the light emitting element LE.

When the fifth transistor STR5 and the sixth transistor STR6 are turned on by a gate signal of an emission line EL, a driving current generated by the driving transistor DTR may be supplied to the light emitting element LE.

An active layer of each of the first through sixth transistors STR1 through STR6 and the driving transistor DTR may be made of one or more selected from among polysilicon, amorphous silicon, and/or an oxide semiconductor. For example, a semiconductor layer of each of the first through sixth transistors STR1 through STR6 and the driving transistor DTR may be made of polysilicon by a low-temperature polysilicon (LTPS) process.

Although the first through sixth transistors STR1 through STR6 and the driving transistor DTR are formed as P-type MOSFETs in FIG. 45, one or more embodiments are not limited to the illustration of FIG. 45, and at least some of the first through sixth transistors STR1 through STR6 and the driving transistor DTR may also be formed as N-type MOSFETs.

A first power supply voltage of the first power line ELVDL, a second power supply voltage of the second power line ELVSL, and an initialization voltage of the initialization voltage line VIL may be set in consideration of the characteristics of the driving transistor DTR and the characteristics of the light emitting element LE.

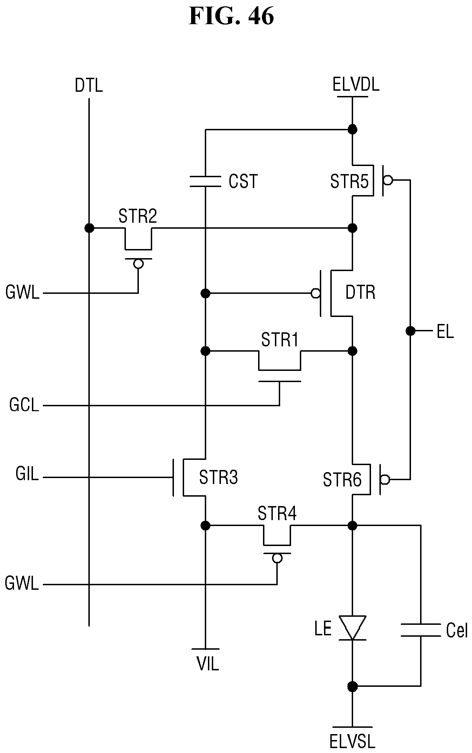

Referring to FIG. 46, a pixel driving circuit of an emission area according to an example is the same as the pixel driving circuit illustrated in FIG. 45 except that a first transistor STR1 and a third transistor STR3 are formed as N-type MOSFETs. Therefore, any redundant description will be omitted below.

Referring to FIG. 46, a driving transistor DTR, a second transistor STR2, a fourth transistor STR4, a fifth transistor STR5, and a sixth transistor STR6 are formed as P-type MOSFETs. An active layer of each of the driving transistor DTR, the second transistor STR2, the fourth transistor STR4, the fifth transistor STR5, and the sixth transistor STR6 may be made of polysilicon.

An active layer of each of the first transistor STR1 and the third transistor STR3 formed as N-type MOSFETs may be made of an oxide semiconductor.

In addition, a gate electrode of the first transistor STR1 formed as an N-type MOSFET may be connected to a control scan line GCL, not to a write scan line GWL. That is, the first transistor STR1 may be turned on by a gate signal of the control scan line GCL.

The write scan line GWL may instead be connected to a gate electrode of the fourth transistor STR4 formed as a P-type MOSFET.

Here, the gate signal of the control scan line GCL and a gate signal of an initialization scan line GIL may be gate-high voltages for turning on an N-type MOSFET.

On the other hand, a gate signal of a write scan line GWL and a gate signal of an emission line EL may be gate-low voltages for turning on a P-type MOSFET.

The pixel driving circuit according to the described embodiment is not limited to the illustration of FIGS. 44 through 46 and may also be formed in other known circuit structures that those skilled in the art can employ in addition to the structures illustrated in FIGS. 44 through 46.

FIG. 47 is a layout view illustrating an example of a plurality of emission areas LEA corresponding to a portion A of FIG. 42.

Referring to FIG. 47, the display device 100 according to the described embodiment includes a plurality of emission areas LEA arranged in the display area DPA.

Each of the emission areas LEA may be a basic unit that displays a specific color with a desired brightness (e.g., a predetermined brightness) to display an image.

The emission areas LEA include the first emission areas LEA1 emitting light of the first color, the second emission areas LEA2 emitting light of the second color, and the third emission areas LEA3 emitting light of the third color.

Here, the first, second, and third colors may correspond to different main peak wavelengths.

For example, the second color may correspond to a main peak wavelength lower than that of the first color, and the third color may correspond to a main peak wavelength lower than that of the second color. In this case, the first color may be red corresponding to a wavelength band of about 600 to 750 nm, the second color may be green corresponding to a wavelength band of about 480 to 560 nm, and the third color may be blue corresponding to a wavelength band of about 370 to 460 nm.

According to the described embodiment, the first emission areas LEA1, the second emission areas LEA2, and the third emission areas LEA3 may be arranged side by side along the second direction DR2. In addition, the first emission areas LEA1, the second emission areas LEA2, and the third emission areas LEA3 may be alternately arranged along the first direction DR1.

In this case, each of a plurality of pixels PX may be composed of a combination of one first emission area LEA1, one second emission area LEA2, and one third emission area LEA3 adjacent to each other in the first direction DR1. However, this is merely an example, and the configuration of each pixel PX according to the described embodiment is not limited to that illustrated in FIG. 47 and can be changed as desired.

The emission areas LEA are spaced from each other in the first direction DR1 and the second direction DR2, and an area NEA between the emission areas LEA is a non-emission area that does not emit light in the display area DPA.

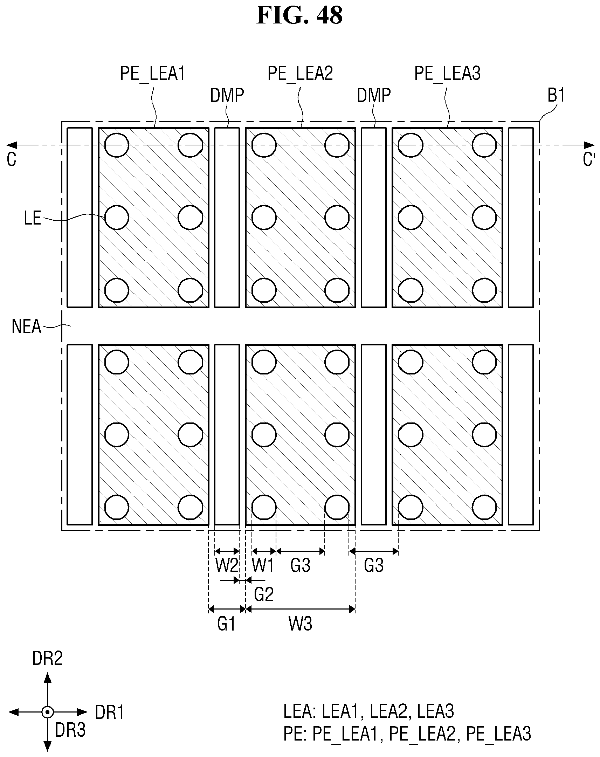

FIG. 48 is a plan view illustrating an example of pixel electrodes PE and dummy patterns DMP corresponding to a portion B of FIG. 47.

Referring to FIG. 48, the display device 100 according to the described embodiment includes a plurality of pixel electrodes PE respectively corresponding to the emission areas LEA, a plurality of dummy patterns DMP corresponding to the non-emission area NEA between the emission areas LEA, and a light emitting element array layer including a plurality of light emitting elements LE corresponding to the emission areas LEA.

The pixel electrodes PE correspond to the emission areas LEA, respectively. Like the emission areas LEA, the pixel electrodes PE may be spaced from each other in each of the first direction DR1 and the second direction DR2.

For example, the pixel electrodes PE may be spaced from each other by a distance G1 (e.g., a predetermined distance G1, hereinafter, referred to as a "first distance") in the first direction DR1.

According to a first example B1 of FIG. 48, the dummy patterns DMP are disposed in the non-emission area NEA between the pixel electrodes PE corresponding to the emission areas LEA. The dummy patterns DMP are spaced from the pixel electrodes PE. That is, the dummy patterns DMP are formed as island-shaped patterns.

For example, one or more dummy patterns DMP may be disposed between every two pixel electrodes PE neighboring each other in at least one (e.g., the first direction DR1) of the first direction DR1 and the second direction DR2.

That is, as illustrated in FIG. 48, when a first emission area LEA1, a second emission areas LEA2, and a third emission areas LEA3 are alternately arranged side by side along the first direction DR1, one dummy pattern DMP may be disposed between a pixel electrode PE_LEA1 of the first emission area LEA1 and a pixel electrode PE_LEA2 of the second emission area LEA2, one dummy pattern DMP may be disposed between the pixel electrode PE_LEA2 of the second emission area LEA2 and a pixel electrode PE_LEA3 of the third emission area LEA3, and one dummy pattern DMP may be disposed between the pixel electrode PE_LEA3 of the third emission area LEA3 and the pixel electrode PE_LEA1 of the first emission area LEA1.

Here, the dummy patterns DMP are disposed alternately and side by side with the pixel electrodes PE in the first direction DR1. A width of each dummy pattern DMP in the second direction DR2 may be in the same range as a width of each pixel electrode PE in the second direction DR2.

The light emitting elements LE are disposed on the pixel electrodes PE respectively corresponding to the emission areas LEA and are spaced from each other in the first direction DR1 and the second direction DR2.

The light emitting elements LE may be spaced from each other by a distance G3 (hereinafter, referred to as a "third distance") within the same range in at least one of the first direction DR1 and the second direction DR2. Here, the same range may refer to ranges including margins that can be regarded as the same. For example, the same range may include a margin within ±15%. However, this is merely an example, and the definition of the same range can be changed according to the size and resolution of the display device 100.

The sum of the third distance G3 between the light emitting elements LE in the first direction DR1 and a width W1 (hereinafter, referred to as a "first width") of each light emitting element LE in the first direction DR1 is smaller than a width W3 (hereinafter, referred to as a "third width") of each pixel electrode PE in the first direction DR1.

Accordingly, at least one light emitting element LE may be disposed on each of the pixel electrodes PE.

In other words, each of the emission areas LEA may correspond to two or more light emitting elements LE.

That is, two or more light emitting elements LE neighboring each other in the first direction DR1 or the second direction DR2 may be disposed on each of the pixel electrodes PE corresponding to the emission areas LEA.

To this end, the width of each of the pixel electrodes PE in the first direction DR1 may be greater than the sum of at least one time the first width W1 of each light emitting element LE and at least one time the third distance G3 between the light emitting elements LE in the first direction DR1.

The width of each of the pixel electrodes PE, the width of each light emitting element LE, and the distance between the light emitting elements LE may be maintained in the same range in the first direction DR1 or the second direction DR2.

In this case, the same number of light emitting elements LE can be disposed on each of the pixel electrodes PE even in a process of concurrently (e.g., simultaneously) placing the light emitting elements LE on the pixel electrodes PE.

Here, the number of light emitting elements LE disposed on each of the pixel electrodes PE may correspond to the width of the pixel electrode PE, the width of each light emitting element LE, and the distance between the light emitting elements LE. The number of light emitting elements LE disposed on each of the pixel electrodes PE is not limited to that illustrated in FIG. 48 and can be changed based on the width of each pixel electrode PE, the width of each light emitting element LE, and the distance between the light emitting elements LE.

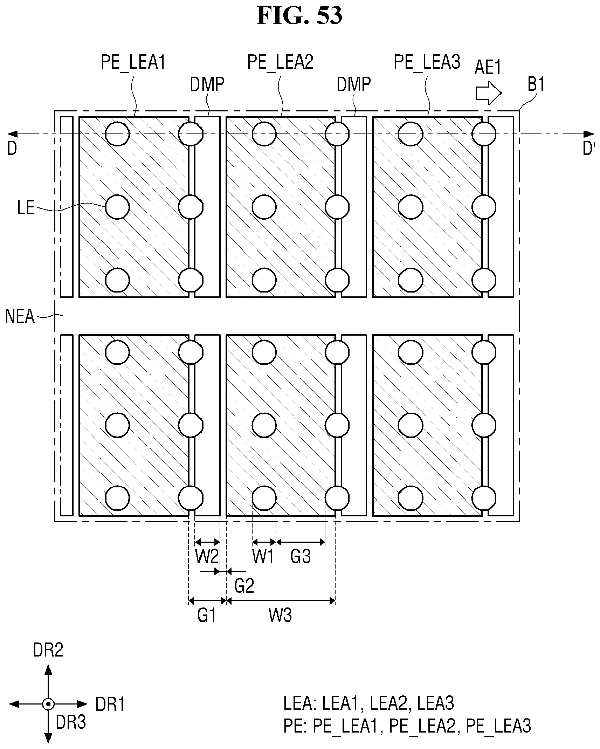

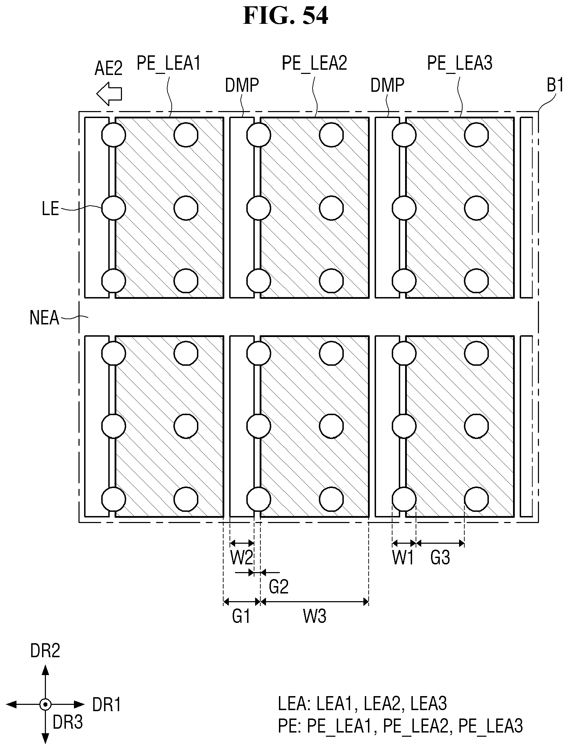

In one or more embodiments, the light emitting elements LE are not individually placed one by one, but are placed all at once. As a result, some of the light emitting elements LE may be partially disposed in the non-emission area NEA. That is, as illustrated in FIGS. 53 and 54 to be described later, due to a process error, some of the light emitting elements LE may be partially disposed on each pixel electrode PE and the non-emission area NEA or may be disposed in the non-emission area NEA.

Here, if a light emitting element LE disposed in the non-emission area NEA between any two pixel electrodes PE is partially disposed on both of the two pixel electrodes PE, a display defect in which the light emitting element LE is driven by at least one of the two pixel electrodes PE may occur.

To prevent this, the first distance G1 between the pixel electrodes PE neighboring each other in the first direction DR1 may be selected within a range greater than the first width W1 of each light emitting element LE in the first direction DR1 (i.e., G1 > W1).

In this case, some of the light emitting elements LE that are partially disposed in the non-emission area NEA due to an alignment error in the first direction DR1 may be connected to only one pixel electrode PE and thus may be driven only by a driving current supplied through the one pixel electrode PE.

In addition, the display device 100 according to the described embodiment includes a plurality of dummy patterns DMP disposed in the area NEA between the emission areas LEA.

Accordingly, some of the light emitting elements LE that are partially disposed in the non-emission area NEA due to an alignment error may be supported by the dummy patterns DMP disposed in the non-emission area NEA. Therefore, it is possible to prevent a tilting defect in which a light emitting element LE disposed on an edge of a pixel electrode PE due to an alignment error in the first direction DR1 is tilted by a step of the pixel electrode PE.

That is, even if there are light emitting elements LE protruding to the non-emission area NEA as a result of placing the light emitting elements LE all at once, tilting defects of these light emitting elements LE can be prevented by the dummy patterns DMP.

As illustrated in FIG. 48, when a dummy pattern DMP is disposed between the pixel electrodes PE neighboring each other in the first direction DR1, a pixel electrode PE of an emission area LEA and the dummy pattern DMP neighboring the emission area LEA may be spaced from each other by a distance G2 (e.g., a predetermined distance G2, hereinafter, referred to as a "second distance") in the first direction DR1.

Assuming that a tilting defect of a light emitting element LE occurs when the light emitting element LE protrudes into the non-emission area NEA by a distance greater than a threshold value, the second distance G2 between the pixel electrode PE and the dummy pattern DMP may be set to be equal to or less than the threshold value of the tilting defect.

For example, if more than half of the light emitting element LE is disposed in the non-emission area NEA, the center of gravity of the light emitting element LE may not be supported by the pixel electrode PE, causing the tilting defect of the light emitting element LE. Hence, the threshold value of the tilting defect may be half the width (i.e., the first width W1) of the light emitting element LE in the first direction DR1.

Accordingly, the second distance G2 between the pixel electrode PE and the dummy pattern DMP neighboring each other may be selected within a range exceeding 0 and smaller than half the first width W1 of the light emitting element LE (i.e., 0 < G2 ≤ (W1)/2).

In this case, the tilting defect of the light emitting element LE partially disposed in the non-emission area NEA can be prevented by the dummy pattern DMP.

Each dummy pattern DMP may have a predetermined width W2 (hereinafter, referred to as a "second width") in the first direction DR1.

When each dummy pattern DMP is spaced from two neighboring pixel electrodes PE on both sides in the first direction DR1 by the same second distance G2, the sum (W2+2*G2) of the second width W2 of the dummy pattern DMP and twice (2*G2) the second distance G2 may correspond to the first distance G1 between the two neighboring pixel electrodes PE in the first direction DR1 (i.e., (W2+2*G2) ≒ G1).

In addition, the sum of the second width W2 and the second distance G2 may be selected within a range greater than half the first width W1 (i.e., W2 + G2 > (W1)/2, W2 > (W1)/2 - G2).

In this case, of a light emitting element LE protruding into the non-emission area NEA, a portion protruding farthest from an edge of a pixel electrode PE may be supported by a dummy pattern DMP. That is, one side of the light emitting element LE protruding into the non-emission area NEA in the first direction DR1 may be supported by the pixel electrode PE, and the other side in the first direction DR1 may be supported by the dummy pattern DMP. Accordingly, the reliability of the dummy pattern DMP for preventing a tilting defect of the light emitting element LE can be improved.

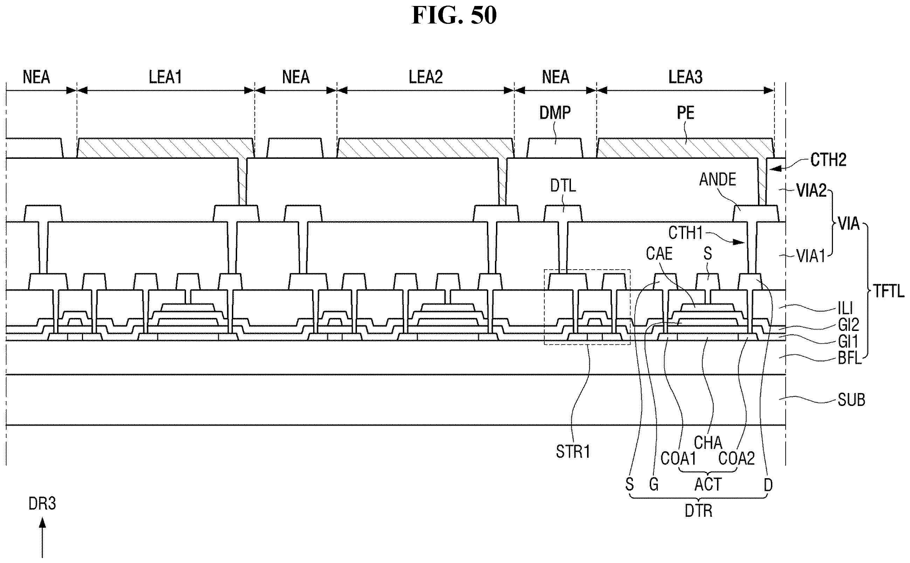

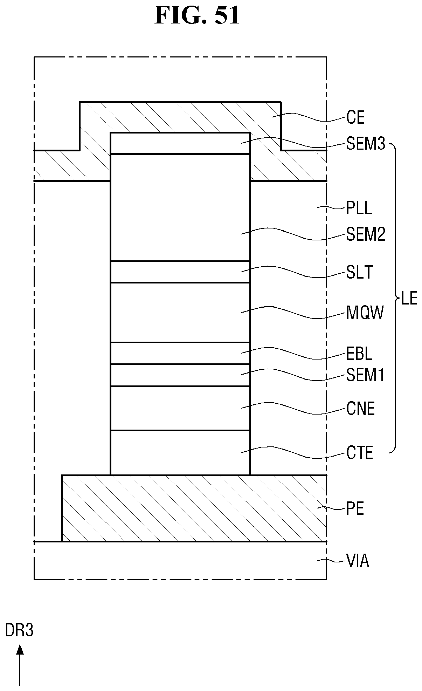

FIG. 49 is a cross-sectional view taken along the line C-C' of FIG. 48. FIG. 50 is a cross-sectional view of an example of the transistor array layer TFTL of FIG. 49. FIG. 51 is a detailed cross-sectional view of a portion D of FIG. 49.

Referring to FIG. 49, the display device 100 according to the described embodiment includes a substrate SUB including the display area DPA (see FIG. 42) in which a plurality of emission areas LEA are arranged, a plurality of pixel electrodes PE disposed on the substrate SUB and respectively corresponding to the emission areas LEA, a plurality of dummy patterns DMP disposed on the substrate SUB and corresponding to the non-emission area NEA between the emission areas LEA, a light emitting element array layer EML including a plurality of light emitting elements LE corresponding to the emission areas LEA, a planarization layer PLL disposed between the light emitting elements LE and covering the pixel electrodes PE and the dummy patterns DMP, and a common electrode CE disposed on the light emitting element array layer EML and the planarization layer PLL and corresponding to the emission areas LEA.

The substrate SUB may be a rigid substrate made of a glass material. Alternatively, the substrate SUB may be a flexible substrate that can be bent, folded, or rolled. In this case, the substrate SUB may include an insulating material such as polymer resin (e.g., polyimide (PI)).

The display device 100 may further include the transistor array layer TFTL disposed on the substrate SUB.

The transistor array layer TFTL may include a plurality of thin-film transistors DTR and STR1 corresponding to the emission areas LEA and a via layer VIA covering the thin-film transistors DTR and STR1.

The pixel electrodes PE and the dummy patterns DMP may be disposed on the via layer VIA.

The pixel electrodes PE may be respectively connected to a plurality of pixel drivers of the transistor array layer TFTL through contact holes CTH penetrating the via layer VIA. For example, as illustrated in FIG. 49, the pixel electrodes PE may be connected to a plurality of driving transistors DTR, respectively.

Referring to FIG. 50, the transistor array layer TFTL may include a buffer layer BFL disposed on the substrate SUB, a first gate insulating layer GI1 covering active layers ACT on the buffer layer BFL, a second gate insulating layer GI2 covering gate electrodes G on the first gate insulating layer GI1, an interlayer insulating layer ILI covering capacitor electrodes CAE on the second gate insulating layer GI2, a first via layer VIA1 covering source electrodes S and drain electrodes D on the interlayer insulating layer ILI, and a second via layer VIA2 covering anode connection electrodes ANDE on the first via layer VIA1.

The transistor array layer TFTL of FIG. 50 may correspond to the pixel driving circuit of FIG. 44.

That is, FIGS. 44 and 50 illustrate a driving transistor DTR connected to a light emitting element LE and a first transistor STR1 connected to a data line DTL in each pixel driving circuit. The first transistor STR1 has substantially the same structure as the driving transistor DTR. Therefore, unless particularly mentioned, the driving transistor DTR will be mainly described below, and a redundant description of the first transistor STR1 will be omitted.

The buffer layer BFL is designed to prevent penetration of moisture or oxygen through the substrate SUB. The buffer layer BFL may be a single layer or a multilayer made of an inorganic insulating material such as silicon nitride, silicon oxide, or silicon oxynitride.

The active layer ACT corresponds to a channel of each thin-film transistor provided in each pixel driving circuit. The active layer ACT may be made of a semiconductor material. For example, the active layer ACT may be made of a semiconductor material selected from among amorphous silicon, polycrystalline silicon, and/or an oxide semiconductor. Here, the oxide semiconductor may include a binary compound (ABx), a ternary compound (ABxCy) or a quaternary compound (ABxCyDz) containing indium, zinc, gallium, tin, titanium, aluminum, hafnium (Hf), zirconium (Zr), magnesium (Mg), etc. For example, the active layer ACT may include indium tin zinc oxide (IGZO).

The active layer ACT includes a channel region CHA where a carrier movement path is generated according to the potential of the gate electrode and first and second conductive regions COA1 and COA2 disposed on both sides of the channel region CHA.

When the active layer ACT is made of an oxide semiconductor, the first and second conductive regions COA1 and COA2 may be regions made conductive by being exposed to ions or the like.

Each of the first gate insulating layer GI1 and the second gate insulating layer GI2 may include one or more selected from among silicon oxide, silicon nitride, silicon oxynitride, aluminum oxide, tantalum oxide, hafnium oxide, zirconium oxide, titanium oxide, and/or the like.

The gate electrodes G on the first gate insulating layer GI1 overlap the channel regions CHA of the active layers ACT in the third direction DR3.

The gate electrodes G may include a metal oxide such as ITO, IZO, ITZO and/or In₂O₃ or may include a metal selected from among copper (Cu), titanium (Ti), aluminum (Al), molybdenum (Mo), tantalum (Ta), calcium (Ca), chromium (Cr), magnesium (Mg), and/or nickel (Ni).

The capacitor electrodes CAE on the second gate insulating layer GI2 may at least partially overlap the gate electrodes G of the driving transistors DTR in the third direction DR3. In addition, the capacitor electrodes CAE may be connected to the source electrodes S on the interlayer insulating layer ILI through holes penetrating the interlayer insulating layer ILI.

Therefore, a storage capacitor CST (see FIG. 44) disposed between the gate electrode G and the source electrode S of each driving transistor DTR may be provided by an overlap area between the gate electrode G and a capacitor electrode CAE.

The interlayer insulating layer ILI may include an inorganic insulating material including one or more selected from among silicon oxide, silicon nitride, silicon oxynitride, hafnium oxide, aluminum oxide, titanium oxide, tantalum oxide, and/or zinc oxide.

The source electrodes S on the interlayer insulating layer ILI may be connected to the first conductive regions COA1 of the active layers ACT through holes penetrating the interlayer insulating layer ILI, the second gate insulating layer GI2, and the first gate insulating layer GI1.

The drain electrodes D on the interlayer insulating layer ILI may be connected to the second conductive regions COA2 of the active layers ACT through holes penetrating the interlayer insulating layer ILI, the second gate insulating layer GI2, and the first gate insulating layer GI1.

Each of the source electrodes S and the drain electrodes D may include a single layer or a multilayer made of a metal oxide including one or more selected from among ITO, IZO, ITZO, and/or In₂O₃ or may include a metal such as copper (Cu), titanium (Ti), aluminum (Al), molybdenum (Mo), tantalum (Ta), calcium (Ca), chromium (Cr), magnesium (Mg), and/or nickel (Ni).

The via layer VIA covering the thin-film transistors DTR and STR1 may include the first via layer VIA1 covering the source electrodes S and the drain electrodes D on the interlayer insulating layer ILI and the second via layer VIA2 covering the anode connection electrodes ANDE on the first via layer VIA1.

The data lines DTL may be disposed on the first via layer VIA1 and may be connected to the first transistors STR1 through holes penetrating the first via layer VIA1.

The anode connection electrodes ANDE may be connected to the drain electrodes D of the driving transistors DTR through first contact holes CTH1 penetrating the first via layer VIA1.

Each of the first via layer VIA1 and the second via layer VIA2 may include an organic insulating material including one or more selected from among acrylic resin, epoxy resin, imide resin, and/or ester resin.

Each of the anode connection electrodes ANDE and the data lines DTL may include a single layer or a multilayer made of a metal oxide selected from among ITO, IZO, ITZO, and/or In₂O₃ or may include a metal selected from among copper (Cu), titanium (Ti), aluminum (Al), molybdenum (Mo), tantalum (Ta), calcium (Ca), chromium (Cr), magnesium (Mg), and/or nickel (Ni).

Each of the pixel electrodes PE may have a stacked structure in which a material layer having a high work function such as titanium oxide (TiO₂), indium tin oxide (ITO), indium zinc oxide (IZO), zinc oxide (ZnO), indium tin zinc oxide (ITZO) or magnesium oxide (MgO) and a reflective material layer such as silver (Ag), magnesium (Mg), aluminum (Al), platinum (Pt), lead (Pd), gold (Au), nickel (Ni), neodymium (Nd), iridium (Ir), chromium (Cr), lithium (Li), calcium (Ca), and/or a mixture thereof are stacked.

The pixel electrodes PE may be connected to the anode connection electrodes ANDE through second contact holes CTH2 penetrating the second via layer VIA2.

The dummy patterns DMP are designed to prevent tilting defects of the light emitting elements LE due to a step of the pixel electrodes PE. Therefore, in order to prevent tilting of light emitting elements LE partially disposed on the dummy patterns DMP and the pixel electrodes PE, the dummy patterns DMP may have a thickness in the same range as that of the pixel electrodes PE so that they are disposed parallel to the pixel electrodes PE.

The dummy patterns DMP may be made of the same material as the pixel electrodes PE. In this case, the dummy patterns DMP may maintain a floating state so as not to cause unnecessary electrical signals. That is, the dummy patterns DMP may be in a floating state in which they are not electrically connected to the pixel electrodes PE and may be shaped like islands spaced from the pixel electrodes PE.

Alternatively, the dummy patterns DMP may be made of an insulating material having a thickness in the same range as that of the pixel electrodes PE. In this case, the dummy patterns DMP may be made of an inorganic insulating material in order to prevent the via layer VIA from being damaged by a patterning process for placing the dummy patterns DMP.

As illustrated in FIG. 49, the light emitting element array layer EML including a plurality of light emitting elements LE is disposed on the pixel electrodes PE.

Alternatively, as illustrated in FIGS. 53, 54, and 55, some of the light emitting elements LE may be partially disposed on the dummy patterns DMP of the non-emission area NEA due to an alignment error of the light emitting element array layer EML.

Referring to FIG. 51, each of the light emitting elements LE may be a vertical light emitting diode element connected between a pixel electrode PE and the common electrode CE facing each other in the third direction DR3.

In addition, each of the light emitting elements LE may be a micro-light emitting diode element. For example, a length of each light emitting element LE in the third direction DR3 may be about 1 to 5 *µ*m.

Each of the light emitting elements LE may be shaped like a pillar having a width in the first and second directions DR1 and DR2 smaller than a length in the third direction DR3. For example, each of the light emitting elements LE may be shaped like a cylinder, a disk, or a rod. However, the shape of each of the light emitting elements LE is not limited thereto and may also be modified to various shapes including shapes such as a rod, a wire and/or a tube, polygonal prisms such as a cube, a rectangular parallelepiped and a hexagonal prism, and a shape extending in a direction and having a partially inclined outer surface.

Each of the light emitting elements LE may include a first semiconductor layer SEM1 and a second semiconductor layer SEM2 doped with dopants of different conductivity types and an active layer MQW interposed between the first semiconductor layer SEM1 and the second semiconductor layer SEM2. In each of the light emitting elements LE, electron-hole pairs may be generated in the active layer MQW by holes and electrons transferred through the first semiconductor layer SEM1 and the second semiconductor layer SEM2, and photons may be generated by the electron-hole pairs.

Each of the light emitting elements LE may include a connection electrode CNE, the first semiconductor layer SEM1, an electron blocking layer EBL, the active layer MQW, a superlattice layer SLT, the second semiconductor layer SEM2, and a third semiconductor layer SEM3 sequentially disposed in the third direction DR3.

The first semiconductor layer SEM1 may be connected to the pixel electrode PE through the connection electrode CNE and a contact electrode CTE, and the second semiconductor layer SEM2 may be connected to the common electrode CE through the third semiconductor layer SEM3. Therefore, electrons and holes generated by a driving current between the pixel electrode PE and the common electrode CE may be transferred to the first semiconductor layer SEM1 and the second semiconductor layer SEM2.

Each of the light emitting elements LE may further include the contact electrode CTE disposed between the connection electrode CNE and the pixel electrode PE.

The contact electrode CTE is designed to improve adhesion characteristics and/or interface characteristics between the connection electrode CNE and the pixel electrode PE.

Although not illustrated in detail, the contact electrode CTE may have a multilayer structure of conductive materials. For example, the contact electrode CTE may include a first contact layer contacting the pixel electrode PE and a second contact layer contacting the connection electrode CNE.

For example, when an uppermost portion of the pixel electrode PE is made of ITO, the first contact layer may include titanium (Ti). However, this is merely an example, and the first contact layer may be any metal material having excellent adhesion to the pixel electrode PE.

The second contact layer may be made of a metal material having excellent adhesion to the connection electrode CNE. For example, when the connection electrode CNE is an alloy of copper, silver and tin (SAC305), the second contact layer may include copper (Cu) or gold (Au).

The connection electrode CNE may include a connection layer contacting the contact electrode CTE and a reflective layer contacting the first semiconductor layer SEM1.

The connection layer is designed to reduce resistance between the pixel electrode PE and the first semiconductor layer SEM1 and may be an ohmic connection electrode or a Schottky connection electrode. The connection layer may include at least one selected from among gold (Au), copper (Cu), tin (Sn), silver (Ag), aluminum (Al), and/or titanium (Ti). For example, the connection layer may include a 9:1, 8:2 or 7:3 alloy of gold to tin or may include an alloy of copper, silver and tin (SAC305).

The reflective layer is designed to reflect light from the active layer MQW toward the second semiconductor layer SEM2. The reflective layer may include aluminum (Al) or silver (Ag) or may be an alloy thereof. Alternatively, the reflective layer may further include ITO.

The first semiconductor layer SEM1 on the connection electrode CNE may include a semiconductor material having a chemical formula of AlₓGa_{y}In_{1-x-y}N (0≤x≤1, 0≤y≤1, 0≤x+y≤1) and may be a p-type semiconductor doped with a p-type dopant.

For example, the first semiconductor layer SEM1 may be made of a p-type doped AIGalnN, GaN, AlGaN, InGaN, AIN, and/or InN.

The p-type dopant of the first semiconductor layer SEM1 may be selected from among Mg, Zn, Ca, Se, Ba, and/or the like.

For example, the first semiconductor layer SEM1 may be p-GaN doped with Mg.

A thickness of the first semiconductor layer SEM1 may be in the range of, but not limited to, 30 to 200 nm.

The electron blocking layer EBL on the first semiconductor layer SEM1 is designed to suppress or prevent too many electrons from flowing into the active layer MQW and may also be omitted depending on the characteristics of the first semiconductor layer SEM1 and the active layer MQW.

The electron blocking layer EBL may be p-AlGaN doped with Mg.

A thickness of the electron blocking layer EBL may be in the range of, but not limited to, 10 to 50 nm.

The active layer MQW may be disposed on the electron blocking layer EBL. The active layer MQW may emit light through combination of electron-hole pairs according to electrical signals received through the first semiconductor layer SEM1 and the second semiconductor layer SEM2.

The active layer MQW may emit light of a first color having a central wavelength band of 450 to 495 nm, that is, light of a blue wavelength band. Alternatively, the active layer MQW may emit light having a central wavelength band of 400 to 420 nm, that is, light in an ultraviolet band.

The active layer MQW may include a material having a single or multiple quantum well structure. When the active layer MQW includes a material having a multiple quantum well structure, it may have a structure in which a plurality of well layers and a plurality of barrier layers are alternately stacked. Here, the well layers may be made of InGaN, and the barrier layers may be made of GaN and/or AlGaN, but embodiments of the present disclosure are not limited thereto. The well layers may have a thickness of about 1 to 4 nm, and the barrier layers may have a thickness of 3 to 10 nm.

Alternatively, the active layer MQW may have a structure in which a semiconductor material having a large band gap energy and a semiconductor material having a small band gap energy are alternately stacked or may include different Group III to V semiconductor materials depending on the wavelength band of light that it emits.

A wavelength band of light emitted from the active layer MQW may correspond to a component ratio of the active layer MQW.

For example, when some of the semiconductor materials of the active layer MQW include indium, the color of light emitted may vary according to the content of indium. For example, if the content of indium is about 15%, light in the blue wavelength band may be emitted. If the content of indium is about 25%, light in a green wavelength band may be emitted. If the indium content is about 35% or more, light in a red wavelength band may be emitted.

The superlattice layer SLT on the active layer MQW is designed to relieve stress between the second semiconductor layer SEM2 and the active layer MQW. The superlattice layer SLT may be omitted depending on the interface characteristics of the second semiconductor layer SEM2 and the active layer MQW.

For example, the superlattice layer SLT may be made of InGaN and/or GaN. A thickness of the superlattice layer SLT may be about 50 to 200 nm.

The second semiconductor layer SEM2 on the superlattice layer SLT may include a semiconductor material having a chemical formula of AlₓGa_{y}In_{1-x-y}N (0≤x≤1, 0≤y≤1, 0≤x+y≤1) and may be an n-type semiconductor doped with an n-type dopant.

For example, the second semiconductor layer SEM2 may be made of one or more selected from among an n-type doped AIGalnN, GaN, AlGaN, InGaN, AIN, and/or InN.

The n-type dopant of the second semiconductor layer SEM2 may be selected from Si, Ge, and/or Sn.

For example, the second semiconductor layer SEM2 may be n-GaN doped with Si.

A thickness of the second semiconductor layer SEM2 may be in the range of, but not limited to, 2 to 4 *µ*m.

The third semiconductor layer SEM3 between the second semiconductor layer SEM2 and the common electrode CE may be an undoped semiconductor.

That is, the third semiconductor layer SEM3 may include the same material as the second semiconductor layer SEM2 but may be a material not doped with an n-type or p-type dopant. For example, the third semiconductor layer SEM3 may be, but is not limited to, at least one or more selected from among undoped InAlGaN, GaN, AlGaN, InGaN, AIN, and/or InN.

The planarization layer PLL is designed to prevent the common electrode CE on the light emitting elements LE from being broken due to a step difference corresponding to the length of the light emitting elements LE in the third direction DR3. The planarization layer PLL is disposed between the light emitting elements LE and covers the pixel electrodes PE and the dummy patterns DMP.

The planarization layer PLL may be made of an organic insulating material that makes it relatively easy to form the planarization layer PLL thickly. That is, the planarization layer PLL may be made of one or more selected from among polyacrylates resin, epoxy resin, phenolic resin, polyamides resin, polyimides resin, unsaturated polyesters resin, polyphenylenethers resin, polyphenylenesulfides resin, and/or benzocyclobutene (BCB).

The planarization layer PLL has a smaller thickness than the light emitting elements LE so as not to completely cover the light emitting elements LE. Therefore, an end of each of the light emitting elements LE may be electrically connected to the pixel electrode PE, and the other end may be electrically connected to the common electrode CE.

The common electrode CE corresponds to the emission areas LEA and is disposed on the light emitting element array layer EML including the light emitting elements LE and on the planarization layer PLL. For example, the common electrode CE may be disposed over at least the entire display area DPA.

Because the light emitting elements LE are not completely covered with the planarization layer PLL, the common electrode CE may contact at least the third semiconductor layer SEM3 of each of the light emitting elements LE and may be electrically connected to the second semiconductor layer SEM2 of each of the light emitting elements LE.

Because light of each light emitting element LE is emitted through the common electrode CE, the common electrode CE may be thin enough to transmit the light.

For example, the common electrode CE may have a thickness of, but not limited to, about 10 to 200 Å.

In addition, because the common electrode CE is wider than the pixel electrode PE, it may include a material having relatively low resistance so as to reduce sheet resistance.

For example, the common electrode CE may include a material having low resistance such as aluminum (Al), silver (Ag), and/or copper (Cu).

As illustrated in FIG. 49, the display device 100 according to the described embodiment may further include a color conversion array layer CCAL disposed on the common electrode CE and a color filter layer CFL disposed on the color conversion array layer CCAL.

The color conversion array layer CCAL is designed to convert light of the light emitting elements LE into light of a higher wavelength band so that each of the emission areas LEA can display a corresponding color.

The color filter layer CFL is designed to selectively transmit light of a wavelength band corresponding to the color of each emission area LEA from among the light output from the color conversion array layer CCAL, so that each of the emission areas LEA can more clearly display a corresponding color.

Therefore, even if the light emitting element array layer EML includes a plurality of light emitting elements LE emitting light of the same wavelength band, the display device 100 may display various colors, not a single color.

For example, as illustrated in FIG. 49, when the light emitting elements LE emit light of the third color, the color conversion array layer CCAL may include a first color conversion pattern CCP1 corresponding to the first emission area LEA1, a second color conversion pattern CCP2 corresponding to the second emission area LEA2, a transmission pattern TRP corresponding to the third emission area LEA3, and a partition wall pattern WLP corresponding to the non-emission area NEA.

The first color conversion pattern CCP1 of the first emission area LEA1 corresponding to the first color may include first color conversion members WCP1 that convert at least a portion of the light from the light emitting elements LE into light of the first color in a wavelength band higher than that of the third color.

The second color conversion pattern CCP2 of the second emission area LEA2 corresponding to the second color may include second color conversion members WCP2 that convert at least a portion of the light from the light emitting elements LE into light of the second color in a wavelength band higher than that of the third color.

The transmission pattern TRP of the third emission area LEA3 corresponding to the third color guides the light of the light emitting elements LE toward the color filter layer CFL.

For example, the first color conversion pattern CCP1 may include a suitable base resin BRS (e.g., a predetermined base resin BRS) having light transmitting properties and the first color conversion members WCP1 dispersed in the base resin BRS.

Similarly, the second color conversion pattern CCP2 may include a suitable base resin BRS (e.g., a predetermined base resin BRS) having light transmitting properties and the second color conversion members WCP2 dispersed in the base resin BRS.

The base resin BRS may be made of an organic material that is cured by ultraviolet light or heat and has light transmitting properties. For example, the base resin BRS may include one or more selected from among epoxy resin, acrylic resin, cardo resin, and/or imide resin.

Each of the first and second color conversion members WCP1 and WCP2 may be a quantum dot, a quantum rod, a fluorescent material, and/or a phosphorescent material. For example, the quantum dot may be a particulate material that emits light of a specific color when an electron transits from a conduction band to a valence band.

Specifically, the quantum dot may be a semiconductor nanocrystalline material. That is, the quantum dot may have a specific band gap according to its composition and size. Thus, the quantum dot may absorb light and then emit light having a unique wavelength. Examples of semiconductor nanocrystals include Group IV nanocrystals, Group II-VI compound nanocrystals, Group Ill-V compound nanocrystals, Group IV-VI nanocrystals, and combinations thereof.

The Group II-VI compounds may be selected from binary compounds selected from among CdSe, CdTe, ZnS, ZnSe, ZnTe, ZnO, HgS, HgSe, HgTe, MgSe, MgS, and/or mixtures thereof; ternary compounds selected from among InZnP, AgInS, CulnS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS and/or mixtures thereof; and quaternary compounds selected from among HgZnTeS, CdZnSeS, CdZnSeTe, CdZnSTe, CdHgSeS, CdHgSeTe, CdHgSTe, HgZnSeS, HgZnSeTe, HgZnSTe, and/or mixtures thereof.

The Group III-V compounds may be selected from binary compounds selected from among GaN, GaP, GaAs, GaSb, AIN, AIP, AlAs, AlSb, InN, InP, InAs, InSb, and/or mixtures thereof; ternary compounds selected from among GaNP, GaNAs, GaNSb, GaPAs, GaPSb, AINP, AINAs, AINSb, AIPAs, AlPSb, InGaP, InNP, InAlP, InNAs, InNSb, InPAs, InPSb, GaAINP, and/or mixtures thereof; and quaternary compounds selected from among GaAINAs, GaAINSb, GaAIPAs, GaAIPSb, GalnNP, GalnNAs, GaInNSb, GalnPAs, GalnPSb, InAINP, InAINAs, InAINSb, InAIPAs, InAIPSb, and/or mixtures thereof.

The Group IV-VI compounds may be selected from binary compounds selected from among SnS, SnSe, SnTe, PbS, PbSe, PbTe, and/or mixtures thereof; ternary compounds selected from among SnSeS, SnSeTe, SnSTe, PbSeS, PbSeTe, PbSTe, SnPbS, SnPbSe, SnPbTe, and/or mixtures thereof; and quaternary compounds selected from among SnPbSSe, SnPbSeTe, SnPbSTe, and/or mixtures thereof. The Group IV elements may be selected from among silicon (Si), germanium (Ge), and/or a mixture thereof. The Group IV compounds may be binary compounds selected from among silicon carbide (SiC), silicon germanium (SiGe), and/or a mixture thereof.

Here, the binary, ternary, and/or quaternary compounds may be present in the particles at a uniform concentration or may be present in the same particles at partially different concentrations. In addition, they may have a core/shell structure in which one quantum dot surrounds another quantum dot. An interface between the core and the shell may have a concentration gradient in which the concentration of an element present in the shell is reduced toward the center.

In the described embodiment, the quantum dot may have a core-shell structure including a core containing the above-described nanocrystal and a shell surrounding the core. The shell of the quantum dot may serve as a protective layer for maintaining semiconductor characteristics by preventing chemical denaturation of the core and/or as a charging layer for giving electrophoretic characteristics to the quantum dot. The shell may be a single layer or a multilayer. The shell of the quantum dot may be, for example, a metal or non-metal oxide, a semiconductor compound, or a combination thereof.

For example, the metal or non-metal oxide may be, but is not limited to, a binary compound selected from among SiO₂, Al₂O₃, TiO₂, ZnO, MnO, Mn₂O₃, Mn₃O₄, CuO, FeO, Fe₂O₃, Fe₃O₄, CoO, Co₃O₄ or NiO or a ternary compound such as MgAl₂O₄, CoFe₂O₄, NiFe₂O₄, and/or CoMn₂O₄.

In addition, the semiconductor compound may be, but is not limited to, selected from among CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AIP, and/or AlSb.

Alternatively, the first color conversion members WCP1 and the second color conversion members WCP2 may convert light of the third color emitted from the light emitting elements LE into a fourth color in a wavelength band between the wavelength band of the first color and the wavelength band of the second color.

Alternatively, the first color conversion members WCP1 may be phosphors of the first color that convert light of the third color emitted from the light emitting elements LE into light of the first color. For example, when the third color is blue and the first color is red, the phosphors of the first color may be (Sr, Ca)AISiN₃:Eu²⁺ or K₂(Si, Ge, Ti)F₆:Mn⁴⁺.

In addition, the second color conversion members WCP2 may be phosphors of the second color that convert light of the third color emitted from the light emitting elements LE into light of the second color. For example, when the third color is blue and the second color is green, the phosphors of the second color may be at least one selected from among Beta-SiAION:Eu²⁺, SrGa₂S₄:Eu²⁺, BaAlMg₁₀O₁₇:Eu²⁺, Mn²⁺ , (Sr, Ba, Mg)₂SiO₄:Eu²⁺, and/or (Lu,Y)₃(Al, Ga)₅O₁₂:Ce³⁺.

The transmission pattern TRP may include a base resin BRS (e.g., a predetermined base resin BRS) having light transmitting properties. Alternatively, the transmission pattern TRP may further include scattering particles.

For example, the scattering particles may have a size of 10 to 500 nm. The scattering particles may be made of at least one metal oxide selected from among titanium oxide (TiO₂), silicon oxide (SiO₂), aluminum oxide (Al₂O₃), and/or zirconium oxide (ZrO₂).

In addition, each of the first color conversion pattern CCP1 and the second color conversion pattern CCP2 may further include scattering particles dispersed in the base resin BRS.

The partition wall pattern WLP is designed to separate spaces for placing the first color conversion pattern CCP1, the second color conversion pattern CCP2, and the transmission pattern TRP. The partition wall pattern WLP may be made of an organic insulating material selected from among epoxy resin, acrylic resin, cardo resin, and/or imide resin.

A width of the partition wall pattern WLP in the first direction DR1 or the second direction DR2 may be in the range of 1 to 10 *µ*m.

The color filter layer CFL may include a first color filter CF1 corresponding to the first emission area LEA1 and transmitting light of the first color, a second color filter CF2 corresponding to the second emission area LEA2 and transmitting light of the second color, a third color filter CF3 corresponding to the third emission area LEA3 and transmitting light of the third color, and a light blocking pattern LBP corresponding to the non-emitting area NEA.

The color filter layer CFL may improve the color purity of light emitted from each of the emission areas LEA.

In addition, the light blocking pattern LBP may prevent reflection of external light in the non-emission area NEA and prevent color mixing between neighboring emission areas LEA, thereby improving a color gamut.

In addition, the display device 100 according to the described embodiment may further include a protective layer PTL covering the color filter layer CFL.

The protective layer PTL may be made of an inorganic insulating material selected from among silicon oxide (SiOₓ), silicon nitride (SiNₓ), silicon oxynitride (SiOₓN_{y}), aluminum oxide (AlₓO_{y}), and/or aluminum nitride (AIN).

The protective layer PTL may have a thickness of 0.01 to 1 *µ*m. However, this is merely an example.

FIG. 49 illustrates an example of a case where a plurality of light emitting elements LE emit light of the third color corresponding to the third emission area LEA3.

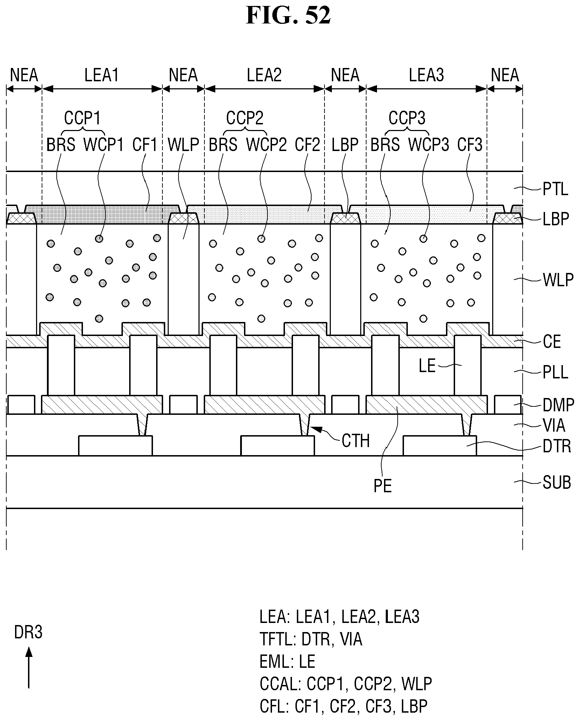

Alternatively, the light emitting elements LE may emit light in a wavelength band lower than that of the third color, that is, light in the ultraviolet band. In this case, the color conversion array layer CCAL may include a third color conversion pattern CCP3 (see FIG. 52) instead of the transmission pattern TRP.

FIG. 52 is a cross-sectional view taken along the line C-C' of FIG. 48.

The example illustrated in FIG. 52 is the same as the example illustrated in FIGS. 49 through 51 except that a plurality of light emitting elements LE' emit light in a wavelength band lower than that of the third color and that a color conversion array layer CCAL does not include a transmission pattern TRP (see FIG. 49) and, instead, includes a third color conversion pattern CCP3 corresponding to a third emission area LEA3. Therefore, any redundant description will be omitted.

The third color conversion pattern CCP3 may include a base resin BRS (e.g., a predetermined base resin BRS) and third color conversion members WCP3 dispersed in the base resin BRS and converting light from the light emitting elements LE' into light of the third color.

The third color conversion members WCP3 may be quantum dots, quantum rods, a fluorescent material, or a phosphorescent material.

For example, the third color conversion members WCP3 may be made of a fluorescent material of BalIMg₁₀O₁₇:Eu²⁺.

As mentioned above, the light emitting elements LE' are not individually placed one by one, but are placed all at once.

Therefore, there may be some errors in alignment between the light emitting elements LE' and a plurality of pixel electrodes PE. That is, due to the alignment errors, not all of the light emitting elements LE' may be disposed on the pixel electrodes PE, but some of the light emitting elements LE' may be partially disposed in a non-emission area NEA.

FIGS. 53 and 54 are plan views illustrating examples of an alignment error of the light emitting elements LE illustrated in FIG. 48.

Referring to FIG. 53, there may occur a first alignment error AE1 in which the light emitting elements LE are shifted to one side (right side of FIG. 53) in the first direction DR1 from a position of normal alignment with the pixel electrodes PE.

When a width of the first alignment error AE1 is greater than the second distance G2 between a pixel electrode PE and a dummy pattern DMP, some light emitting elements LE partially disposed in the non-emission area NEA due to the first alignment error AE1 from among two or more light emitting elements LE disposed on each pixel electrode PE may be supported by a dummy pattern DMP adjacent to one side of each pixel electrode PE in the first direction DR1.

Alternatively, referring to FIG. 54, there may occur a second alignment error AE2 in which the light emitting elements LE are shifted to the other side (left side of FIG. 54) in the first direction DR1 from the position of normal alignment with the pixel electrodes PE.

When a width of the second alignment error AE2 is greater than the second distance G2 between a pixel electrodes PE and a dummy patterns DMP, some light emitting elements LE partially disposed in the non-emission area NEA due to the second alignment error AE2 from among two or more light emitting elements LE disposed on each pixel electrode PE may be supported by a dummy pattern DMP adjacent to the other side of each pixel electrode PE in the first direction DR1.

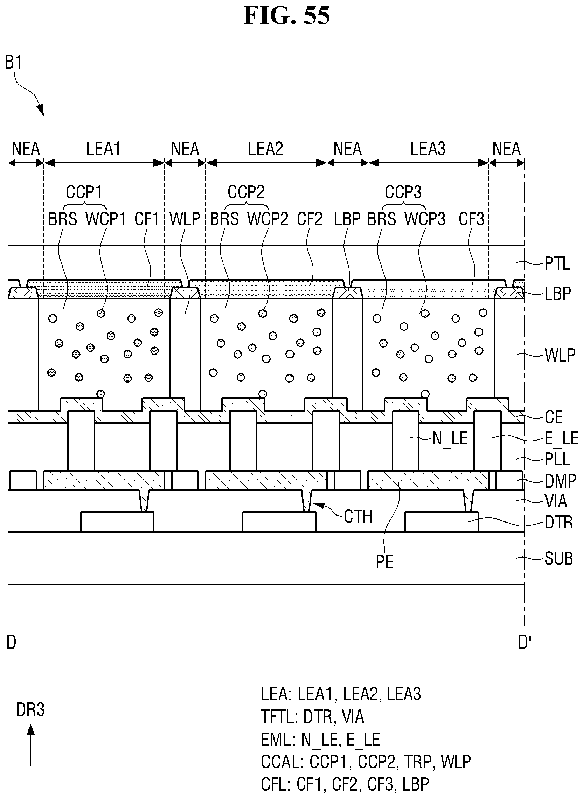

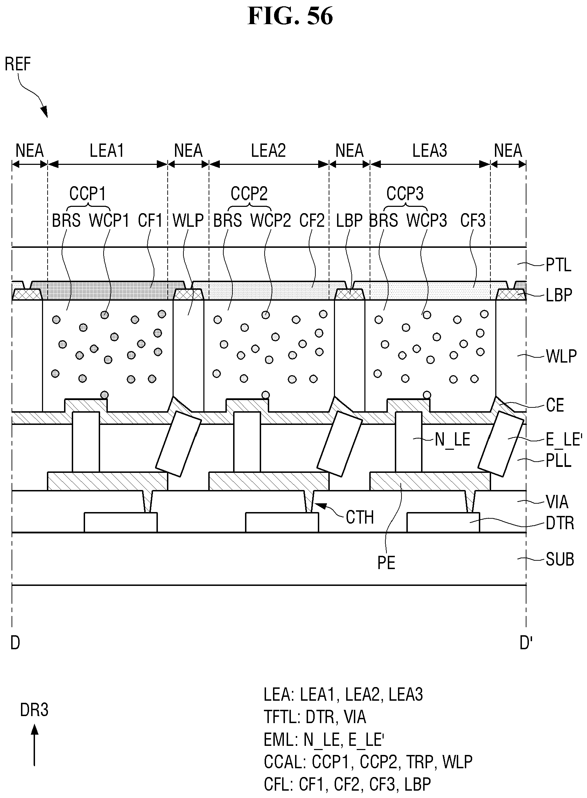

FIG. 55 is a cross-sectional view taken along the lone line D-D' of FIG. 53. FIG. 56 is a cross-sectional view of a comparative example REF of FIG. 55.

First, referring to FIG. 56, in the case of the comparative example REF not including a plurality of dummy patterns DMP, some light emitting elements E_LE' abnormally protruding to a non-emission area NEA due to the first alignment error AE1 or the second alignment error AE2 are disposed on the edges of pixel electrodes PE and tilted due to a step of the pixel electrodes PE.

The tilted light emitting elements E_LE' cannot be located at the same height as light emitting elements N_LE disposed normally. This may be a factor that causes a common electrode CE disposed on the light emitting elements N_LE and E_LE' to be broken.

That is, because the common electrode CE is disposed on inclined surfaces corresponding to the tilted light emitting elements E_LE', it is difficult for the common electrode CE to have a constant thickness on each of the light emitting elements LE. Therefore, the sheet resistance of the common electrode CE may vary locally. Accordingly, this may undermine the uniformity of luminance characteristics of the light emitting elements LE, thus degrading the display quality of the display device 100.

On the other hand, referring to FIG. 55, when the first alignment error AE1 or the second alignment error AE2 corresponding to the first direction DR1 occurs, two or more light emitting elements LE corresponding to each pixel electrode PE may include light emitting elements N_LE normally disposed on each pixel electrode PE and light emitting elements E_LE abnormally protruding to a non-emission area NEA adjacent to each pixel electrode PE in the first direction DR1.

Here, according to the described embodiment, a plurality of dummy patterns DMP are disposed on the same layer as the pixel electrodes PE and alternately disposed with the pixel electrodes PE in the first direction DR1. Therefore, the light emitting elements E_LE abnormally protruding to the non-emission area NEA may be supported by the dummy patterns DMP. Accordingly, this can prevent a tilting defect in which the light emitting elements E_LE abnormally protruding to the non-emission area NEA are tilted due to a step of the pixel electrodes PE.

Therefore, because the common electrode CE can be disposed with a uniform thickness on each of the light emitting elements LE, it is possible to prevent a decrease in the uniformity of luminance characteristics of the light emitting elements LE and prevent degradation of display quality.

Next, other examples of the dummy patterns according to the described embodiment will be described.

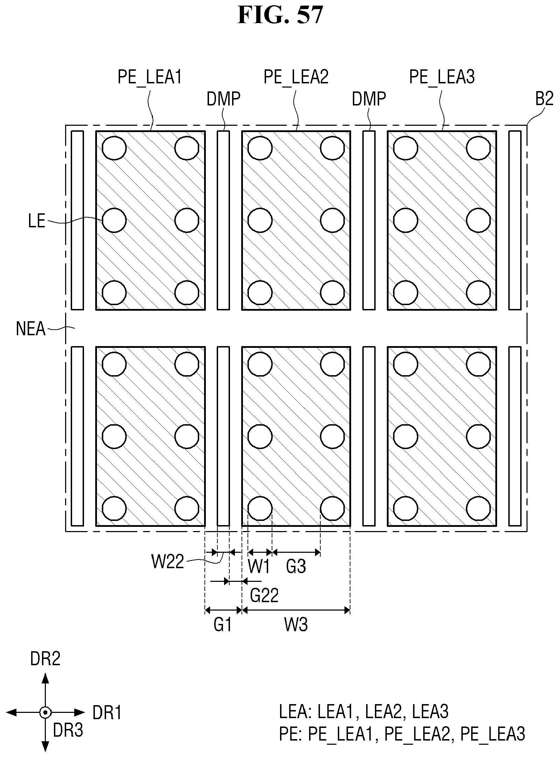

FIGS. 57 through 63 are plan views illustrating other examples of pixel electrodes and dummy patterns corresponding to the portion B of FIG. 47.

Referring to FIG. 57, a second example B2 is substantially the same as the first example B1 of FIGS. 48 through 55 except that a second distance G22 between each pixel electrode PE and a dummy pattern DMP is in the same range as half a first width W1 of a light emitting element LE which is a threshold value of a tilting defect. Therefore, any redundant description will be omitted.

According to the second example B2, a second width W22 of each dummy pattern DMP may correspond to a value obtained by subtracting the second distances G22 between the dummy pattern DMP and two pixel electrodes PE disposed on both sides of the dummy pattern DMP in the first direction DR1 from a first distance G1 between the pixel electrodes PE (i.e., W22 = G1 - (G22 * 2)).

According to the second example B2, because the second distance G22 between each pixel electrode PE and a dummy pattern DMP corresponds to a threshold value of a tilting defect, it is possible to prevent the tilting defect and reduce the proportion of the dummy patterns DMP in a display area DPA.

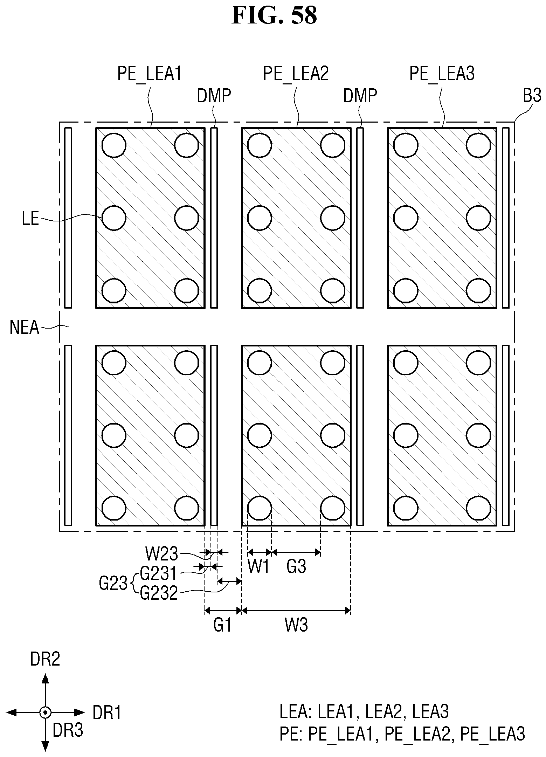

Referring to FIG. 58, a third example B3 is substantially the same as the first example B1 of FIGS. 48 through 55 except that one dummy pattern DMP disposed between two neighboring pixel electrodes PE is more adjacent to any one of the two pixel electrodes PE. Therefore, any redundant description will be omitted.

The third example B3 illustrated in FIG. 58 may correspond to the first alignment error AE1 in which a plurality of light emitting elements LE are shifted to one side (right side of FIG. 58) in the first direction DR1 from a position of normal alignment with a plurality of pixel electrodes PE.

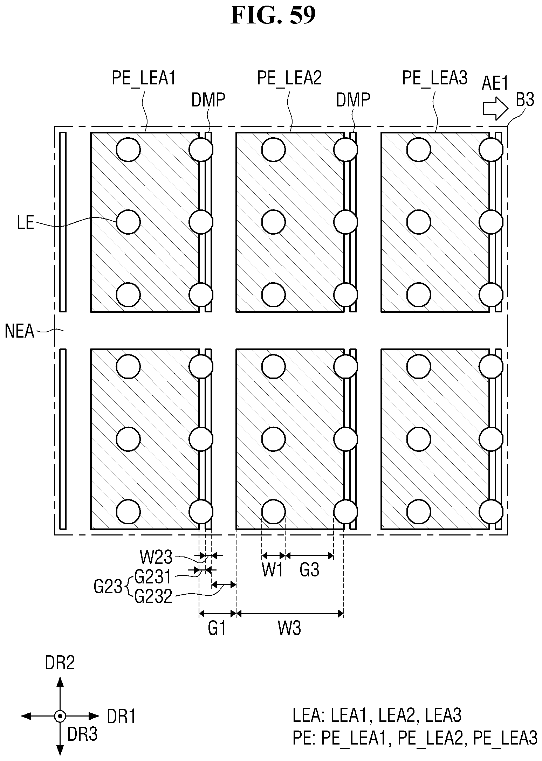

That is, as illustrated in FIG. 59, according to the third example B3 corresponding to the first alignment error AE1, one dummy pattern DMP disposed between two neighboring pixel electrodes PE may be more adjacent to a pixel electrode PE adjacent to the other side in the first direction DR1 from among the two pixel electrodes PE. Therefore, the light emitting elements LE shifted to one side (right side of FIG. 59) in the first direction DR1 by the first alignment error AE1 may be supported by the dummy pattern DMP.

According to the third example B3, one dummy pattern DMP disposed between two pixel electrodes PE may be spaced from a pixel electrode PE adjacent to the other side in the first direction DR1 from among the two pixel electrodes PE by a 231^{st} distance G231 and may be spaced from a pixel electrode PE adjacent to one side in the first direction DR1 by a 232^{nd} distance G232. As shown in FIG. 59, G231 + G232 = G23.

Here, when the dummy pattern DMP corresponds to the first alignment error AE1, the 231^{st} distance G231 is smaller than the 232^{nd} distance G232 (i.e., G231 < G232).

The sum of the 231^{st} distance G231 and a second width W23 of each dummy pattern DMP may be equal to or greater than half a first width W1 of each light emitting element LE (i.e., (G231 + W23) ≥ (W1)/2).

In this case, it is possible to prevent a tilting defect due to the first alignment error AE1 and further reduce the proportion of the dummy patterns DMP in a display area DPA.

FIGS. 58 and 59 illustrate the third example B3 corresponding to the first alignment error AE1. When the third example B3 corresponds to the second alignment error AE2 in which a plurality of light emitting elements LE are shifted to the other side (left side of FIG. 54) in the first direction DR1, one dummy pattern DMP disposed between two neighboring pixel electrodes PE may be more adjacent to a pixel electrode PE adjacent to one side in the first direction DR1 from among the two pixel electrodes PE.

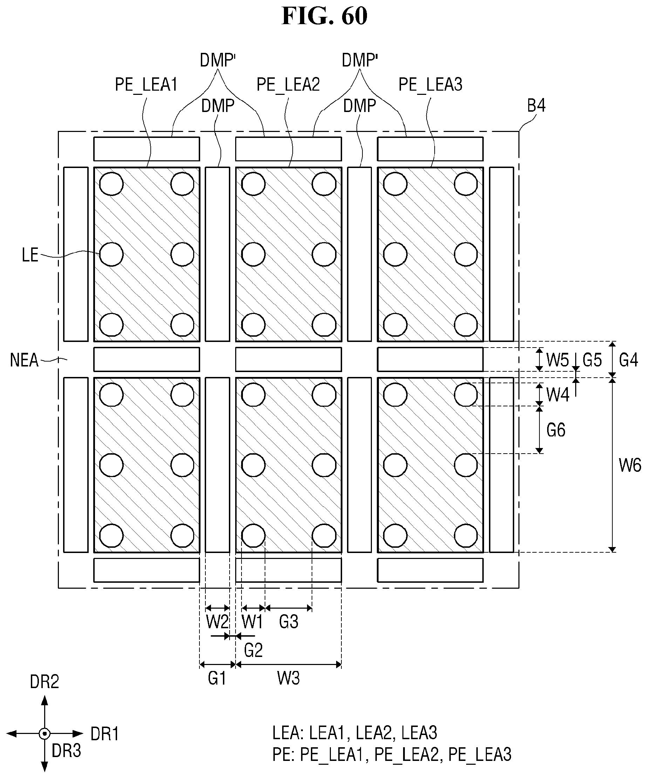

Referring to FIG. 60, a fourth example B4 is substantially the same as the first example B1 of FIGS. 48 through 55 except that auxiliary dummy patterns DMP' alternately disposed with a plurality of pixel electrodes PE along the second direction DR2 are further included. Therefore, any redundant description will be omitted.

Each of a plurality of light emitting elements LE may have a width W4 (e.g., a predetermined width W4, hereinafter, referred to as a "fourth width") in the second direction DR2. The light emitting elements LE may be spaced from each other by distance G6 (e.g., a predetermined distance G6, hereinafter, referred to as a "sixth distance") in the second direction DR2.

Each of the pixel electrodes PE may have a width W6 (e.g., a predetermined width W6, hereinafter, referred to as a "sixth width") in the second direction DR2. The pixel electrodes PE may be spaced from each other by a distance G4 (e.g., a predetermined distance G4, hereinafter, referred to as a "fourth distance") in the second direction DR2.

The auxiliary dummy patterns DMP' may have a width W5 (e.g., a predetermined width W5, hereinafter, referred to as a "fifth width") in the second direction DR2. A pixel electrode PE of an emission area LEA and an auxiliary dummy pattern DMP' adjacent to the emission area LEA in the second direction DR2 may be spaced from each other by a distance G5 (e.g., a predetermined distance G5, hereinafter, referred to as a "fifth distance") in the second direction DR2.

The fourth distance G4 between the pixel electrodes PE neighboring each other in the second direction DR2 may be greater than the fourth width W4 of each light emitting element LE in the second direction DR2 (i.e., G4 > W4).

In this case, it is possible to prevent a defect in which a light emitting element partially disposed in a non-emission area NEA due to an alignment error is connected to both of the two pixel electrodes PE neighboring each other in the second direction DR2.

The fifth distance G5 between a pixel electrode PE and an auxiliary dummy pattern DMP' neighboring each other in the second direction DR2 may be selected within a range exceeding 0 and smaller than half the fourth width W4 of each light emitting element LE (i.e., 0 < G5 ≤ (W4)/2).

In this case, a tilting defect of a light emitting element LE partially disposed in the non-emission area NEA between the pixel electrodes PE neighboring each other in the second direction DR2 can be prevented by an auxiliary dummy pattern DMP'.

When an auxiliary dummy pattern DMP' is spaced from two neighboring pixel electrodes PE on both sides in the second direction DR2 by the same fifth distance G5, the sum (W5+2*G5) of the fifth width W5 of the auxiliary dummy pattern DMP' and twice (2*G5) the fifth distance G5 is equal the fourth distance G4 between the two pixel electrodes PE neighboring each other in the second direction DR2. However, in some embodiments, when an auxiliary dummy pattern DMP' is spaced from two neighboring pixel electrodes PE on both sides in the second direction DR2 by the same fifth distance G5, the sum (W5+2*G5) of the fifth width W5 of the auxiliary dummy pattern DMP' and twice (2*G5) the fifth distance G5 is smaller than the fourth distance G4 between the two pixel electrodes PE neighboring each other in the second direction DR2.

In addition, the sum of the fifth width W5 and the fifth distance G5 may be selected within a range greater than half the fourth width W4 (W5 + G5 > (W4)/2, W5 > (W4)/2 - G5).

In this case, of a light emitting element LE protruding into the non-emission area NEA between the pixel electrodes PE neighboring each other in the second direction DR2, a portion protruding farthest from an edge of a pixel electrode PE may be supported by an auxiliary dummy pattern DMP'. That is, one side of the light emitting element LE protruding into the non-emission area NEA in the second direction DR2 may be supported by the pixel electrode PE, and the other side in the second direction DR2 may be supported by the auxiliary dummy pattern DMP'. Accordingly, the reliability of the auxiliary dummy pattern DMP' for preventing a tilting defect of the light emitting element LE can improved.

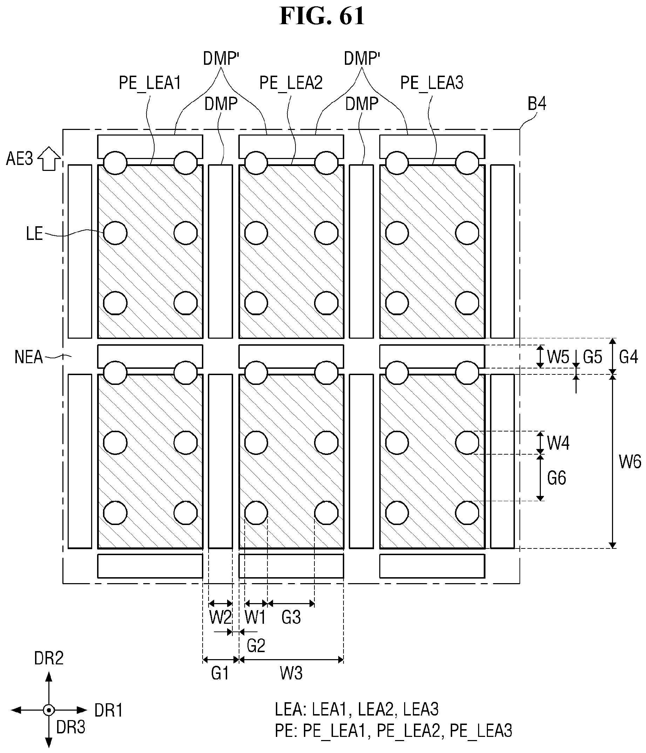

That is, as illustrated in FIG. 61, when there occurs a third alignment error AE3 in which a plurality of light emitting elements LE are shifted to one side (upper side of FIG. 61) in the second direction DR2 from a position of normal alignment with a plurality of pixel electrodes PE, some light emitting elements LE partially disposed in the non-emission area NEA due to the third alignment error AE3 from among two or more light emitting elements LE disposed on each pixel electrode PE may be supported by an auxiliary dummy pattern DMP' adjacent to one side of each pixel electrode PE in the second direction DR2.

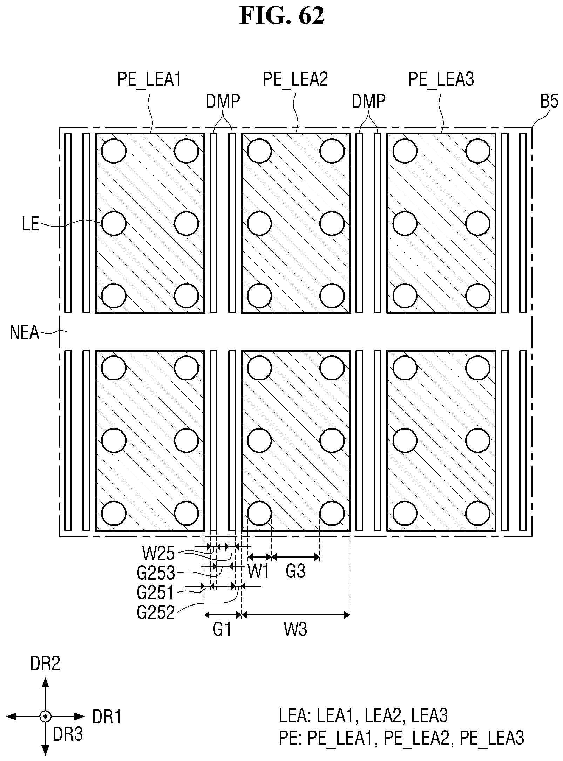

Referring to FIG. 62, a fifth example B5 is the same as the first example B1 illustrated in FIGS. 48 through 55 except that two dummy patterns DMP spaced from each other are disposed between two pixel electrodes PE neighboring each other in the first direction DR1. Therefore, any redundant description will be omitted.

For example, from among two dummy patterns DMP disposed between the two pixel electrodes PE_LEA1 and PE_LEA2 neighboring each other in the first direction DR1, a dummy pattern DMP disposed on the other side (e.g., left side of FIG. 62) in the first direction DR1 may be spaced apart from a neighboring pixel electrode PE_LEA1 on the other side in the first direction DR1 by a 251^{st} distance G251.

In addition, from among the two dummy patterns DMP disposed between the two pixel electrodes PE_LEA1 and PE_LEA2 neighboring each other in the first direction DR1, the other dummy pattern DMP disposed on one side (e.g., right side of FIG. 62) in the first direction DR1 may be spaced from a neighboring pixel electrode PE_LEA2 on the one side in the first direction DR1 by a 252^{nd} distance G252. Here, the 251^{st} distance G251 and the 252^{nd} distance G252 may be in the same range, but embodiments of the present disclosure are not limited thereto.

Each of the 251^{st} distance G251 and the 252^{nd} distance G252 may be smaller than half a first width W1 of a light emitting element LE (i.e., G251, G252 ≤ (W1)/2).

Each of the two dummy patterns DMP disposed between two pixel electrodes PE_LEA1 and PE_LEA2 neighboring each other in the first direction DR1 may have a 25^{th} width W25 (e.g., a predetermined 25^{th} width W25) in the first direction DR1.

For example, the sum of the 251^{st} distance G251 and the 25^{th} width W25 may be smaller than half the first width W1 of each light emitting element LE (i.e., (G251 + W25) ≤ (W1)/2). In this case, when the first alignment error AE1 in which the light emitting elements LE are shifted to one side (right side of FIG. 53) in the first direction DR1 occurs, even if a light emitting element LE protrudes into a non-emission area NEA by more than half the first width W1, at least a portion of the light emitting element LE may be supported by a dummy pattern DMP. Therefore, a tilting defect can be prevented.

Similarly, the sum of the 252^{nd} distance G252 and the 25^{th} width W25 may be smaller than half the first width W1 of each light emitting element LE ((G252 + W25) ≤ (W1)/2). In this case, when the second alignment error AE2 in which the light emitting elements LE are shifted to the other side (left side of FIG. 53) in the first direction DR1, even if a light emitting element LE protrudes into the non-emission area NEA by more than half the first width W1, at least a portion of the light emitting element LE may be supported by a dummy pattern DMP. Therefore, a tilting defect can be prevented.

Two dummy patterns DMP disposed between two pixel electrodes PE_LEA1 and PE_LEA2 neighboring each other in the first direction DR1 may be spaced from each other by a 253^{rd} distance G253. The 253^{rd} distance G253 may correspond to a patterning margin of the dummy patterns DMP.

According to the fifth example B5, when the first alignment error AE1 or the second alignment error AE2 corresponding to the first direction DR1 occurs, a light emitting element LE protruding into the non-emission area NEA may be partially disposed on a pixel electrode PE and one dummy pattern DMP or may be disposed on two neighboring dummy patterns DMP. Therefore, it is possible to prevent a tilting defect and a defect in which a light emitting element LE in the non-emission area NEA is connected to two pixel electrodes PE.

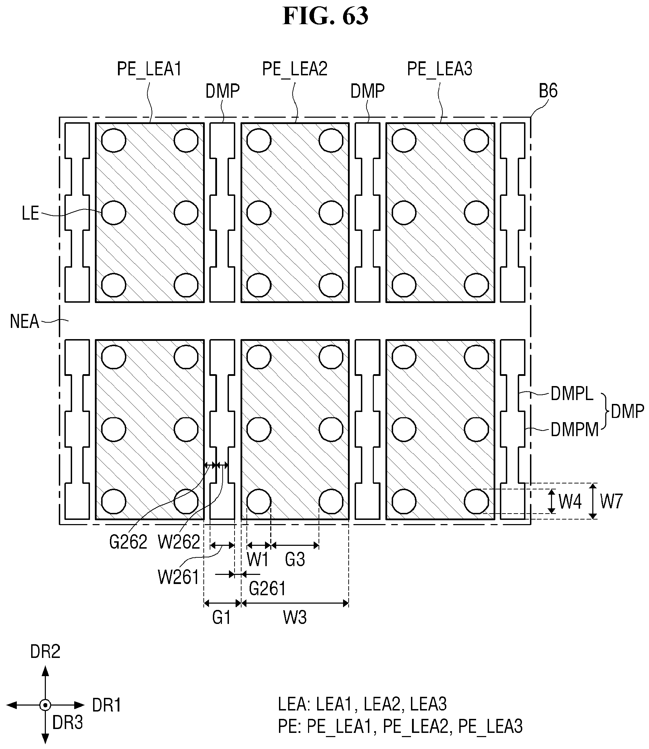

Referring to FIG. 63, a sixth example B6 is substantially the same as the first example B1 of FIGS. 48 through 55 except that a dummy pattern DMP disposed between two pixel electrodes PE includes main portions DMPM protruding toward the two pixel electrodes PE and a line portion DMPL connecting the main portions DMPM. Therefore, any redundant description will be omitted.

The main portions DMPM of each dummy pattern DMP may face light emitting elements LE on both sides in the first direction DR1.

A seventh width W7 of each main portion DMPM in the second direction DR2 may be equal to or greater than a fourth width W4 of each light emitting element LE in the second direction DR2. In this case, a light emitting element LE protruding into a non-emission area NEA can be easily supported by a main portion DMPM.

Each main portion DMPM may be spaced from a neighboring pixel electrode PE in the first direction DR1 by a 261^{st} distance G261.

The 261^{st} distance G261 of each main portion DMPM may be selected within a range exceeding 0 and smaller than half a first width W1 of each light emitting element LE (i.e., 0 < G261 ≤ (W1)/2).

The main portions DMPM may have a predetermined 261^{st} width W261 in the first direction DR1.

The sum (W261+2*G261) of the 261^{st} width W261 of each main portion DMPM and twice (2*G261) the 261^{st} distance G261 may correspond to a first distance G1 between two pixel electrodes PE neighboring each other in the first direction DR1.

In addition, the sum of the 261^{st} width W261 of each main portion DMPM and the 261^{st} distance G261 may be selected within a range greater than half the first width W1 (i.e., (W261 + G261) > (W1)/2).

In this case, one side of a light emitting elements LE protruding into the non-emission area NEA in the first direction DR1 may be supported by a pixel electrode PE, and the other side in the first direction DR1 may be supported by a main portion DMPM of a dummy pattern DMP.

The line portion DMPL of each dummy pattern DMP may have a predetermined 262^{nd} width W262 in the first direction DR1. Here, the 262^{nd} width W262 of the line portion DMPL is smaller than the 261^{st} width W261 of the main portions DMPM. Therefore, it is possible to reduce the proportion of the dummy patterns DMP in a display area DPA while preventing a tilting defect through the dummy patterns DMP.

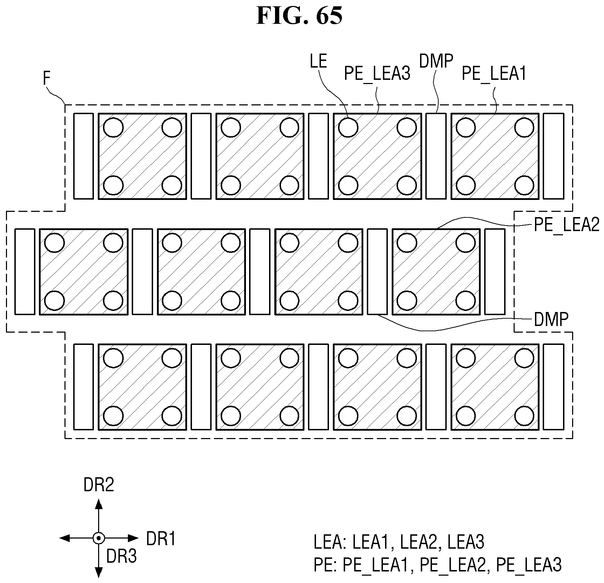

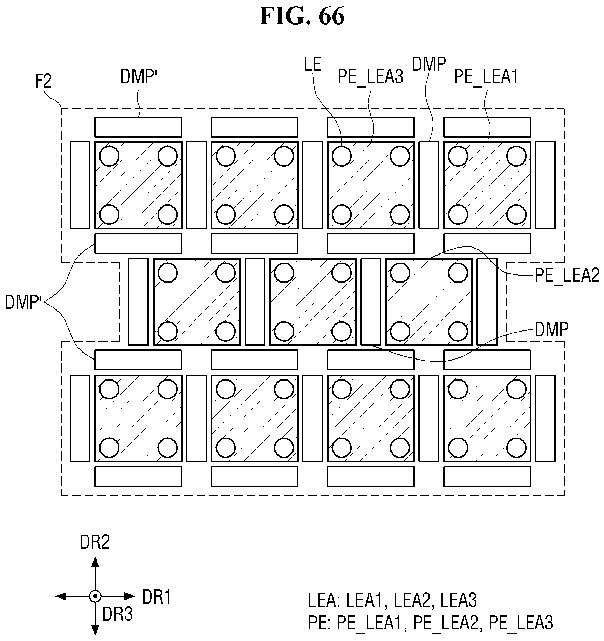

FIG. 64 is a plan view illustrating another example of a plurality of emission areas LEA corresponding to the portion A of FIG. 42. FIGS. 65 and 66 are plan views illustrating examples of pixel electrodes PE and dummy patterns DMP corresponding to a portion F of FIG. 64.

As illustrated in FIG. 64, the arrangement form of the emission areas LEA according to the example may include a first row in which first emission areas LEA1 and third emission areas LEA3 are alternately arranged along the first direction DR1 and a second row in which second emission areas LEA2 are arranged side by side in the first direction DR1. The first row and the second row may be alternately arranged along the second direction DR2. In addition, the first and third emission areas LEA1 and LEA3 of the first row may not be side by side with the second emission areas LEA2 of the second row in the second direction DR2 but may neighbor the second emission areas LEA2 of the second row in diagonal directions intersecting the first direction DR1 and the second direction DR2.

In this case, each of a plurality of pixels PX may be composed of one first emission area LEA1 and one third emission area LEA3 adjacent to each other in the first direction DR1 and two second emission areas LEA2 adjacent to them in the diagonal directions. However, this is merely an example, and the configuration of each pixel PX according to one or more embodiments is not limited to that illustrated in FIG. 64 and can be changed as desired.

Referring to FIG. 65, a display device 100 including the emission areas LEA illustrated in FIG. 64 may include a plurality of pixel electrodes PE_LEA1, PE_LEA2, and PE_LEA3 respectively corresponding to the emission areas LEA, a plurality of dummy patterns DMP, each disposed in a non-emission area NEA between the pixel electrodes PE neighboring each other in the first direction DR1, and a plurality of light emitting elements LE.

Alternatively, referring to FIG. 66, the display device 100 including the emission areas LEA illustrated in FIG. 64 may further include auxiliary dummy patterns DMP' disposed on both sides of each of the pixel electrodes PE_LEA1 and PE_LEA3 in the first and third emission areas LEA1 and LEA3 in the second direction DR2.

Alternatively, the auxiliary dummy patterns DMP' may also be disposed on both sides of the pixel electrode PE_LEA2 in each second emission area LEA2 in the second direction DR2, unlike the illustration of FIG. 66.

Next, a method of manufacturing a display device according to one or more embodiments will be described.

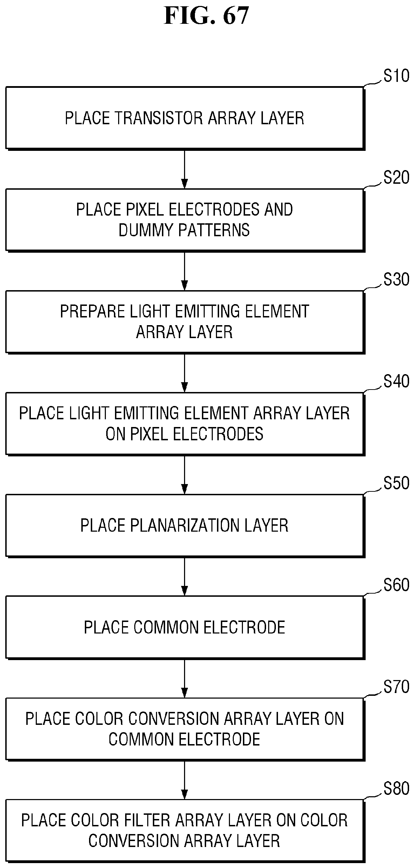

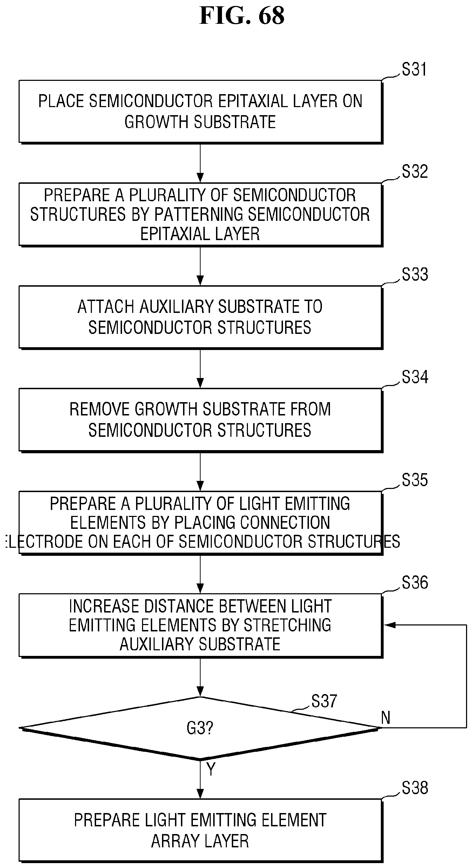

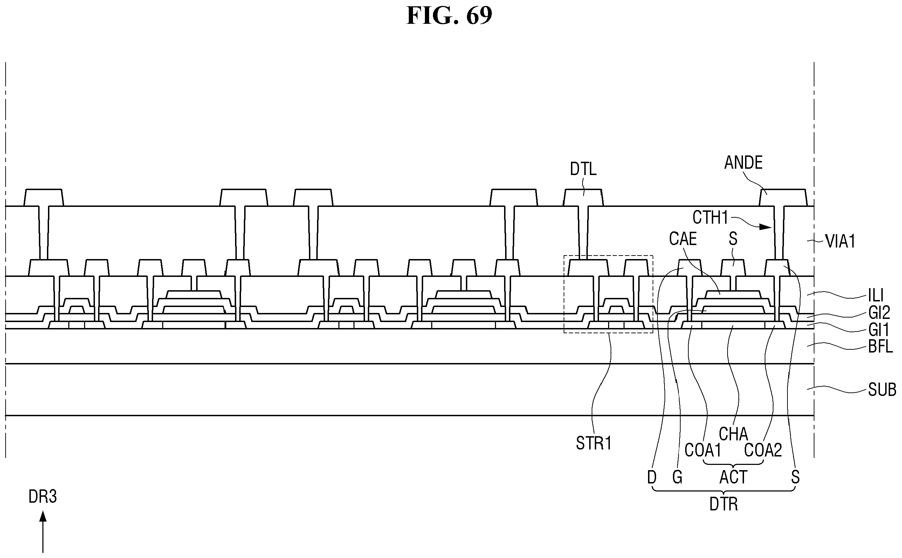

FIG. 67 is a flowchart illustrating a method of manufacturing a display device according to another embodiment. FIG. 68 is a flowchart illustrating an operation of preparing a light emitting element array layer in FIG. 67. FIGS. 69 through 84 are process diagrams illustrating each operation of FIGS. 67 and 68.

Referring to FIG. 67, the method of manufacturing the display device 100 according to the described embodiment includes preparing a substrate SUB including a display area DPA in which a plurality of emission areas LEA are arranged and placing a transistor array layer TFTL, which includes a plurality of thin-film transistors DTR corresponding to the emission areas LEA and a via layer VIA covering the thin-film transistors, on the substrate SUB (operation S10), placing a plurality of pixel electrodes PE corresponding to the emission areas LEA and a plurality of dummy patterns DMP corresponding to a non-emission area NEA between the emission areas LEA on the via layer VIA (operation S20), preparing a light emitting element array layer EML disposed on an auxiliary substrate and including a plurality of light emitting elements LE corresponding to the emission areas LEA (operation S30), placing the light emitting element array layer EML on the pixel electrodes PE and removing the auxiliary substrate (operation S40), placing a planarization layer PLL to fill a space between the light emitting elements LE and to cover the pixel electrodes PE and the dummy patterns DMP (operation S50), placing a common electrode CE corresponding to the emission areas LEA on the light emitting elements LE and the planarization layer PLL (operation S60), placing a color conversion array layer CCAL on the common electrode CE (operation S70), and placing a color filter layer CFL on the color conversion array layer CCAL (operation S80).

In the placing of the pixel electrodes PE and the dummy patterns DMP (operation S20), the pixel electrodes PE may be spaced from each other by a first distance G1 (e.g., a predetermined first distance G1) in one direction.

In addition, in the placing of the pixel electrodes PE and the dummy patterns DMP (operation S20), a pixel electrode PE and a dummy pattern DMP neighboring each other in one direction may be spaced from each other by a second distance G2 (e.g., a predetermined second distance G2).

Referring to FIG. 68, the preparing of the light emitting element array layer EML (operation S30) may include placing a semiconductor epitaxial layer on a growth substrate (operation S31), preparing a plurality of semiconductor structures, each having a first width W1 in one direction, by patterning the semiconductor epitaxial layer (operation S32), attaching an auxiliary substrate to the semiconductor structures (operation S33), removing the growth substrate from the semiconductor structures (operation S34), preparing a plurality of light emitting elements LE by placing a connection electrode CNE on each of the semiconductor structures (operation S35), increasing a distance between the light emitting elements LE by stretching the auxiliary substrate (operation S36), and preparing the light emitting element array layer EML (operation S38) when the light emitting elements LE are spaced from each other by a third distance G3 (e.g., a predetermined third distance G3) in the one direction (operation S37).

In the placing of the semiconductor epitaxial layer (operation S31), the semiconductor epitaxial layer may include a first semiconductor layer of a first conductivity type, an active layer of a quantum well structure, a second semiconductor layer of a second conductivity type, and a third semiconductor layer of an undoped semiconductor that are sequentially stacked on the growth substrate.

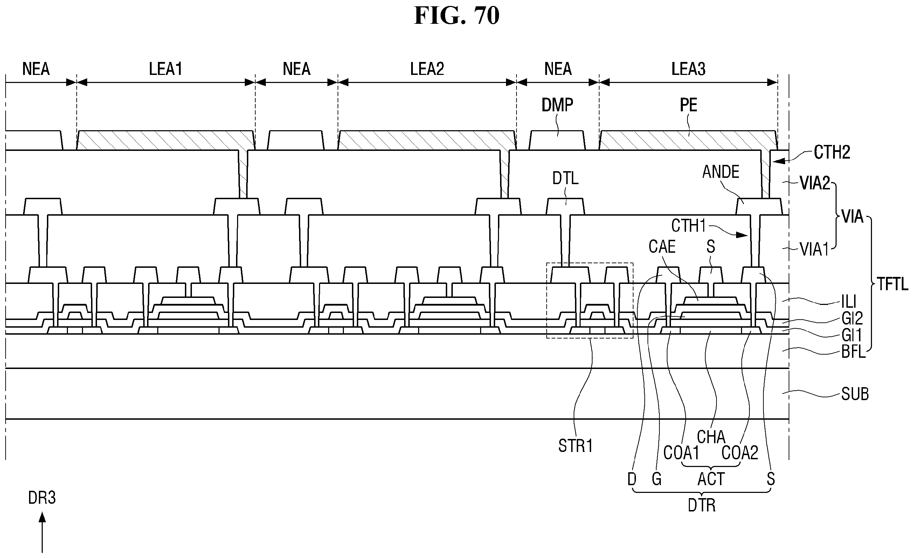

Referring to FIGS. 69 and 70, a substrate SUB including a display area DPA is prepared, and a transistor array layer TFTL including a plurality of thin-film transistors DTR and STR1 and a via layer VIA covering the thin-film transistors DTR and STR1 is placed on the substrate SUB (operation S10).

As illustrated in FIG. 69, the transistor array layer TFTL may include a buffer layer BFL disposed on the substrate SUB, a first gate insulating layer GI1 covering active layers ACT on the buffer layer BFL, a second gate insulating layer GI2 covering gate electrodes G on the first gate insulating layer GI1, an interlayer insulating layer ILI covering capacitor electrodes CAE on the second gate insulating layer GI2, and a first via layer VIA1 covering source electrodes S and drain electrodes D on the interlayer insulating layer ILI.

A driving transistor DTR from among the thin-film transistors included in the transistor array layer TFTL may include an active layer ACT disposed on the buffer layer BFL and including a channel region CHA and first and second conductive regions COA1 and COA2 connected to both sides of the channel region CHA, a gate electrode G disposed on the first gate insulating layer GI1 and overlapping the channel region CHA of the active layer ACT in the third direction DR3, and a drain electrode D and a source electrode S disposed on the interlayer insulating layer IL1.

The drain electrode D may be connected to the first conductive region COA1 of the active layer ACT through a hole penetrating the interlayer insulating layer ILI, the second gate insulating layer GI2, and the first gate insulating layer GI1.

The source electrode S may be connected to the second conductive region COA2 of the active layer ACT through a hole penetrating the interlayer insulating layer ILI, the second gate insulating layer GI2, and the first gate insulating layer GI1.

A capacitor electrode CAE on the second gate insulating layer GI2 may overlap at least a portion of the gate electrode G of the driving transistor DTR in the third direction DR3 and may be connected to the source electrode S of the driving transistor DTR through a hole penetrating the interlayer insulating layer ILI.

As illustrated in FIG. 70, the transistor array layer TFTL may further include anode connection electrodes ANDE disposed on the first via layer VIA1 and a second via layer VIA2 covering the anode connection electrodes ANDE.

Each of the anode connection electrodes ANDE may be connected to the source electrode S of the driving transistor DTR through a first contact hole CTH1 penetrating the first via layer VIA1.

Data lines DTL may be further placed on the first via layer VIA1.

Next, a plurality of pixel electrodes PE and a plurality of dummy patterns DMP are placed on the second via layer VIA2 of the transistor array layer TFTL (operation S20).

The pixel electrodes PE may respectively correspond to a plurality of emission areas LEA1 through LEA3 and may be respectively connected to the anode connection electrodes ANDE of the emission areas LEA1 through LEA3 through second contact holes CTH2 penetrating the second via layer VIA2.

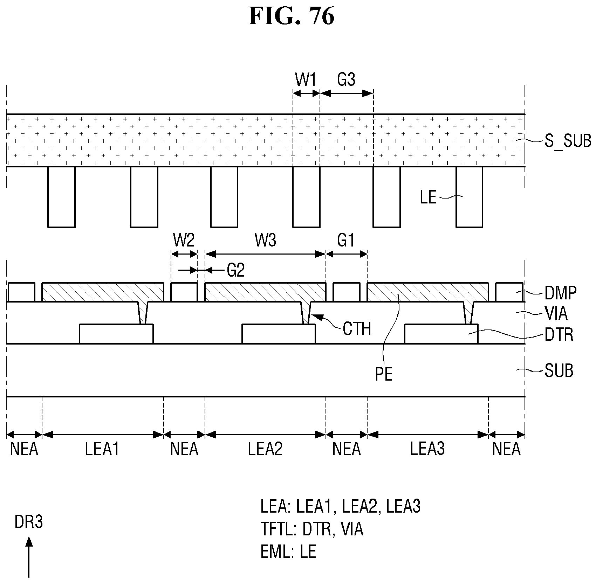

The pixel electrodes PE may be spaced from each other by a first distance G1 (e.g., predetermined first distance G1, see FIG. 76) in the first direction DR1.

Each of the pixel electrodes PE may have a third width W3 (e.g., a predetermined third width W3, see FIG. 76) in the first direction DR1.

Each of the dummy patterns DMP may be disposed in a non-emission area NEA and may have a second width W2 (e.g., a predetermined second width W2, see FIG. 76) in the first direction DR1.

The dummy patterns DMP may be formed on the same layer as the pixel electrodes PE and may have a thickness in the same range in the third direction DR3 as that of the pixel electrodes PE, so that they are disposed parallel to the pixel electrodes PE.

A pixel electrode PE and a dummy pattern DMP neighboring each other in the first direction DR1 may be spaced from each other by a second distance G2 (e.g., a predetermined second distance G2).

If one dummy pattern DMP is disposed between two pixel electrodes PE neighboring each other in the first direction DR1, the sum of the second width W2 and twice the second distance G2 may correspond to the first distance G1.

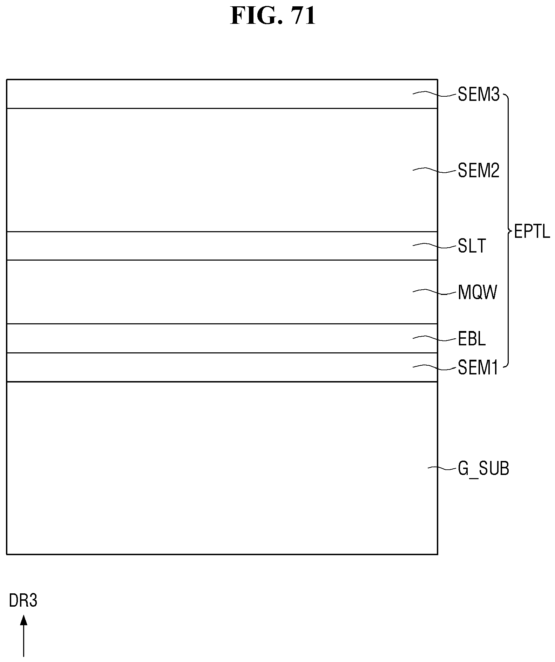

Referring to FIG. 71, in order to prepare a light emitting element array layer EML, a semiconductor epitaxial layer EPTL is placed on a growth substrate G_SUB (operation S31).

The semiconductor epitaxial layer EPTL may include a first semiconductor layer SEM1 of a first conductivity type, an active layer MQW of a quantum well structure, a second semiconductor layer SEM2 of a second conductivity type, and a third semiconductor layer SEM3 of an undoped semiconductor which are sequentially stacked in the third direction DR3.

The semiconductor epitaxial layer EPTL may further include an electron blocking layer EBL disposed between the first semiconductor layer SEM1 and the active layer MQW and a superlattice layer SLT disposed between the active layer MQW and the second semiconductor layer SEM2.

The first conductivity type may be a *p* type, and the second conductivity type may be an *n* type.

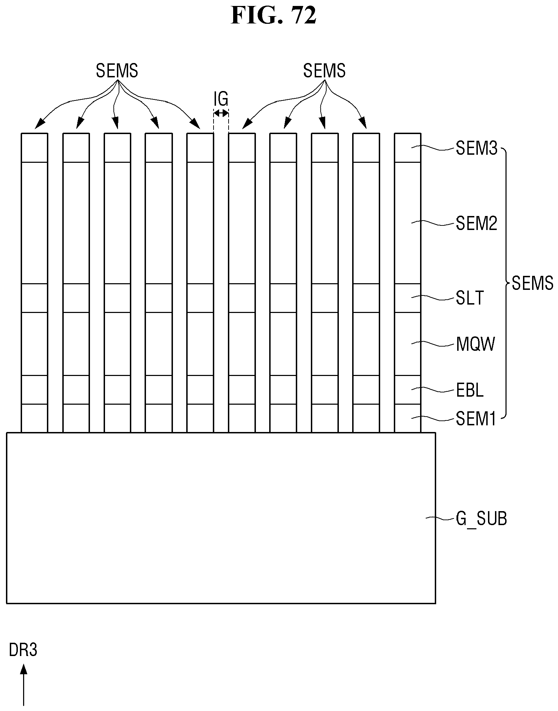

Referring to FIG. 72, a plurality of semiconductor structures SEMS, each having a first width W1 (e.g., a predetermined first width W1), may be prepared by patterning the semiconductor epitaxial layer EPTL (see FIG. 71) (operation S32).

The semiconductor structures SEMS may be spaced from each other by an initial distance IG in at least one direction (e.g., the first direction DR1).

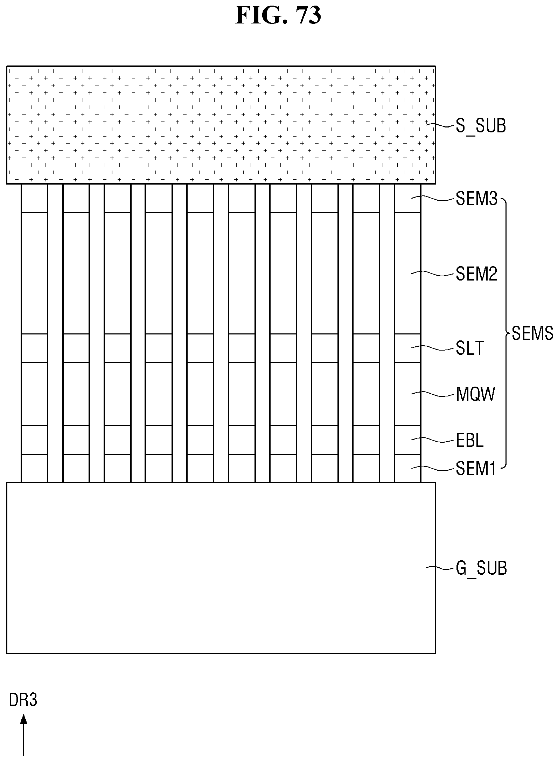

Referring to FIG. 73, an auxiliary substrate S_SUB may be attached onto the third semiconductor layers SEM3 of the semiconductor structures SEMS (operation S33).

The auxiliary substrate S_SUB may be made of a material that can be stretched in the first and second directions DR1 and DR2 corresponding to the arrangement of the semiconductor structures SEMS.

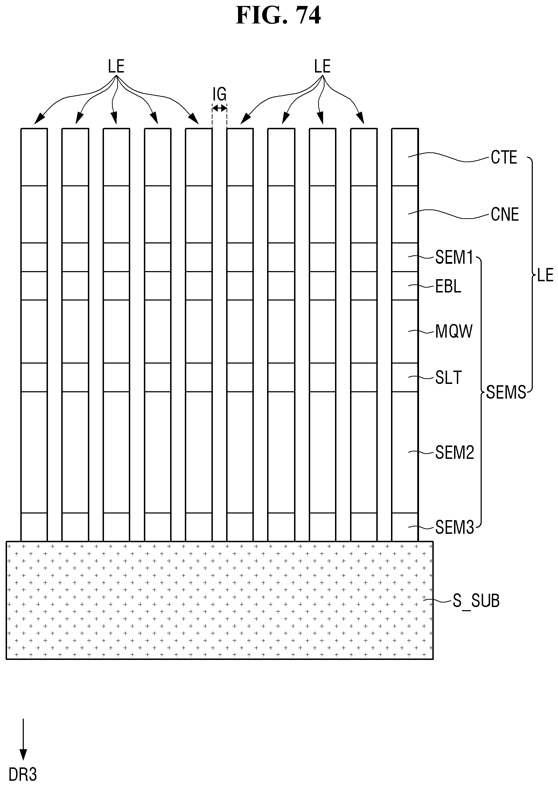

Referring to FIG. 74, the growth substrate G_SUB is removed from the semiconductor structures SEMS (operation S34). Then, a plurality of light emitting elements LE may be prepared by placing a connection electrode CNE on each of the semiconductor structures SEMS (operation S35).

The connection electrode CNE may be placed on the first semiconductor layer SEM 1 of each of the semiconductor structures SEMS.

In addition, each of the light emitting elements LE may further include a contact electrode CTE disposed on the connection electrode CNE.

That is, each of the light emitting elements LE may include a semiconductor structure SEMS, a connection electrode CNE on the first semiconductor layer SEM1 of the semiconductor structure SEMS, and a contact electrode CTE on the connection electrode CNE.

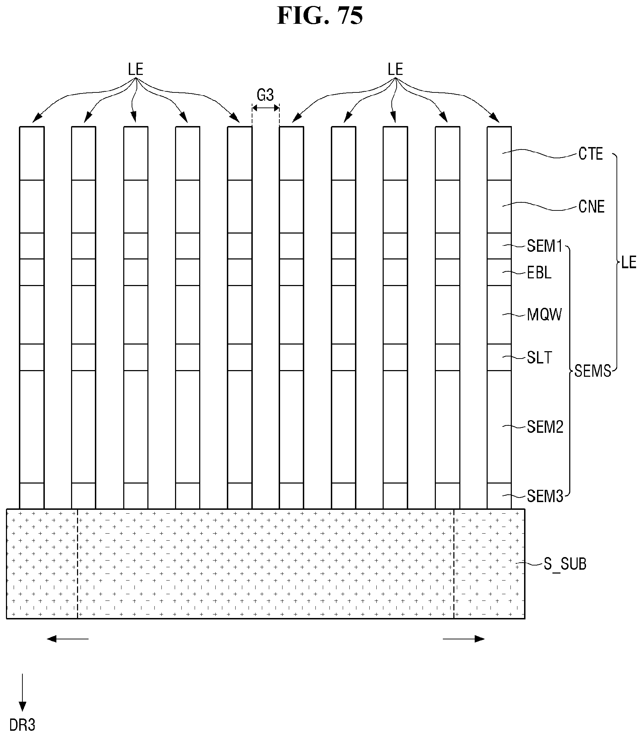

Referring to FIG. 75, a distance between the light emitting elements LE may be increased by stretching the auxiliary substrate S_SUB (operation S36). Here, the auxiliary substrate S_SUB may be stretched in at least one of the first direction DR1 and the second direction DR2 until the distance between the light emitting elements LE reaches a third distance G3 (e.g., a predetermined third distance G3) (operation S37).

Accordingly, the light emitting element array layer EML including the light emitting elements LE spaced from each other by the third distance G3 greater than the initial distance IG (see FIG. 74) in one direction may be prepared (operation S38).

Next, the light emitting element array layer EML is placed on the pixel electrodes PE, and the auxiliary substrate S_SUB is removed from the light emitting element array layer EML (operation S40).

Referring to FIG. 76, the light emitting elements LE on the auxiliary substrate S_SUB may be aligned with the pixel electrodes PE. Here, the light emitting elements LE may be aligned between the auxiliary substrate S_SUB and the pixel electrodes PE in the third direction DR3. In addition, at least one of the light emitting elements LE may face each pixel electrode PE thereunder.

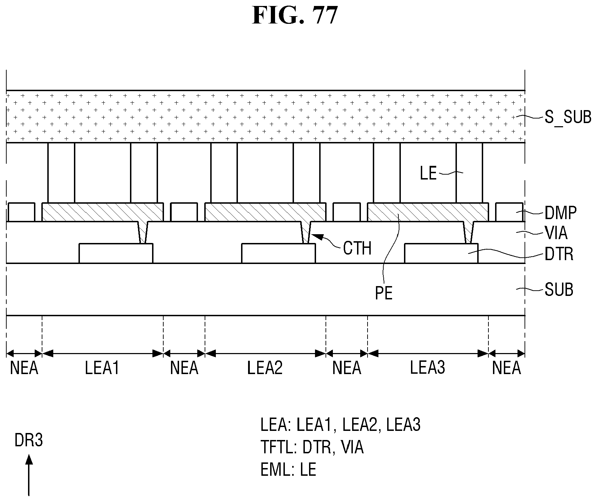

Referring to FIG. 77, the light emitting elements LE may be fixed onto the pixel electrodes PE. Here, the contact electrodes CTE (see FIG. 75) of the light emitting elements LE may contact the pixel electrodes PE.

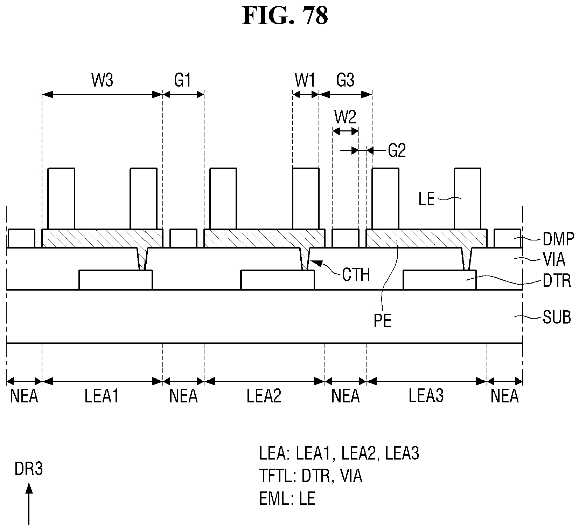

Referring to FIG. 78, the auxiliary substrate S_SUB may be removed from the third semiconductor layers SEM3 of the light emitting elements LE fixed on the pixel electrodes PE.

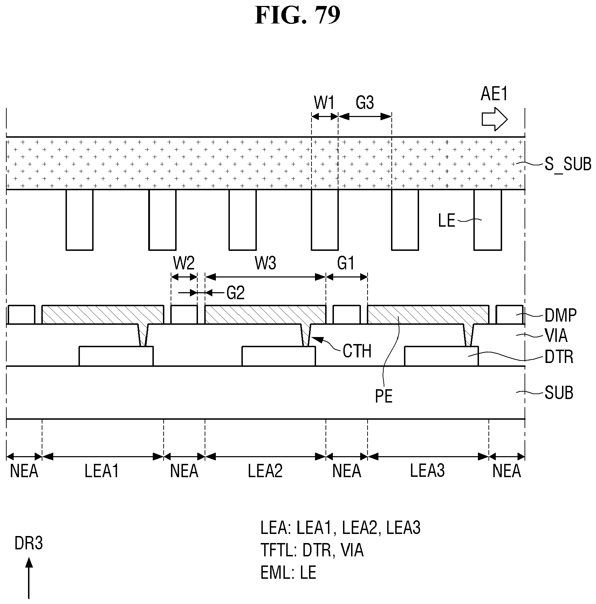

As illustrated in FIG. 79, a first alignment error AE1 in which the light emitting elements LE are shifted to one side (right side of FIG. 79) in the first direction DR1 from a normal position may occur in the process of aligning the light emitting elements LE on the auxiliary substrate S_SUB with the pixel electrodes PE.

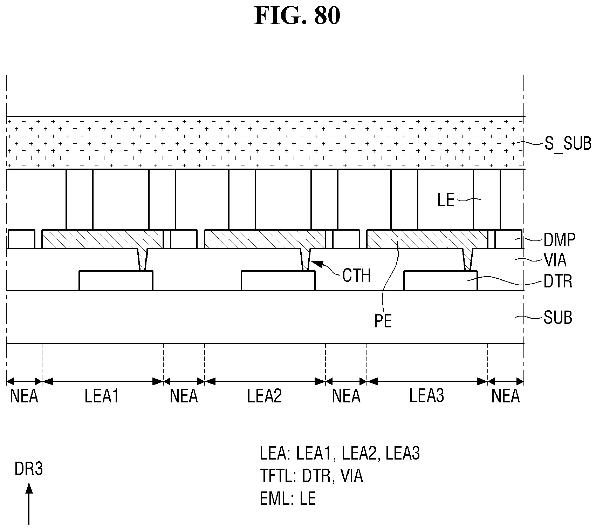

As illustrated in FIG. 80, when the light emitting elements LE are brought into contact with the pixel electrodes PE in a state where the first alignment error AE1 is reflected, some of the light emitting elements LE may protrude into the non-emission area NEA due to the first alignment error AE1.

However, according to the described embodiment, because the dummy patterns DMP formed on the same layer as the pixel electrodes PE and having a thickness in the same range as that of the pixel electrodes PE are disposed, some of the light emitting elements LE that protrude into the non-emission area NEA may be supported by the dummy patterns DMP. Accordingly, it is possible to prevent tilting defects of the light emitting elements LE protruding into the non-emission area NEA due to an alignment error.

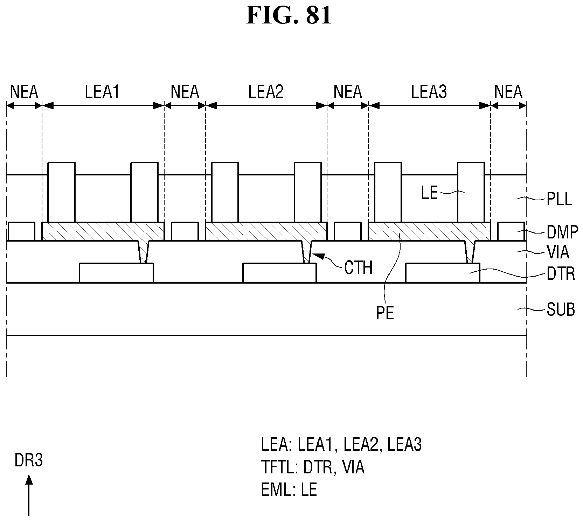

Next, referring to FIG. 81, a planarization layer PLL may be placed to fill a space between the light emitting elements LE and to cover the pixel electrodes PE and the dummy patterns DMP (operation S50).

Here, the light emitting elements LE may not be completely covered with the planarization layer PLL, and at least the third semiconductor layer SEM3 of each of the light emitting elements LE may be exposed outside the planarization layer PLL.

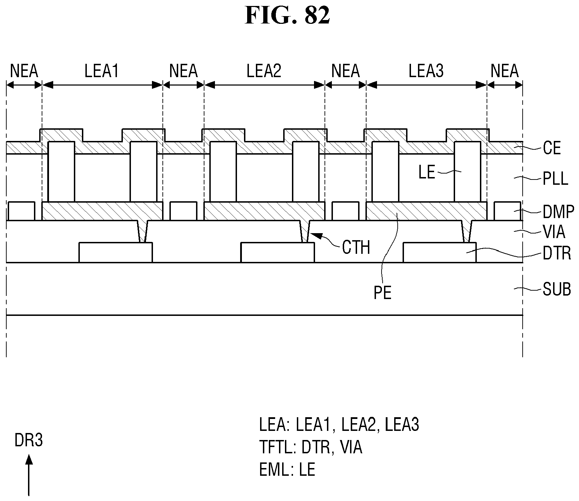

Referring to FIG. 82, a common electrode CE may be placed on the light emitting elements LE and the planarization layer PLL (operation S60). The common electrode CE may be electrically connected to the exposed third semiconductor layers SEM3 of the light emitting elements LE.

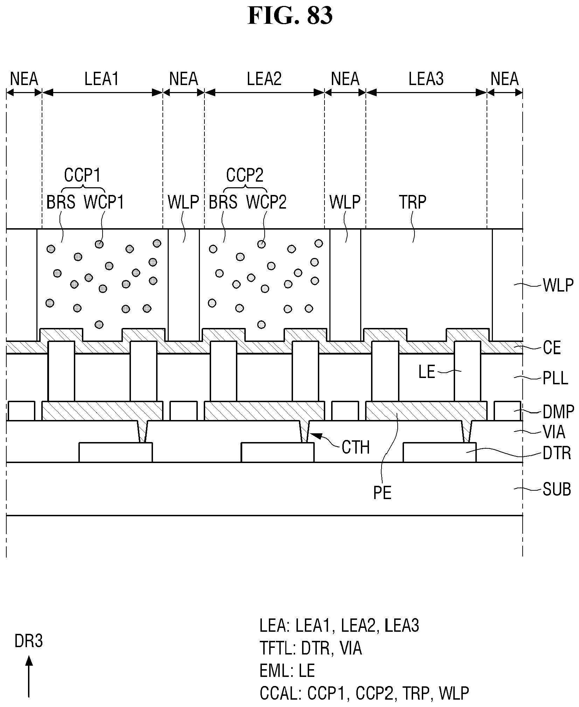

Referring to FIG. 83, a color conversion array layer CCAL may be placed on the common electrode CE (operation S70).

The color conversion array layer CCAL may include a first color conversion pattern CCP1 corresponding to a first emission area LEA1, a second color conversion pattern CCP2 corresponding to a second emission area LEA2, and a partition wall pattern WLP corresponding to the non-emission area NEA.

The first color conversion pattern CCP1 may include first color conversion members WCP1 that convert at least a portion of light from the light emitting elements LE into light of a first color.

The second color conversion pattern CCP2 may include second color conversion members WCP2 that convert at least a portion of light from the light emitting elements LE into light of a second color.

When the light emitting elements LE emit light of a third color, the color conversion array layer CCAL may further include a transmission pattern TRP corresponding to a third emission area LEA3 and transmitting light of the light emitting elements LE without changing the color.

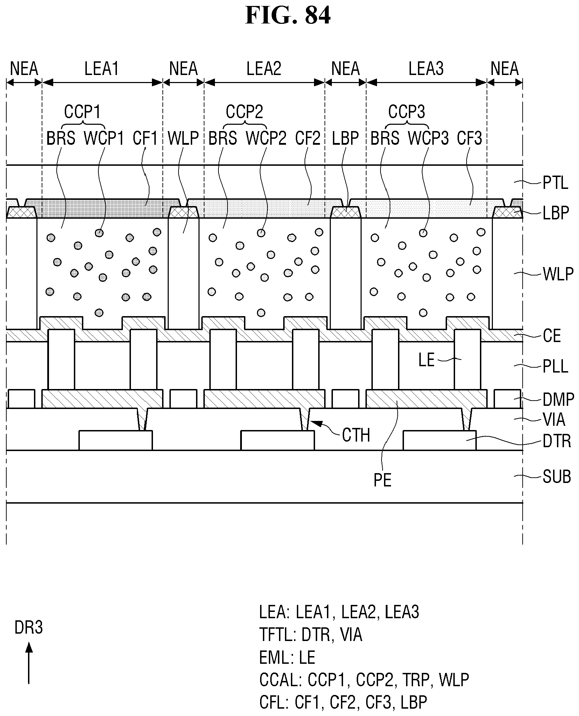

Alternatively, when the light emitting elements LE emit light of a wavelength band lower than that of the third color, the color conversion array layer CCAL may further include a third color conversion pattern CCP3 (see FIGS. 52 and 84) corresponding to the third emission area LEA3. The third color conversion pattern CCP3 may include third color conversion members WCP3 that convert at least a portion of light from the light emitting elements LE into light of the third color.

Referring to FIG. 84, a color filter layer CFL may be placed on the color conversion array layer CCAL (operation S80).

The color filter layer CFL may include a first color filter CF1 corresponding to the first emission area LEA1 and transmitting light of the first color, a second color filter CF2 corresponding to the second emission area LEA2 and transmitting light of the second color, a third color filter CF3 corresponding to the third emission area LEA3 and transmitting light of the third color, and a light blocking pattern LBP corresponding to the non-emission area NEA.

In addition, the color filter layer CFL may be covered with a protective layer PTL (e.g., a predetermined protective layer PTL).

As described above, the display device 100 according to the described embodiment includes the dummy patterns DMP disposed in the non-emission area NEA to be parallel to the pixel electrodes PE. Therefore, even if some of the light emitting elements LE are disposed in the non-emission area NEA due to an alignment error occurring in the process of concurrently (e.g., simultaneously) placing the light emitting elements LE on the pixel electrodes PE, tilting defects of these light emitting elements LE can be prevented by the dummy patterns DMP.

A display device according to one or more embodiments includes a plurality of light emitting units respectively corresponding to a plurality of emission areas and a partition wall portion corresponding to a non-emission area, which is a boundary between the emission areas and having a variable width in at least one direction.

Because the partition wall portion includes a portion having a relatively large width, it may not be easily deformed. Therefore, a decrease in the display quality, life, and yield of the display device due to deformation of the partition wall portion can be prevented.

In addition, because the partition wall portion includes a portion having a relatively small width, a decrease in the width of the light emitting units due to the partition wall portion can be reduced. Therefore, a decrease in the luminance of the display device due to the partition wall portion can be prevented.

A display device according to one or more embodiments includes a plurality of dummy patterns corresponding to a non-emission area between a plurality of emission areas, formed on (or at) the same layer as a plurality of pixel electrodes, and disposed parallel to the pixel electrodes.

Therefore, even if some of a plurality of light emitting elements protrude into the non-emission area due to an alignment error occurring in the process of concurrently (e.g., simultaneously) placing the light emitting elements on the pixel electrodes, they may be supported by the dummy patterns in the non-emission area. Accordingly, it is possible to prevent a tilting defect in which a light emitting element partially disposed in the non-emission area is tilted due to a step of a pixel electrode. Consequently, this can prevent a local increase in resistance of a common electrode, thus preventing degradation of display quality.

However, the effects, aspects, and features of the present disclosure are not restricted to the one set forth herein. The above and other effects, aspects, and features of the present disclosure will become more apparent to one of daily skill in the art to which the present disclosure pertains by referencing the claims.

## Claims

1. A display device comprising:
a substrate comprising a display area in which a plurality of emission areas configured to emit light for displaying an image is arranged;
a plurality of light emitting units located on the substrate and respectively corresponding to the plurality of emission areas; and
a partition wall on the substrate, corresponding to a non-emission area, which is a boundary between the plurality of emission areas, and having a variable width in at least one direction,
wherein the partition wall comprises:
a plate corresponding to the non-emission area; and
a pillar protruding from at least a portion of the plate to each of the plurality of emission areas and having a greater width than the plate,
wherein each of the plurality of light emitting units comprises:
a light emitting element on the substrate; and
a light control layer on the substrate to cover the light emitting element and configured to control characteristics of light emitted from the light emitting element,
wherein each of the plurality of light emitting units has a light emitting surface corresponding to the light control layer and configured to emit light and a rear surface opposite the light emitting surface, wherein the rear surface of each of the light emitting units has at least one corner or at least one side having a shape corresponding to that of the partition wall,
wherein a minimum distance between pillars corresponding to both sides of any one of the light emitting units is greater than a width of the light emitting element.

2. The display device of claim 1, wherein a height of each pillar is equal to a height of the plate in a thickness direction of the substrate, and the light emitting surface of each of the plurality of light emitting units has at least one corner or at least one side having a shape corresponding to that of the pillar.

3. The display device of claim 2, wherein each pillar corresponds to corners of four neighboring light emitting units, and the light emitting surface and the rear surface of each of the plurality of light emitting units having a quadrilateral shape having each corner shaped by the pillar.

4. The display device of claim 2, wherein each pillar corresponds to corners of two light emitting units neighboring each other in one direction, and the light emitting surface and the rear surface of each of the light emitting units are formed in a quadrilateral shape in which corners corresponding to both ends of one side extending in the one direction are shaped by the pillars.

5. The display device of claim 2, wherein each pillar corresponds to corners of two light emitting units neighboring each other in one direction and a portion of a side of one light emitting unit neighboring the corners of two neighboring light emitting units in another direction, and the light emitting surface and the rear surface of each of the light emitting units have a quadrilateral shape in which corners corresponding to both ends of one side extending in the one direction and a portion of another side extending in the one direction are shaped by the pillars.

6. The display device of claim 2, wherein each pillar is between two neighboring light emitting units, and the light emitting surface and the rear surface of each of the plurality of light emitting units includes a combination of curved sides convex toward a center of the light emitting unit.

7. The display device of claim 2, wherein 2n pillars are located side by side between two neighboring light emitting units and comprise a first pillar having a cross-sectional shape convex toward one of two neighboring light emitting units and a second pillar having a cross-sectional shape convex toward another one of the two neighboring light emitting units, wherein n is a natural number of 1 or more, the first pillar and the second pillar are alternately arranged between the two neighboring light emitting units, and the first and second pillars neighboring each other are point-symmetrical to each other,
wherein the plate corresponds to corners of four neighboring emission areas and a space between the first pillar and the second pillar, and the light emitting surface and the rear surface of each of the plurality of light emitting units have a quadrilateral shape that comprises a side shaped by the first pillar and another side facing the side and shaped by the second pillar.

8. The display device of claim 1, wherein the height of each pillar is less than the height of the plate, the rear surface of each of the light emitting units is surrounded by the pillars, and the light emitting surface of each of the light emitting units is surrounded by the plate and has a greater width than the rear surface, and wherein optionally the height of each pillar is less than a light emission height of the light emitting element in a thickness direction of the substrate, and the light emission height corresponds to an angle at which light is emitted from the light emitting element.

9. The display device of claim 8, wherein each pillar has one of:
a predetermined width;
an inclined surface facing the light emitting element and a gradually decreasing width toward the plate;
a curved surface facing the light emitting element and a gradually decreasing width toward the plate; and
wherein optionally the partition wall further comprises a buffer located between each pillar and the plate, and the buffer has a width less than the width of each pillar and greater than the width of the plate.

10. The display device of claim 1, wherein the height of each pillar is less than the height of the plate in a thickness direction of the substrate, the rear surface of each of the plurality of light emitting units is surrounded by the plate and the pillars, and the light emitting surface of each of the plurality of light emitting units is surrounded by the plate and has a greater width than the rear surface, and wherein optionally each pillar corresponds to corners of four neighboring light emitting units, and the rear surface of each of the plurality of light emitting units has a quadrilateral shape having each corner shaped by the pillar.

11. A display device comprising:
a substrate comprising a display area in which a plurality of emission areas is arranged;
a plurality of pixel electrodes on the substrate and respectively corresponding to the plurality of emission areas;
a plurality of dummy patterns on the substrate and corresponding to a non-emission area between the plurality of emission areas;
a plurality of light emitting elements corresponding to the plurality of emission areas;
a planarization layer between the plurality of light emitting elements and covering the plurality of pixel electrodes and the plurality of dummy patterns; and
a common electrode on the plurality of light emitting elements and the planarization layer and corresponding to the plurality of emission areas,
wherein the plurality of light emitting elements is spaced from each other by a distance in the same range in at least one direction, each of the plurality of emission areas corresponds to two or more of the plurality of light emitting elements, and two or more light emitting elements corresponding to an emission area from among the plurality of emission areas are on the pixel electrode of the emission area.

12. The display device of claim 11, wherein from among the two or more light emitting elements corresponding to the emission area, some light emitting elements at an edge of the emission area are supported by a dummy pattern from among the plurality of dummy patterns adjacent to the edge of the emission area.

13. The display device of claim 12, wherein one or more dummy patterns are between two pixel electrodes neighboring each other in one direction, and the dummy pattern between two pixel electrodes neighboring each other in the one direction is located parallel to the two pixel electrodes and is spaced from the two pixel electrodes.

14. The display device of claim 13, wherein each of the plurality of light emitting elements has a first width in the one direction, the pixel electrodes are spaced from each other by a first distance in the one direction, and the first distance is greater than the first width,
wherein the pixel electrode of the emission area and the dummy pattern neighboring the emission area are spaced from each other by a second distance in the one direction, and the second distance is smaller than half the first width,
wherein each of the plurality of dummy patterns has a second width in the one direction, and a sum of the second width and the second distance is greater than half the first width,
wherein when one dummy pattern from among the plurality of dummy patterns is between two pixel electrodes neighboring each other in the one direction, a sum of twice the second width and the second distance is less than the first distance.

15. The display device of claim 12, wherein the dummy pattern from among the plurality of dummy patterns adjacent to the emission area has a thickness in the same range as that of the pixel electrode of the emission area; and optionally wherein:
the plurality of dummy patterns comprise a same material as the pixel electrodes, or the plurality of dummy patterns comprise an insulating material.
